# EUROPÄISCHE PATENTSCHRIFT

(11) **EP 4 410 071 B1**
(45) Veröffentlichungstag und Bekanntmachung des Hinweises auf die Patenterteilung: **18.11.2026**
(21) Anmeldenummer: 22790516.3
(22) Anmeldetag: 26.09.2022
(51) Int. Cl.: H10K 85/60, H10K 50/165, H10K 50/11, H10K 50/15, H10K 50/18

(54) **MATERIALIEN FÜR ELEKTRONISCHE VORRICHTUNGEN**
MATERIALS FOR ELECTRONIC DEVICES
MATÉRIAUX POUR DISPOSITIFS ÉLECTRONIQUES

(30) Priorität: 28.09.2021 EP 21199278
(43) Veröffentlichungstag der Anmeldung: 07.08.2024
(73) Patentinhaber: Merck Patent GmbH, 64293 Darmstadt (DE)
(72) Erfinder: STOESSEL, Philipp, 64293 Darmstadt (DE)
(74) Vertreter: Merck Patent Association
(86) Internationale Anmeldenummer: PCT/EP2022/076609
(87) Internationale Veröffentlichungsnummer: WO 2023/052275

(56) Entgegenhaltungen:
- WO-A1-2018/014028
- CN-A- 111 995 562
- CN-A- 112 771 031
- KR-A- 20210 100 352

## Beschreibung

Die vorliegende Erfindung betrifft Materialien für die Verwendung in elektronischen Vorrichtungen, insbesondere in organischen Elektrolumineszenzvorrichtungen, sowie elektronische Vorrichtungen, insbesondere organische Elektrolumineszenzvorrichtungen enthaltend diese Materialien.

Elektronische Vorrichtungen, welche organische, metallorganische und/oder polymere Halbleiter enthalten, gewinnen zunehmend an Bedeutung, wobei diese aus Kostengründen und aufgrund ihrer Leistungsfähigkeit in vielen kommerziellen Produkten eingesetzt werden. Als Beispiele seien hier Ladungstransportmaterialien auf organischer Basis (z.B. Lochtransporter auf Triarylamin-Basis) in Kopiergeräten, organischen oder polymeren Leuchtdioden (OLEDs oder PLEDs) in Anzeige- und Displayvorrichtungen oder organische Photorezeptoren in Kopierern genannt. Organische Solarzellen (O-SC), organische FeldeffektTransistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Als elektronische Vorrichtungen im Sinne dieser Erfindung werden organische elektronische Vorrichtungen verstanden, welche organische Halbleitermaterialien als funktionelle Materialien enthalten. Insbesondere stehen die elektronischen Vorrichtungen für Elektrolumineszenzvorrichtungen wie OLEDs.

Der Aufbau von OLEDs, in welchen organische Verbindungen als funktionelle Materialien verwendet werden, ist dem Fachmann aus dem Stand der Technik bekannt. Im Allgemeinen werden unter OLEDs elektronische Vorrichtungen verstanden, welche eine oder mehrere Schichten haben, welche organische Verbindungen umfassen, und beim Anlegen einer Spannung Licht emittieren.

In elektronischen Vorrichtungen, insbesondere OLEDs, gibt es einen großen Bedarf die Leistungsdaten, insbesondere Lebensdauer, Effizienz und Betriebsspannung zu verbessern. Für diese Aspekte konnte bisher keine zufriedenstellende Lösung gefunden werden.

Elektronische Vorrichtungen umfassen üblicherweise Kathode, Anode und mindestens eine funktionale, bevorzugt emittierende Schicht. Außer diesen Schichten können sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers).

Einen großen Einfluss auf die Leistungsdaten von elektronischen Vorrichtungen haben die Lochtransportschichten und Elektronentransportschichten.

Aufgabe der vorliegenden Erfindung ist die Bereitstellung von Verbindungen, welche sich für den Einsatz in einer elektronischen Vorrichtung, insbesondere einer OLED, eignen, insbesondere als Material von Lochtransportschichten oder Material von Elektronentransportschichten, und dort zu guten Eigenschaften führen.

Überraschend wurde gefunden, dass bestimmte, unten näher beschriebene Trypticene diese Aufgabe lösen und sich gut für die Verwendung in elektronischen Vorrichtungen, insbesondere OLEDs eignen. Dabei weisen die OLEDs insbesondere eine lange Lebensdauer, eine hohe Effizienz und eine geringere Betriebsspannung auf. Diese Verbindungen sowie elektronische Vorrichtungen, insbesondere organische Elektrolumineszenzvorrichtungen, welche diese Verbindungen enthalten, sind daher der Gegenstand der vorliegenden Erfindung.

KR 2021 0100352 A, CN 111 995 562 A und CN 112 771 031 A offenbaren Trypticenverbindungen und elektronische Vorrichtungen enthaltend die besagte Trypticenverbindungen.

Gegenstand der vorliegenden Erfindung ist eine Verbindung gemäß Formel (1), 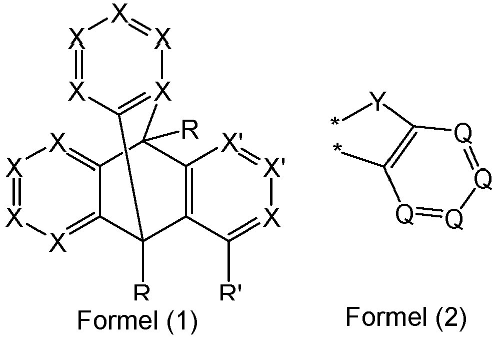 sowie Enantiomere davon, wobei für die verwendeten Symbole gilt:
- X: ist gleich oder verschieden bei jedem Auftreten CR oder N mit der Maßgabe, dass maximal zwei Gruppen X pro Zyklus für N stehen;
- X': stehen für C, welche über die mit * bezeichneten Bindungen in Formel (2) ein an den Zyklus ankondensiertes aromatisches oder heteroaromatisches Ringsystem bilden, so dass Formel (2) an die Positionen von X' ankondensiert ist;
- Y: ist bei jedem Auftreten gleich oder verschieden ein BR (C(R)₂, Si(R)₂, Ge(R)₂, Sn(R)₂, O, S, Se, SO, SO₂, PR, P(=O)R, Bi(O)R², BiR² C(R)₂, wobei bei C(R)₂ R über ein Kohlenstoffatom angebunden ist.
- Q: ist gleich oder verschieden bei jedem Auftreten CR oder N mit der Maßgabe, dass maximal zwei Gruppen Q pro Zyklus für N stehen.
- R: ist bei jedem Auftreten gleich oder verschieden H, D, F, Cl, Br, I, OAr', SAr', B(OR¹)₂, CHO, C(=O)R¹, CR¹=C(R¹)₂, CN C(=O)OR¹, C(=O)NR¹, Si(R¹)₃, NO₂, P(=O)(R¹)₂, OSO₂R¹, OR¹, S(=O)R¹. S(=O)₂R¹, SR¹, eine geradkettige Alkylgruppe mit 1 bis 20 C-Atomen oder eine Alkenyl- oder Alkinylgruppe mit 2 bis 20 C-Atomen oder eine verzweigte oder zyklische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch -R¹C=CR¹-
- ,: -C≡C-, Si(R¹)₂, NR¹, CONR¹, C=O, C=S, -C(=O)O-, P(=O)(R¹), -O-, -S-, SO oder SO₂ ersetzt sein können, oder ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann, wobei zwei oder mehr bevorzugt an den gleichen Zyklus gebundene Reste R miteinander ein aliphatisches, heteroaliphatisches, aromatisches oder heteroaromatisches Ringsystem bilden können, das mit einem oder mehreren Resten R¹ substituiert sein kann, und wobei zwei an dasselbe Kohlenstoff- Silizium-, Germanium- oder Zinnatom gebundene Reste R ein monozyklisches oder polyzyklisches, aliphatisches, aromatisches oder heteroaromatisches Ringsystem miteinander bilden können, das mit einem oder mehreren Resten R¹ substituiert sein kann;
- R': ist bei jedem Auftreten gleich oder verschieden H,
- D, F, Cl, Br, I, N(Ar')₂.: N(R¹)₂, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, ein aromatisches oder heteroaromatisches Ringsystem mit 5 bis 60 aromatischen Ringatomen, bevorzugt mit 5 bis 40 aromatischen Ringatomen das jeweils durch einen oder mehrere Reste R¹ substituiert sein kann;
- Ar': ist bei jedem Auftreten gleich oder verschieden ein aromatisches oder heteroaromatisches Ringsystem mit 5 bis 40 aromatischen Ringatomen, das durch einen oder mehrere Reste R¹ substituiert sein kann;
- R¹: ist bei jedem Auftreten gleich oder verschieden H, D, F, I, B(OR²)₂, CHO, C(=O)R², CR²=C(R²)₂, CN, C(=O)OR², Si(R²)₃, NO₂. P(=O)(R²)₂, OSO₂R², SR², OR², S(=O)R², S(=O)₂R², eine geradkettige Alkylgruppe mit 1 bis 20 C-Atomen oder eine Alkenyl- oder Alkinylgruppe mit 2 bis 20 C-Atomen oder eine verzweigte oder zyklische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere CH₂-Gruppen in den oben genannten Gruppen durch -R²C=CR²-, -C=C-, Si(R²)₂, C=O, C=S, -C(=O)O-, NR², CONR², P(=O)(R²), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R² substituiert sein kann, wobei zwei oder mehr Reste R¹ miteinander ein aliphatisches, heteroaliphatisches, aromatisches oder heteroaromatisches Ringsystem bilden können;
- R²: ist bei jedem Auftreten gleich oder verschieden H, D, F, CN oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden.

Eine Arylgruppe im Sinne dieser Erfindung enthält 6 bis 40 C-Atome; eine Heteroarylgruppe im Sinne dieser Erfindung enthält 5 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Zyklus, also Benzol, bzw. ein einfacher heteroaromatischer Zyklus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 60 C-Atome, bevorzugt 6 bis 40 C-Atome im Ringsystem. Ein heteroaromatisches Ringsystem im Sinne dieser Erfindung enthält 1 bis 60 C-Atome, bevorzugt 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder Carbonylgruppe, verbunden sein können. Ebenso sollen hierunter Systeme verstanden werden, in denen zwei oder mehr Aryl- bzw. Heteroarylgruppen direkt miteinander verknüpft sind, wie z. B. Biphenyl, Terphenyl, Bipyridin oder Phenylpyridin. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe verbunden sind. Bevorzugte aromatische bzw. heteroaromatische Ringsysteme sind einfache Aryl- bzw. Heteroarylgruppen sowie Gruppen, in denen zwei oder mehr Aryl- bzw. Heteroarylgruppen direkt miteinander verknüpft sind, beispielsweise Biphenyl, Terphenyl, Quaterphenyl oder Bipyridin, sowie Fluoren oder Spirobifluoren.

Ein elektronenreiches heteroaromatisches Ringsystem ist dadurch gekennzeichnet, dass es sich dabei um ein heteroaromatisches Ringsystem handelt, das keine elektronenarmen Heteroarylgruppen enthält. Eine elektronenarme Heteroarylgruppe ist eine Sechsring-Heteroarylgruppe mit mindestens einem Stickstoffatom oder eine Fünfring-Heteroarylgruppe mit mindestens zwei Heteroatomen, von denen eines ein Stickstoffatom und das andere Sauerstoff, Schwefel oder ein substituiertes Stickstoffatom ist, wobei an diese Gruppen jeweils noch weitere Aryl- oder Heteroarylgruppen ankondensiert sein können. Dagegen sind elektronenreiche Heteroarylgruppen Fünfring-Heteroarylgruppen mit genau einem Heteroatom, ausgewählt aus Sauerstoff, Schwefel oder substituiertem Stickstoff, an welche noch weitere Arylgruppen und/oder weitere elektronenreiche Fünfring-Heteroarylgruppen ankondensiert sein können. So sind Beispiele für elektronenreiche Heteroarylgruppen Pyrrol, Furan, Thiophen, Indol, Benzofuran, Benzothiophen, Carbazol, Dibenzofuran, Dibenzothiophen oder Indenocarbazol. Eine elektronenreiche Heteroarylgruppe wird auch als elektronenreicher heteroaromatischer Rest bezeichnet.

Ein elektronenarmes heteroaromatisches Ringsystem ist dadurch gekennzeichnet, dass es mindestens eine elektronenarme Heteroarylgruppe enthält, und insbesondere bevorzugt keine elektronenreiche Heteroarylgruppen.

Im Rahmen der vorliegenden Erfindung wird der Begriff Alkylgruppe als Oberbegriff sowohl für lineare oder verzweigte Alkylgruppen wie auch für zyklische Alkylgruppen verwendet. Analog werden die Begriffe Alkenylgruppe bzw. Alkinylgruppe als Oberbegriffe sowohl für lineare oder verzweigte Alkenyl- bzw. Alkinylgruppen wie auch für zyklische Alkenyl- bzw. Alkinylgruppen verwendet.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, Cyclooctyl, 2-Ethylhexyl, 1-Bicyclo[2,2,2]octyl, 2-Bicyclo[2,2,2]octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl, 1,1-Dimethyl-n-hept-1-yl, 1,1-Dimethyl-n-oct-1-yl, 1,1-Dimethyl-n-dec-1-yl, 1,1-Dimethyl-n-dodec-1-yl, 1,1-Dimethyl-n-tetradec-1-yl, 1,1-Dimethyl-n-hexadec-1-yl, 1,1-Dimethyl-n-octadec-1-yl, 1,1-Diethyl-n-hex-1-yl, 1,1-Diethyl-n-hept-1-yl, 1,1-Diethyl-n-oct-1-yl, 1,1-Diethyl-n-dec-1-yl, 1,1-Diethyl-n-dodec-1-yl, 1,1-Diethyl-n-tetradec-1-yl, 1,1-Diethyln-n-hexadec-1-yl, 1,1-Diethyl-n-octadec-1-yl, 1-(n-Propyl)-cyclohex-1-yl, 1-(n-Butyl)-cyclohex-1-yl, 1-(n-Hexyl)-cyclohex-1-yl, 1-(n-Octyl)-cyclohex-1-yl und 1-(n-Decyl)-cyclohex-1-yl, Ethenyl, Propenyl, Butenyl, Pentenyl, Cyclopentenyl, Hexenyl, Cyclohexenyl, Heptenyl, Cycloheptenyl, Octenyl, Cyclooctenyl, Cyclooctadienyl, Ethinyl, Propinyl, Butinyl, Pentinyl, Hexinyl, Heptinyl oder Octinyl verstanden. Unter einer Alkoxygruppe OR¹ mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe SR¹ mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder zyklisch sein, wobei eine oder mehrere nichtbenachbarte CH₂-Gruppen durch die oben genannten Gruppen ersetzt sein können; weiterhin können auch ein oder mehrere H-Atome durch D, F, Cl, Br, I, CN oder NO₂, bevorzugt F, Cl oder CN, besonders bevorzugt F oder CN ersetzt sein.

Unter einem aromatischen oder heteroaromatischen Ringsystem mit 5 - 60 aromatischen Ringatomen, vorzugsweise 5 - 40 aromatischen Ringatomen, welches noch jeweils mit den oben genannten Resten oder einem Kohlenwasserstoffrest substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme.

Unter der Formulierung, dass zwei oder mehr Reste miteinander ein Ringsystem bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht:

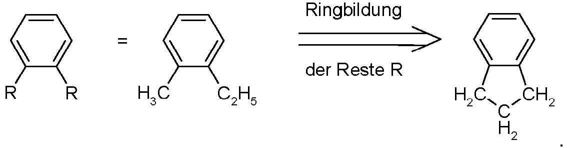

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

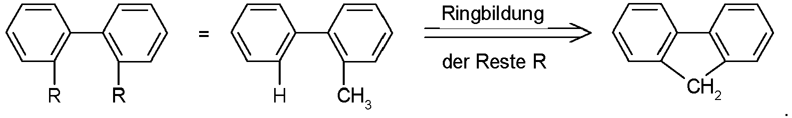

Weitere bevorzugte Ausführungsformen zeigen die folgenden Formeln (3) und (4): 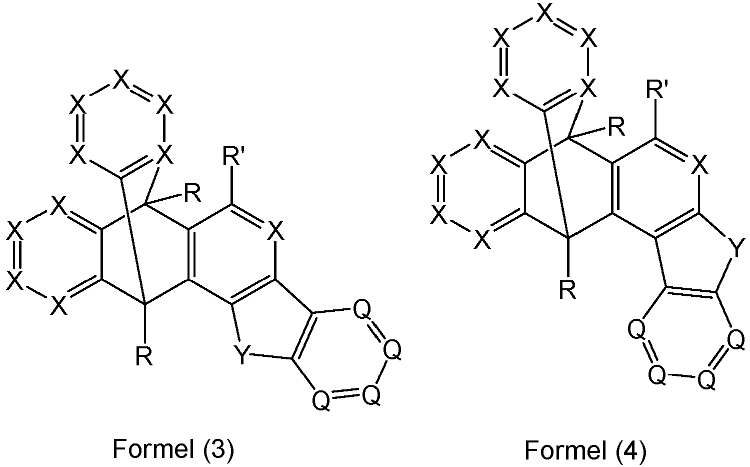 sowie Enantiomere davon, wobei die verwendeten Symbole die oben für Formeln (1) und (2) genannten Bedeutungen aufweisen.

In einer bevorzugten Ausführungsform steht mindestens ein Rest R, R' oder Ar' der Symbole Y, X oder Q in einer der Formeln (1), (2), (3) oder (4) für ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann.

In einer bevorzugten Ausführungsform der Erfindung stehen maximal zwei Symbole X pro Zyklus für N, besonders bevorzugt maximal ein Symbol X.

In einer bevorzugten Ausführungsform der Erfindung stehen maximal zwei Symbole Q für N.

In einer bevorzugten Ausführungsform der Erfindung steht X für CR und maximal zwei Symbole Q für N.

In einer bevorzugten Ausführungsform der Erfindung steht X und Q für CR.

In einer bevorzugten Ausführungsform stehen alle X für CR, wobei R für H, D, F oder CN steht.

In einer bevorzugten Ausführungsform der Erfindung weist die Verbindung nur ein ankondensiertes Ringsystem auf, welches über die mit * gekennzeichneten Bindungen ankondensiert ist.

Bevorzugt weist die Verbindung nach Formel (1) nur ein ankondensiertes Ringsystem auf, welches über die mit * gekennzeichneten Bindungen der Formel (2) ankondensiert ist, sowie nur bis zu ein weiteres ankondensiertes Ringsystem auf, bei dem zwei Reste R ein an den Zyklus ankondensiertes aromatisches oder heteroaromatisches Ringsystem mit 4 bis 8 Ringatomen bilden, welches mit einem oder mehreren Resten R¹ substituiert sein kann.

Bevorzugte Ausführungsformen der Verbindungen der Formeln (3) und (4) sind die folgenden Verbindungen der Formeln (3-1) bis (3-3) und (4-1) bis (4-3): 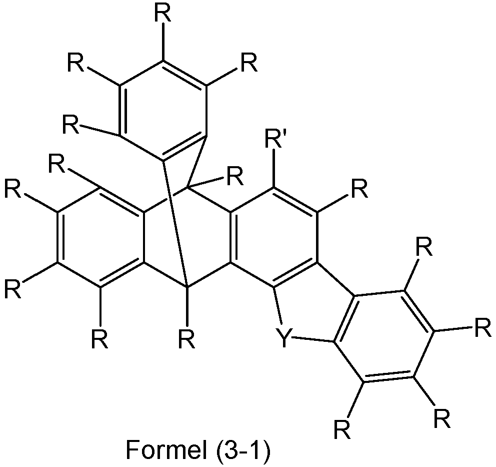 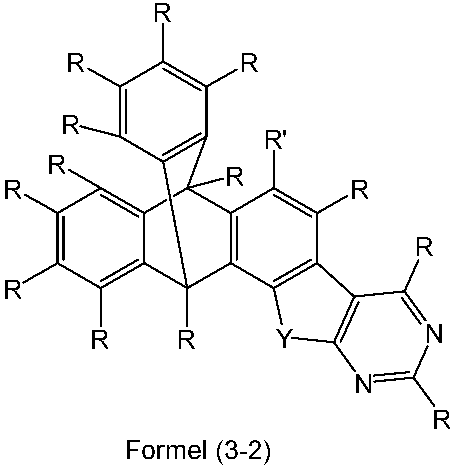 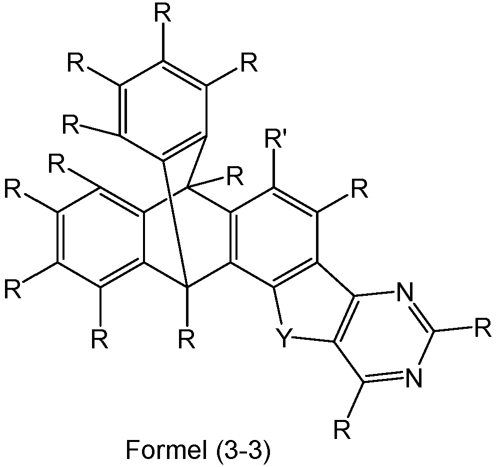 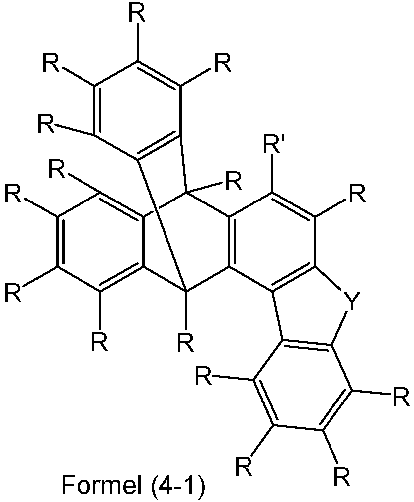 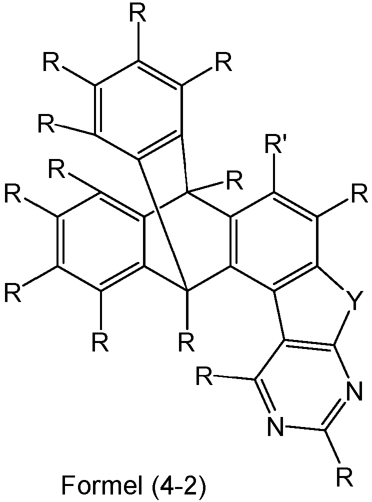 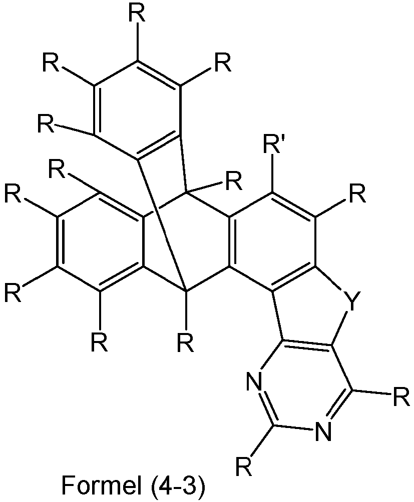 sowie Enantiomere davon, wobei die Symbole soweit vorhanden die für die Formeln (1) und (2) genannten Bedeutungen aufweisen.

In einer bevorzugten Ausführungsform der Erfindung stehen maximal 5 Gruppen R in den Formeln (3) und (4), bevorzugt in den Formeln (3-1) bis (3-3) und (4-1) bis (4-3), nicht für H, F, CN oder D, bevorzugt maximal 2 Gruppen R.

In einer bevorzugten Ausführungsform steht Y für O, S oder CR₂. bevorzugt für CR₂, O oder S, besonders bevorzugt O oder S.

Im Folgenden werden bevorzugte Substituenten R, R', Ar', R¹ und R² beschrieben. In einer besonders bevorzugten Ausführungsform der Erfindung treten die nachfolgend genannten Bevorzugungen für R, R', Ar', R¹ und R² gleichzeitig auf und gelten für die Strukturen der Formel (1) sowie für alle oben aufgeführten bevorzugten Ausführungsformen.

In einer bevorzugten Ausführungsform der Erfindung ist R bei jedem Auftreten gleich oder verschieden ausgewählt aus der Gruppe bestehend aus H, D, F, CN, OR¹, einer geradkettigen Alkylgruppe mit 1 bis 10 C-Atomen oder einer Alkenylgruppe mit 2 bis 10 C-Atomen oder einer verzweigten oder zyklischen Alkylgruppe mit 3 bis 10 C-Atomen, wobei die Alkyl- bzw.

Alkenylgruppe jeweils mit einem oder mehreren Resten R¹ substituiert sein kann, bevorzugt jedoch unsubstituiert ist, und wobei eine oder mehrere nicht benachbarte CH₂-Gruppen durch O ersetzt sein können, oder einem aromatischen oder heteroaromatischen Ringsystem mit 6 bis 30 aromatischen Ringatomen, das jeweils durch einen oder mehrere Reste R¹ substituiert sein kann: dabei können zwei Reste R auch miteinander ein aliphatisches, aromatisches oder heteroaromatisches Ringsystem bilden. Besonders bevorzugt ist R bei jedem Auftreten gleich oder verschieden ausgewählt aus der Gruppe bestehend aus H, F, CN, einer geradkettigen Alkylgruppe mit 1 bis 6 C-Atomen, insbesondere mit 1, 2, 3 oder 4 C-Atomen, oder einer verzweigten oder zyklischen Alkylgruppe mit 3 bis 6 C-Atomen, wobei die Alkylgruppe jeweils mit einem oder mehreren Resten R¹ substituiert sein kann, bevorzugt aber unsubstituiert ist, oder einem aromatischen oder heteroaromatischen Ringsystem mit 6 bis 24 aromatischen Ringatomen, das jeweils durch einen oder mehrere Reste R¹, bevorzugt nicht-aromatische Reste R¹. substituiert sein kann. Ganz besonders bevorzugt ist R bei jedem Auftreten gleich oder verschieden ausgewählt aus der Gruppe bestehend aus H oder einem aromatischen oder heteroaromatischen Ringsystem mit 6 bis 24 aromatischen Ringatomen, das jeweils durch einen oder mehrere Reste R², bevorzugt nicht-aromatische Reste R¹, substituiert sein kann.

Geeignete aromatische bzw. heteroaromatische Ringsysteme R oder R' sind ausgewählt aus Phenyl, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, welches über die 1-, 2-, 3- oder 4-Position verknüpft sein kann, Spirobifluoren, welches über die 1-, 2-, 3- oder 4-Position verknüpft sein kann, Naphthalin, welches über die 1- oder 2-Position verknüpft sein kann, Indol, Benzofuran, Benzothiophen, welches über die 1-, 2-, 3- oder 4-Position verknüpft sein kann, Dibenzofuran, Carbazol, welches über die 1-, 2-, 3- oder 4-Position verknüpft sein kann, Dibenzothiophen, welches über die 1-, 2-, 3- oder 4-Position verknüpft sein kann, Indenocarbazol, Indolocarbazol, Pyridin, Pyrimidin, Pyrazin, Pyridazin, Triazin, Chinolin, Chinazolin, Benzimidazol, Phenanthren, Triphenylen oder einer Kombination aus zwei oder drei dieser Gruppen, welche jeweils mit einem oder mehreren Resten R¹ substituiert sein können. Wenn R für eine Heteroarylgruppe, insbesondere für Triazin, Pyrimidin oder Chinazolin steht, können auch aromatische oder heteroaromatische Reste R¹ an dieser Heteroarylgruppe bevorzugt sein.

Dabei sind die Gruppen R oder R', wenn sie für ein aromatisches bzw. heteroaromatisches Ringsystem stehen, bevorzugt gewählt aus den Gruppen der folgenden Formeln R-1 bis R-163, 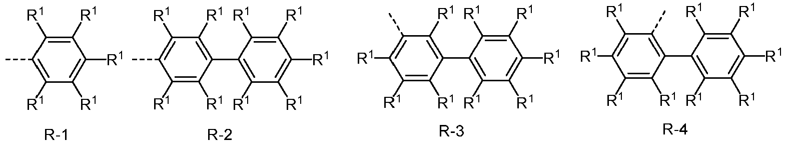 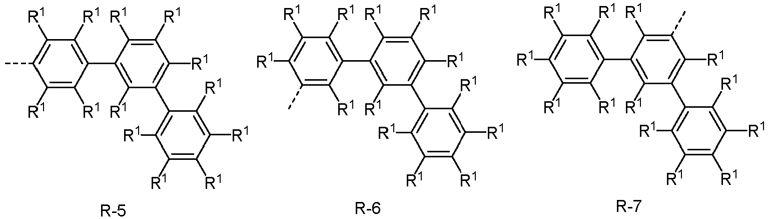 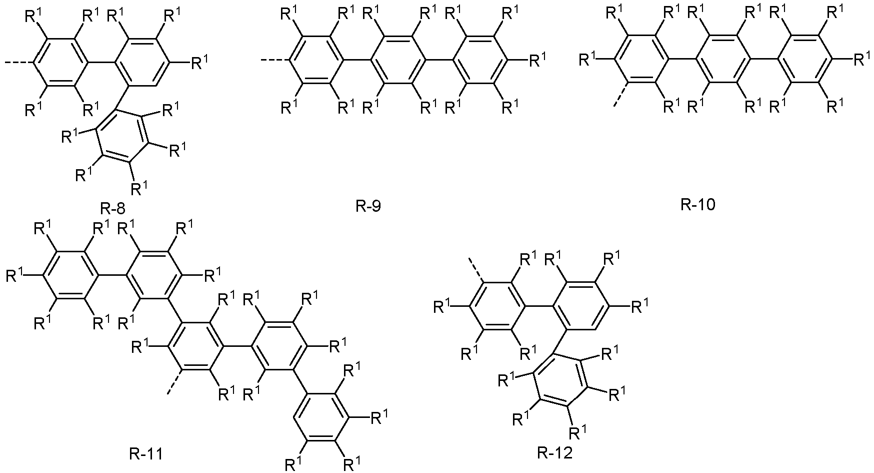 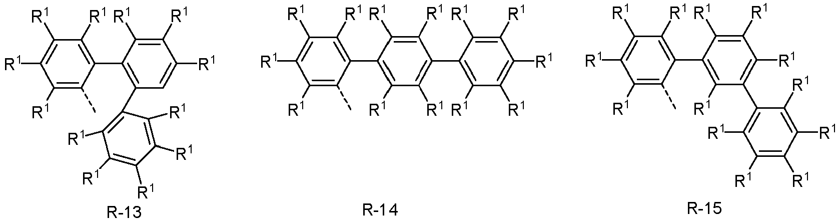 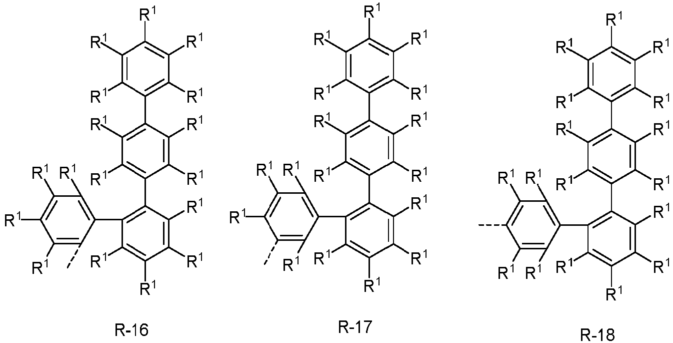 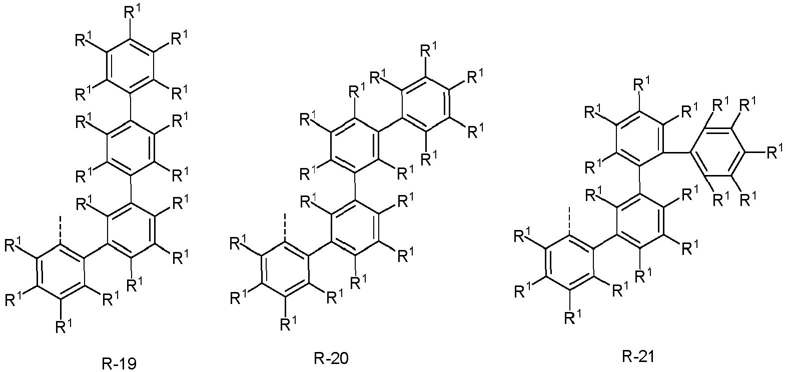 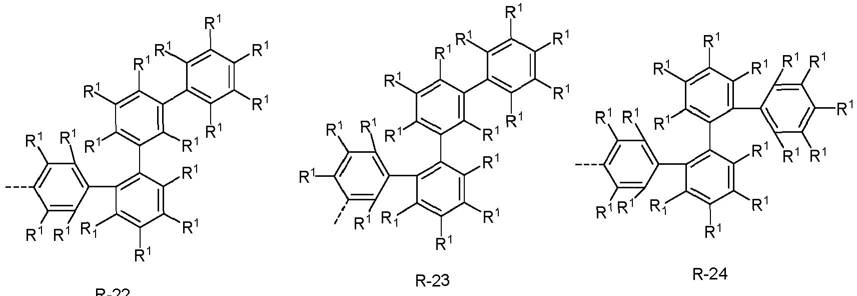 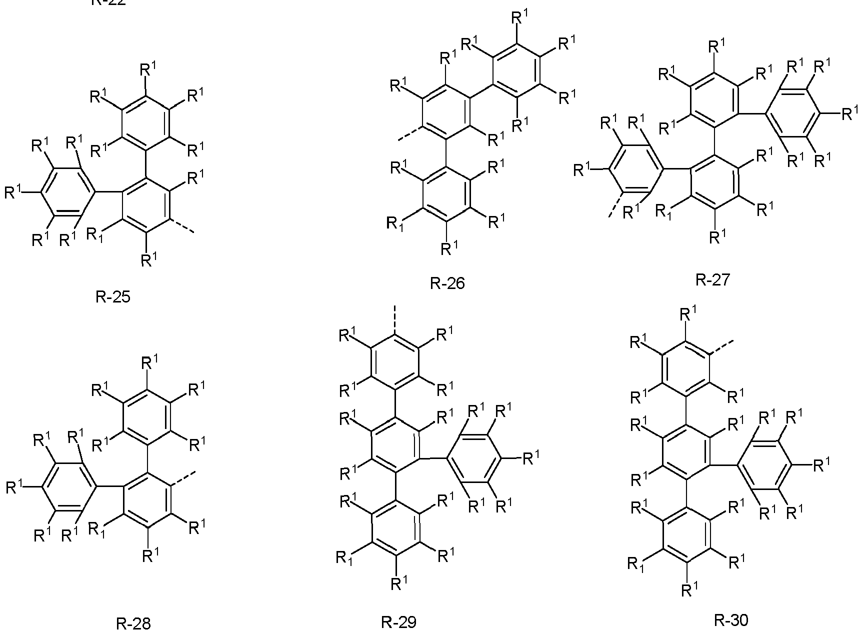 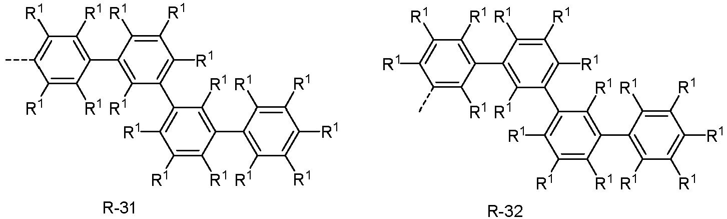 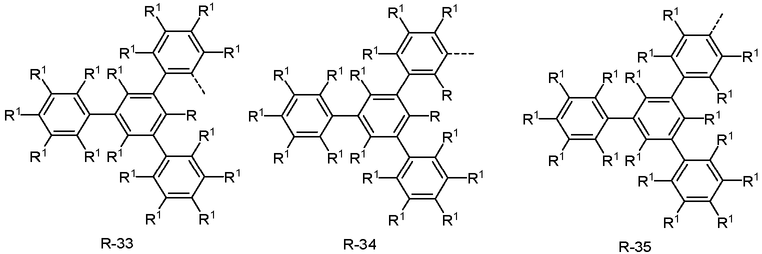 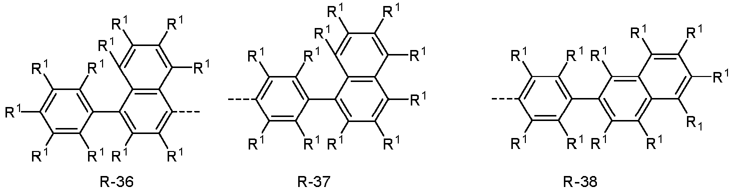 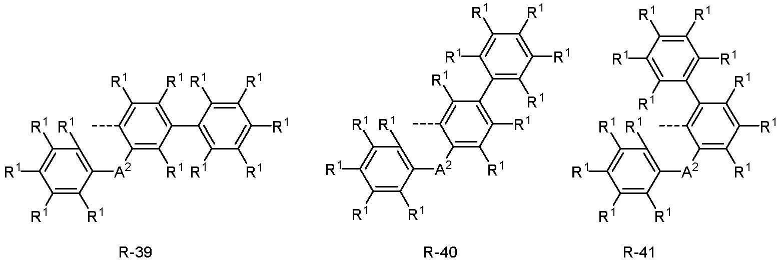 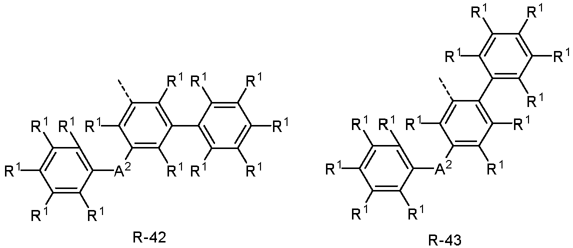 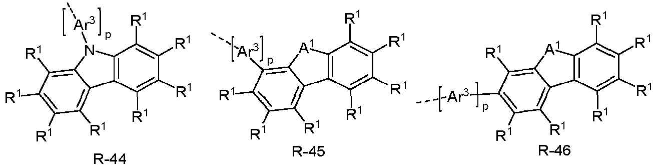 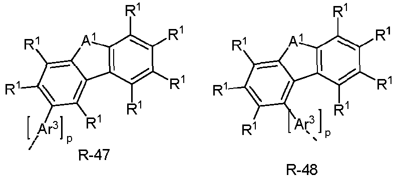 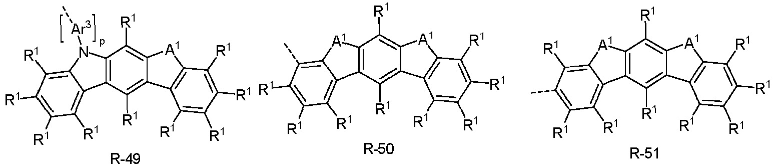 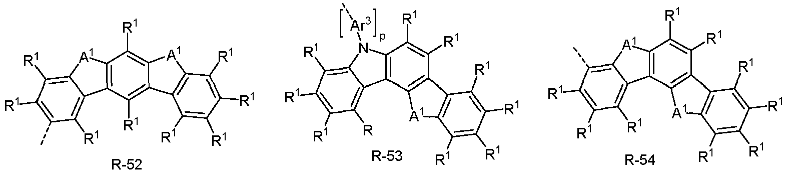 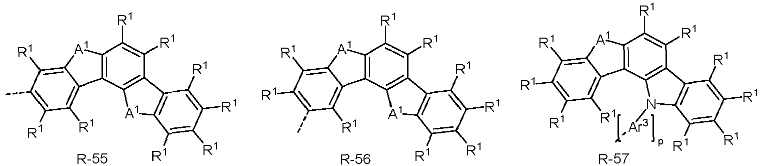 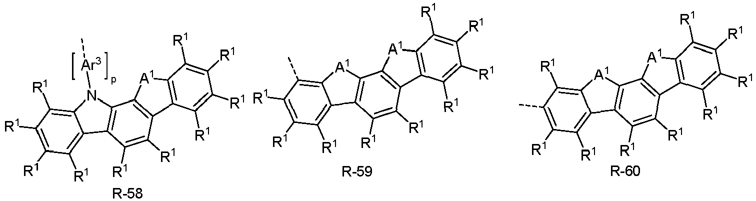 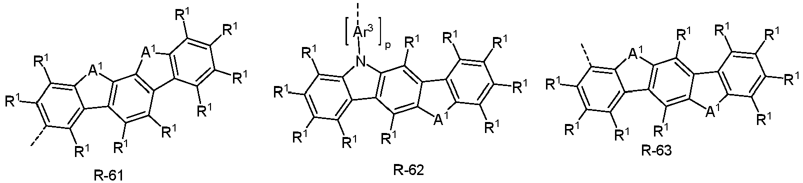 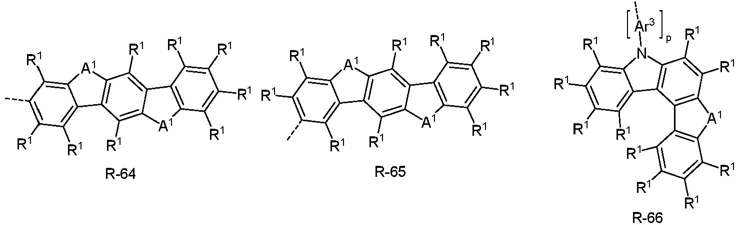 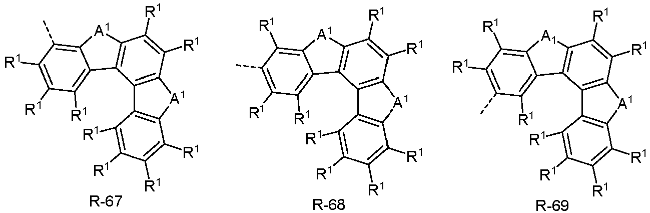 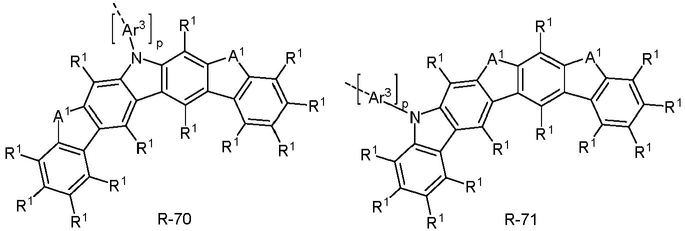 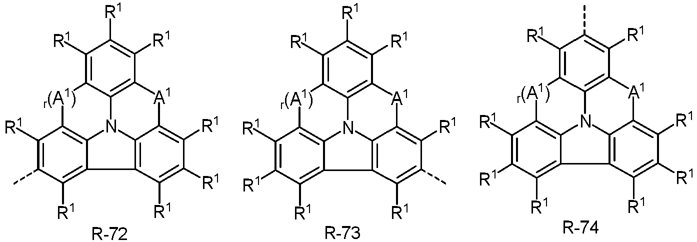 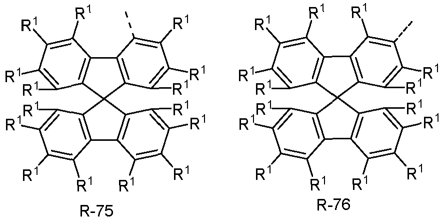 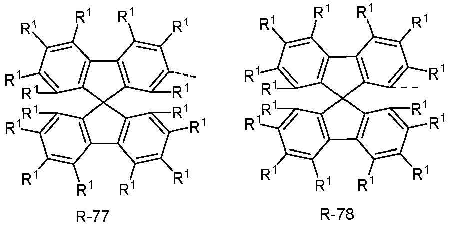 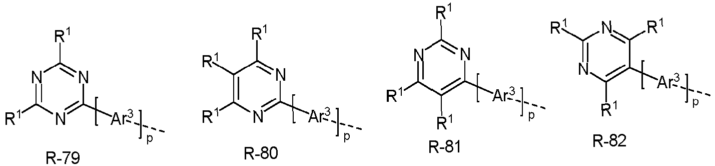 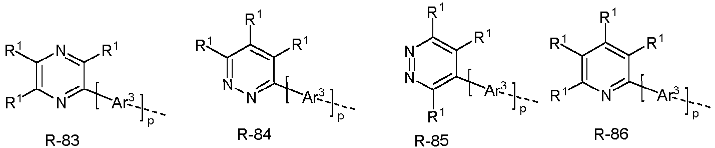 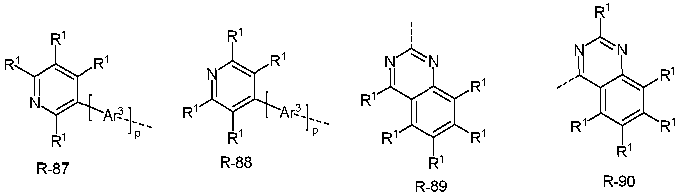 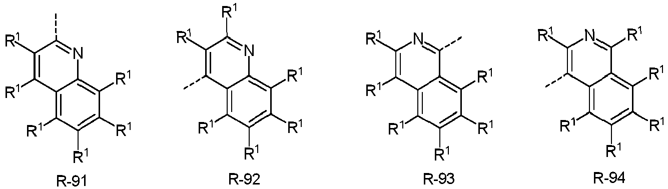 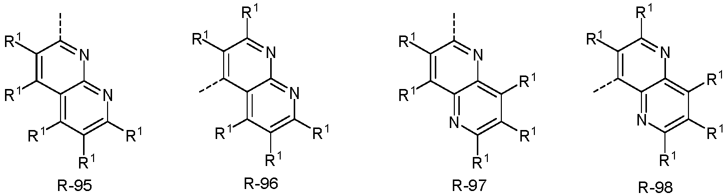 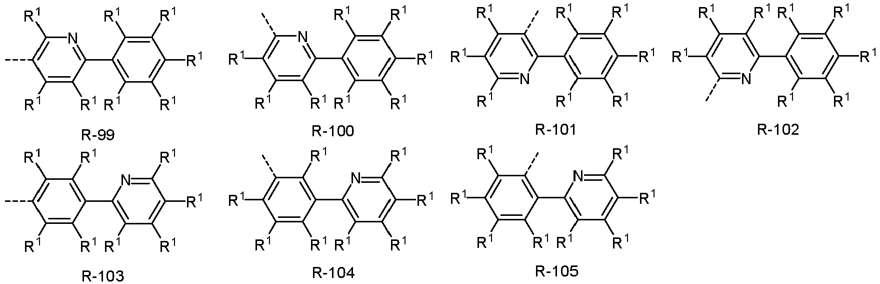 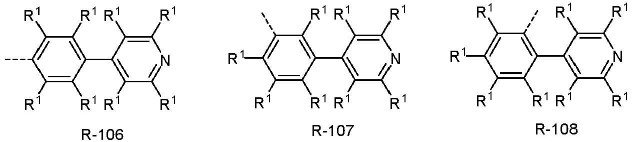 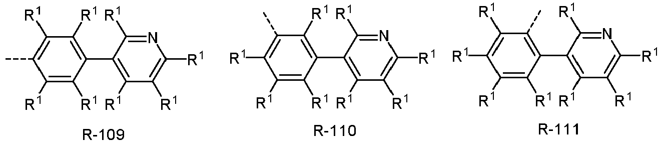 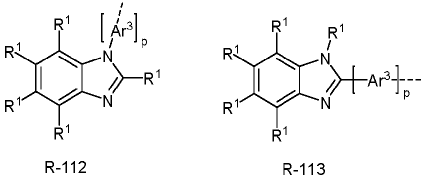 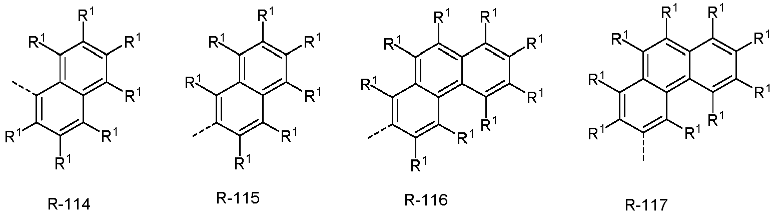 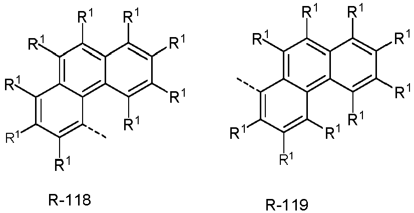 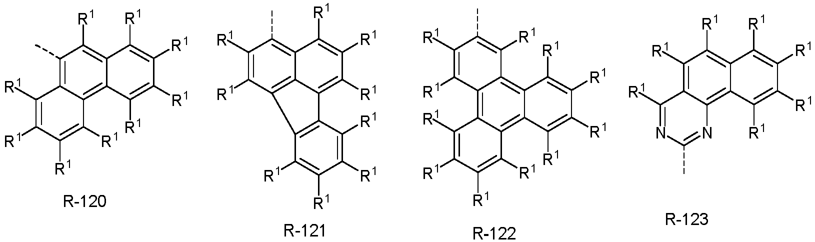 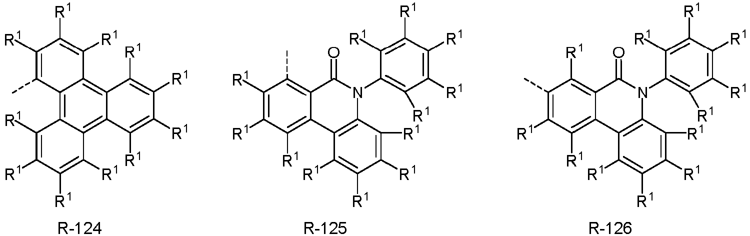 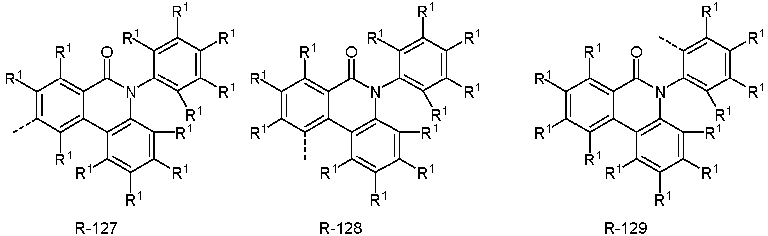 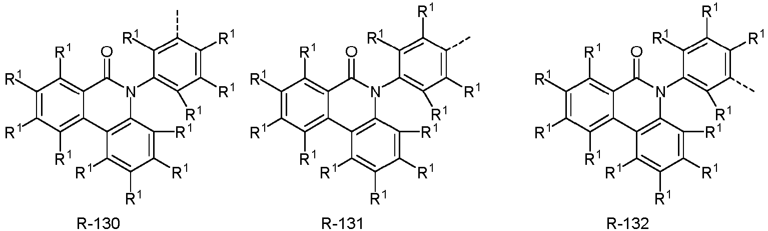 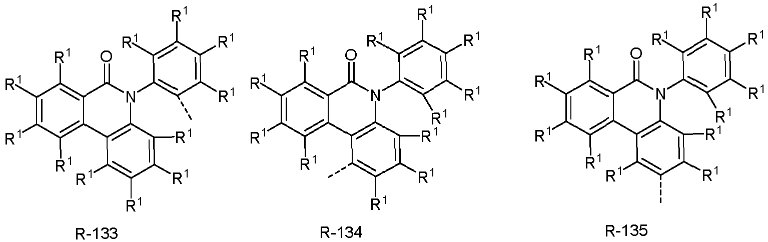 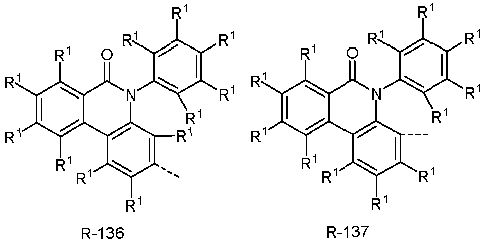 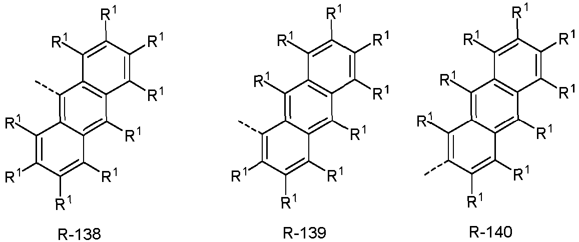 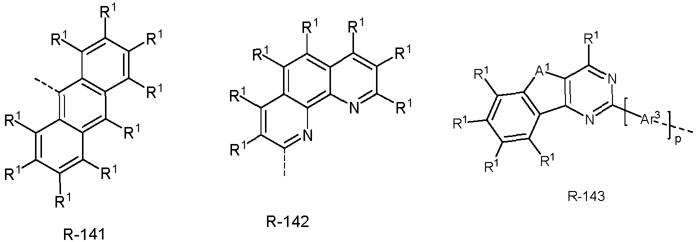 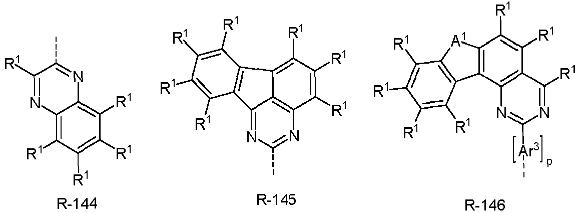 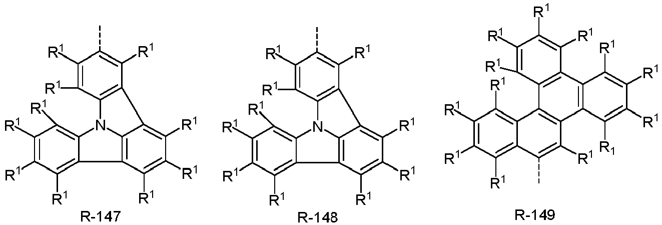 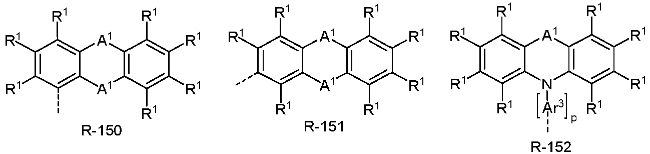 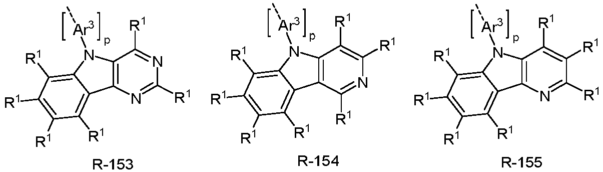 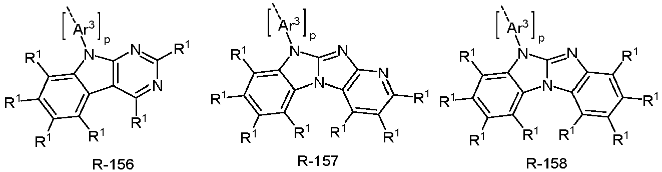 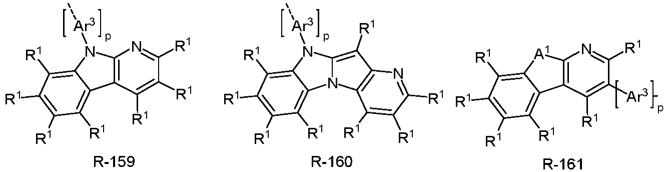 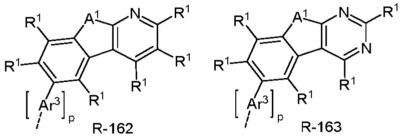 wobei R¹ die oben genannten Bedeutungen aufweist, die gestrichelte Bindung die Bindung zu Formel (1) und (2) darstellt und weiterhin gilt:
- Ar³: ist bei jedem Auftreten gleich oder verschieden ein bivalentes aromatisches oder heteroaromatisches Ringsystem mit 6 bis 18 aromatischen Ringatomen, welches jeweils mit einem oder mehreren Resten R¹ substituiert sein kann;
- A¹: ist bei jedem Auftreten gleich oder verschieden BR¹, C(R¹)₂, NR¹, O oder S, bevorzugt C(R¹)₂, NR¹, O oder S;
- A²: ist bei jedem Auftreten gleich oder verschieden C(R¹)₂, NR¹, O oder S;
- p: ist 0 oder 1, wobei p = 0 bedeutet, dass die Gruppe Ar³ nicht vorhanden ist und dass die entsprechende aromatische bzw. heteroaromatische Gruppe direkt an ein Kohlenstoffatom des Grundgerüsts in Formel (1) und (2) bzw. an den Stickstoff im Falle von Y gleich NR₂, gebunden ist, wobei im Fall von Bindung an den Stickstoff für die Formeln R-44, R-49, R-53, R-57, R-58, R-62, R-66, R-70, R-71, R-112, R-152 bis R-160 p gleich 1 ist;
- r: ist 0 oder 1, wobei r = 0 bedeutet, dass an dieser Position keine Gruppe A¹ gebunden ist und an die entsprechenden Kohlenstoffatome stattdessen Reste R¹ gebunden sind.

In einer bevorzugten Ausführungsform umfasst Ar³ bivalente aromatische oder heteroaromatische Ringsysteme basierend auf den Gruppen der R-1 bis R-163, wobei p gleich 0 gilt und die gestrichelte Bindung und ein R¹ für die Bindung zur aromatischen oder heteroaromatischen Gruppe nach R-1 bis R-163 steht.

Wenn die oben genannten Gruppen R-1 bis R-163 für R oder R' mehrere Gruppen A¹ aufweisen, so kommen hierfür alle Kombinationen aus der Definition von A¹ in Frage. Bevorzugte Ausführungsformen sind dann solche, in denen eine Gruppe A¹ für C(R¹)₂, NR¹, O oder S und die andere Gruppe A¹ für C(R¹)₂ steht oder in denen beide Gruppen A¹ für S oder O stehen oder in denen beide Gruppen A¹ für O bzw. S stehen.

Wenn A¹ für NR¹ steht, steht der Substituent R¹, der an das Stickstoffatom gebunden ist, bevorzugt für ein aromatisches oder heteroaromatisches Ringsystem mit 5 bis 24 aromatischen Ringatomen, welches auch durch einen oder mehrere Reste R² substituiert sein kann. In einer besonders bevorzugten Ausführungsform steht dieser Substituent R¹ gleich oder verschieden bei jedem Auftreten für ein aromatisches oder heteroaromatisches Ringsystem mit 6 bis 24 aromatischen Ringatomen, bevorzugt mit 6 bis 12 aromatischen Ringatomen, welches keine kondensierten Arylgruppen oder Heteroarylgruppen, in denen zwei oder mehr aromatische bzw. heteroaromatische 6-Ring-Gruppen direkt aneinander ankondensiert sind, aufweist, und welches jeweils auch durch einen oder mehrere Reste R² substituiert sein kann. Besonders bevorzugt sind Phenyl, Biphenyl, Terphenyl und Quaterphenyl mit Verknüpfungsmustern, wie vorne für R-1 bis R-35 aufgeführt, wobei diese Strukturen durch einen oder mehrere Reste R¹ substituiert sein können, bevorzugt aber unsubstituiert sind.

Wenn A¹ für C(R¹)₂ steht, stehen die Substituenten R¹, die an dieses Kohlenstoffatom gebunden sind, bevorzugt gleich oder verschieden bei jedem Auftreten für eine lineare Alkylgruppe mit 1 bis 10 C-Atomen oder für eine verzweigte oder zyklische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste R² substituiert sein kann. Ganz besonders bevorzugt steht R¹ für eine Methylgruppe oder für eine Phenylgruppe. Dabei können die Reste R¹ auch miteinander ein Ringsystem bilden, was zu einem Spirosystem führt.

Wenn Y für CR₂ steht, stehen die Substituenten R, die an dieses Kohlenstoffatom gebunden sind, bevorzugt gleich oder verschieden bei jedem Auftreten für eine lineare Alkylgruppe mit 1 bis 10 C-Atomen oder für eine verzweigte oder zyklische Alkylgruppe mit 3 bis 10 C-Atomen oder für ein aromatisches oder elektronenarmes heteroaromatisches Ringsystem mit 5 bis 24 aromatischen Ringatomen, welches auch durch einen oder mehrere Reste R¹ substituiert sein kann. Ganz besonders bevorzugt stehen diese Substituenten R für eine Methylgruppe oder für eine Phenylgruppe. Dabei können die Reste R auch miteinander ein Ringsystem bilden, was zu einem Spirosystem führt.

In einer bevorzugten Ausführungsform der Erfindung ist R' bei jedem Auftreten gleich oder verschieden ausgewählt aus der Gruppe bestehend aus H, D, F, CN, N(Ar')₂, OR¹, einem aromatischen oder heteroaromatischen Ringsystem mit 6 bis 30 aromatischen Ringatomen, das jeweils durch einen oder mehrere Reste R¹ substituiert sein kann.

Wenn Y für CR₂, O oder S steht ist, ist R' bei jedem Auftreten gleich oder verschieden ausgewählt aus der Gruppe bestehend aus H, D, F, CN, N(Ar')₂, OR¹, einem aromatischen oder heteroaromatischen Ringsystem mit 6 bis 30 aromatischen Ringatomen, das jeweils durch einen oder mehrere Reste R¹ substituiert sein kann.

Besonders bevorzugt ist R' bei jedem Auftreten gleich oder verschieden ausgewählt aus der Gruppe bestehend aus H, D, F, CN, N(Ar')₂ oder einem aromatischen oder heteroaromatischen Ringsystem mit 6 bis 24 aromatischen Ringatomen, das jeweils durch einen oder mehrere Reste R², bevorzugt nicht-aromatische Reste R², substituiert sein kann.

Wenn Y für O oder S steht, ist R' bei jedem Auftreten gleich oder verschieden ausgewählt aus der Gruppe bestehend aus H, D, F, CN, N(Ar')₂, einem aromatischen oder heteroaromatischen Rinasvstem mit 6 bis 30 aromatischen Ringatomen, das jeweils durch einen oder mehrere Reste R¹ substituiert sein kann.

In einer bevorzugten Ausführungsform steht R' für D, F, CN, N(Ar')₂, einem aromatischen oder heteroaromatischen Ringsystem mit 6 bis 30 aromatischen Ringatomen, das ieweils durch einen oder mehrere Reste R¹ substituiert sein kann. Bevorzugt steht R dann für H, D, CN oder F.

Geeignete aromatische bzw. heteroaromatische Ringsysteme R' sind ausgewählt aus Phenyl, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluoren, welches über die 1-, 2-, 3- oder 4-Position verknüpft sein kann, Spirobifluoren, welches über die 1-, 2-, 3- oder 4-Position verknüpft sein kann, Naphthalin, welches über die 1- oder 2-Position verknüpft sein kann, Indol, Benzofuran, Benzothiophen, welches über die 1-, 2-, 3- oder 4-Position verknüpft sein kann, Dibenzofuran, Carbazol, welches über die 1-, 2-, 3- oder 4-Position verknüpft sein kann, Dibenzothiophen, welches über die 1-, 2-, 3- oder 4-Position verknüpft sein kann, Indenocarbazol, Indolocarbazol, Pyridin, Pyrimidin, Pyrazin, Pyridazin, Triazin, Chinolin, Chinazolin, Benzimidazol, Phenanthren, Triphenylen oder einer Kombination aus zwei oder drei dieser Gruppen, welche jeweils mit einem oder mehreren Resten R¹ substituiert sein können. Wenn R für eine Heteroarylgruppe, insbesondere für Triazin, Pyrimidin oder Chinazolin steht, können auch aromatische oder heteroaromatische Reste R¹ an dieser Heteroarylgruppe bevorzugt sein.

Dabei sind die Gruppen R', wenn sie für ein aromatisches bzw. heteroaromatisches Ringsystem stehen, bevorzugt gewählt aus den Gruppen der Formeln R-1 bis R-163.

In einer Ausführungsform der Erfindung steht mindestens ein Rest R und/oder R' für ein elektronenreiches heteroaromatisches Ringsystem. Dabei ist das elektronenreiche heteroaromatische Ringsystem bevorzugt gewählt aus den oben abgebildeten Gruppen R-44 bis R-74, wobei in den Gruppen R-45 bis R-48, R-50 bis R-52, R-54 bis R-56, R-59 bis R-61, R-63 bis R-65 und R-67 bis R-69 mindestens eine Gruppe A¹ für NR¹ steht, wobei R¹ bevorzugt für ein aromatisches oder heteroaromatisches Ringsystem steht, insbesondere für ein aromatisches Ringsystem.

In einer weiteren besonders bevorzugten Ausführungsform der Erfindung steht mindestens ein Rest R und/oder R' für ein elektronenarmes heteroaromatisches Ringsystem. Dabei ist das elektronenarme heteroaromatische Ringsystem bevorzugt gewählt aus den oben abgebildeten Gruppen R-79 bis R-113, R-123, R-141 bis 146.

In einer weiteren bevorzugten Ausführungsform der Erfindung ist R¹ gleich oder verschieden bei jedem Auftreten ausgewählt aus der Gruppe bestehend aus H, D, F, CN, OR², einer geradkettigen Alkylgruppe mit 1 bis 10 C-Atomen oder einer Alkenylgruppe mit 2 bis 10 C-Atomen oder einer verzweigten oder zyklischen Alkylgruppe mit 3 bis 10 C-Atomen, wobei die Alkyl- bzw. Alkenylgruppe jeweils mit einem oder mehreren Resten R² substituiert sein kann und wobei eine oder mehrere nicht benachbarte CH₂-Gruppen durch O ersetzt sein können, oder einem aromatischen oder heteroaromatischen Ringsystem mit 6 bis 30 aromatischen Ringatomen, das jeweils durch einen oder mehrere Reste R² substituiert sein kann; dabei können zwei oder mehrere Reste R¹ miteinander ein aliphatisches Ringsystem bilden. In einer besonders bevorzugten Ausführungsform der Erfindung ist R¹ gleich oder verschieden bei jedem Auftreten ausgewählt aus der Gruppe bestehend aus H, einer geradkettigen Alkylgruppe mit 1 bis 6 C-Atomen, insbesondere mit 1, 2, 3 oder 4 C-Atomen, oder einer verzweigten oder zyklischen Alkylgruppe mit 3 bis 6 C-Atomen, wobei die Alkylgruppe mit einem oder mehreren Resten R² substituiert sein kann, bevorzugt aber unsubstituiert ist, oder einem aromatischen oder heteroaromatischen Ringsystem mit 6 bis 24 aromatischen Ringatomen, das jeweils durch einen oder mehrere Reste R² substituiert sein kann, bevorzugt aber unsubstituiert ist.

In einer weiteren bevorzugten Ausführungsform der Erfindung ist R² gleich oder verschieden bei jedem Auftreten H, F, eine Alkylgruppe mit 1 bis 4 C-Atomen oder eine Arylgruppe mit 6 bis 10 C-Atomen, welche mit einer Alkylgruppe mit 1 bis 4 C-Atomen substituiert sein kann, bevorzugt aber unsubstituiert ist.

In einer weiteren bevorzugten Ausführungsform der Erfindung sind alle Reste R¹, soweit sie für ein aromatisches oder heteroaromatisches Ringsystem, bzw. R² soweit sie für aromatische oder heteroaromatische Gruppen stehen, ausgewählt aus den Gruppen R-1 bis R-163, welche allerdings dann jeweils entsprechend mit R², bzw. den bei R² genannten Gruppen substituiert sind.

In einer bevorzugten Ausführungsform bilden die Reste R keine weiteren an das Grundgerüst der Formel (1) ankondensierten aromatischen oder heteroaromatischen Gruppen.

In einer bevorzugten Ausführungsform steht R für H, D F oder für ein aromatisches oder heteroaromatisches Ringsystem ausgewählt aus den Gruppen R-1 bis R-4, R-44 bis R-48, wobei zusätzlich gilt, dass R¹ für H,D oder F steht und p soweit vorhanden gleich 0 ist.

Dabei haben die Alkylgruppen in erfindungsgemäßen Verbindungen, die durch Vakuumverdampfung verarbeitet werden, bevorzugt nicht mehr als fünf C-Atome, besonders bevorzugt nicht mehr als 4 C-Atome, ganz besonders bevorzugt nicht mehr als 1 C-Atom. Für Verbindungen, die aus Lösung verarbeitet werden, eignen sich auch Verbindungen, die mit Alkylgruppen, insbesondere verzweigten Alkylgruppen, mit bis zu 10 C-Atomen substituiert sind oder die mit Oligoarylengruppen, beispielsweise ortho-, meta-, para- oder verzweigten Terphenyl- oder Quaterphenylgruppen, substituiert sind.

Die oben genannten bevorzugten Ausführungsformen können beliebig innerhalb der in Anspruch 1 definierten Einschränkungen miteinander kombiniert werden. In einer besonders bevorzugten Ausführungsform der Erfindung treten die oben genannten Bevorzugungen gleichzeitig auf.

Beispiele für bevorzugte Verbindungen gemäß den oben aufgeführten Ausführungsformen sind die in der folgenden Tabelle aufgeführten Verbindungen.

| | |
|---|---|
| 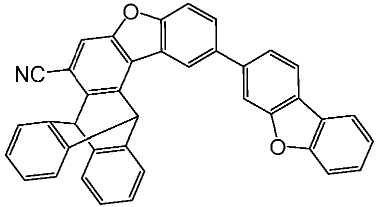 | 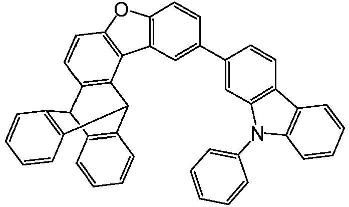 |
| 1 | 2 |
| 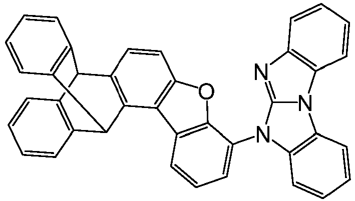 | 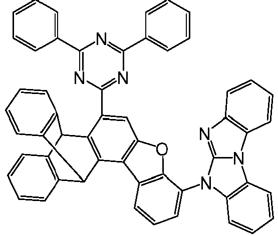 |
| 3 | 4 |
| 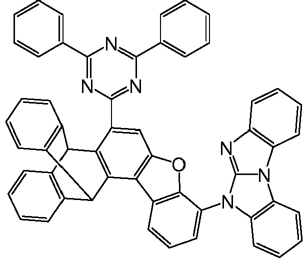 | 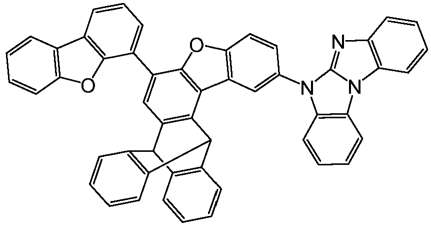 |
| 5 | 6 |
| 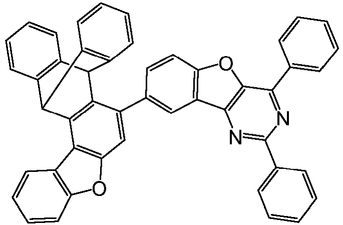 | 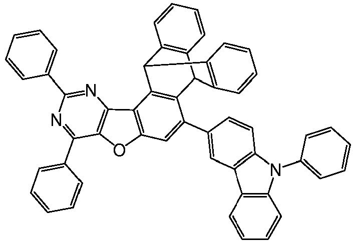 |
| 7 | 8 |
| 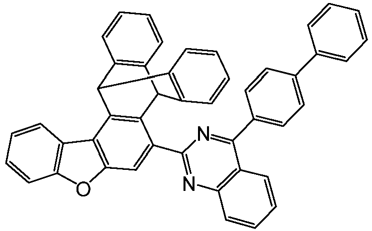 | 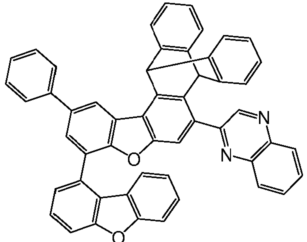 |
| 9 | 10 |
| 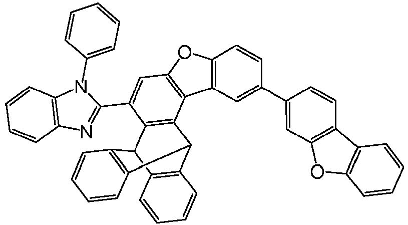 | 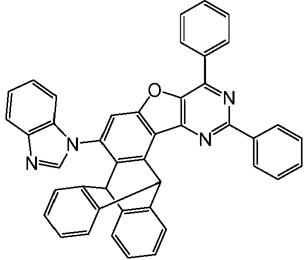 |
| 11 | 12 |
| 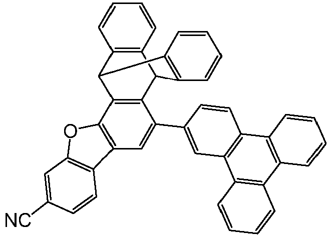 | 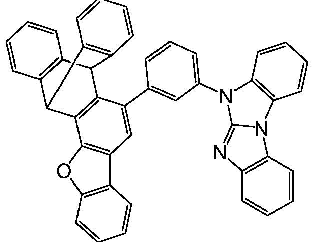 |
| 13 | 14 |
| 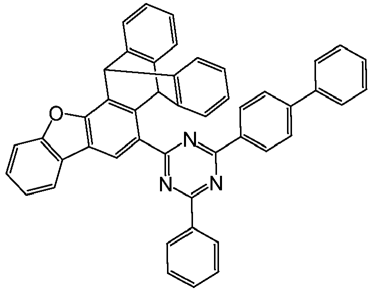 | 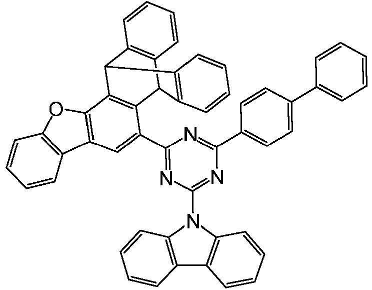 |
| 15 | 16 |
| 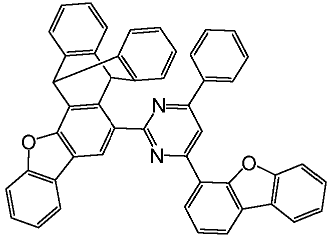 | 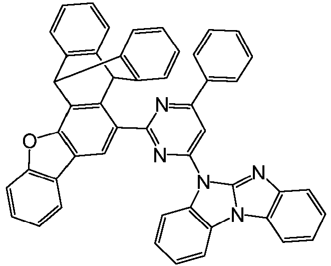 |
| 17 | 18 |
| 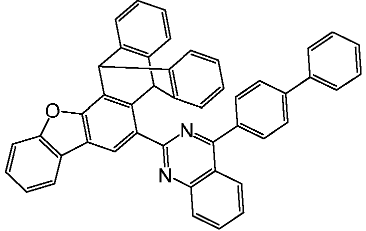 | 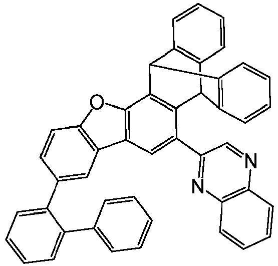 |
| 19 | 20 |
| 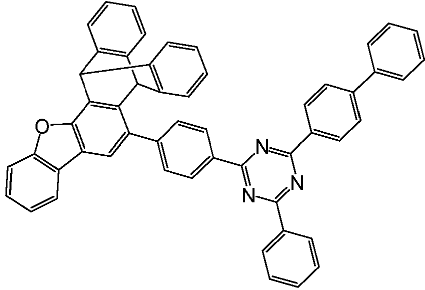 | 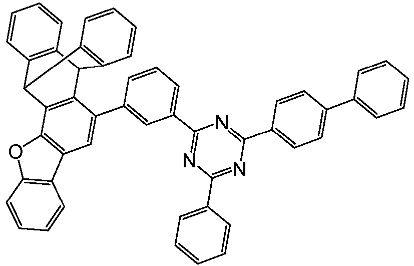 |
| 21 | 22 |
| 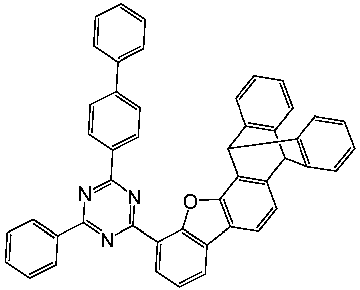 | 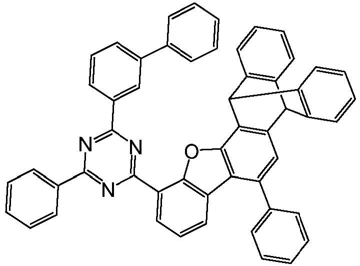 |
| 23 | 24 |
| 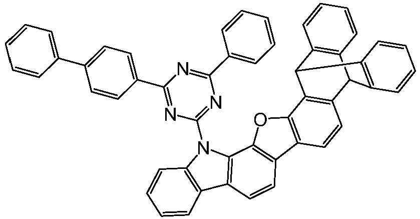 | 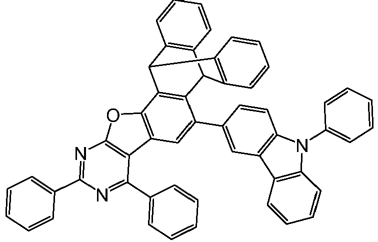 |
| 25 | 26 |
| 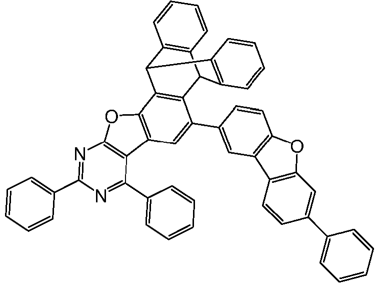 | 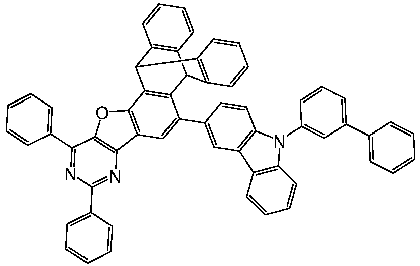 |
| 27 | 28 |
| 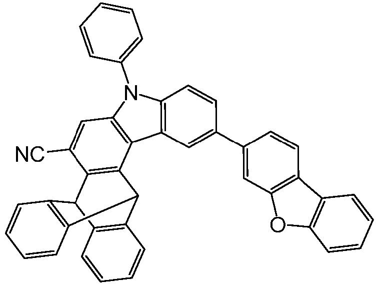 | 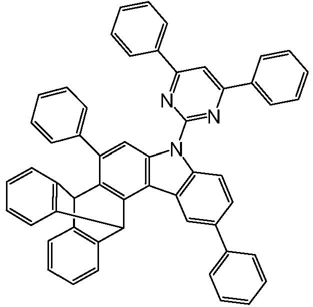 |
| 29 | 30 |
| 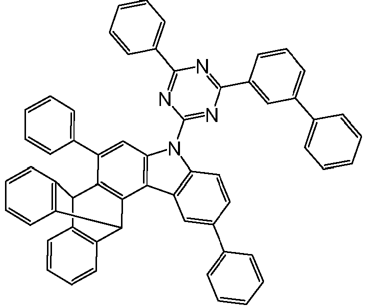 | 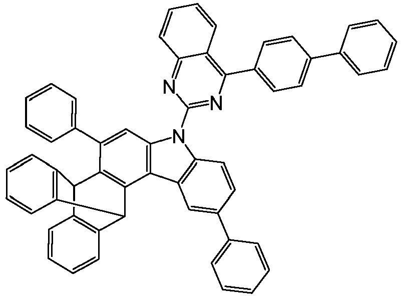 |
| 31 | 32 |
| 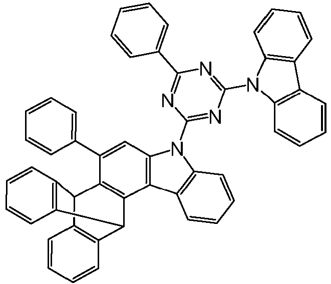 | 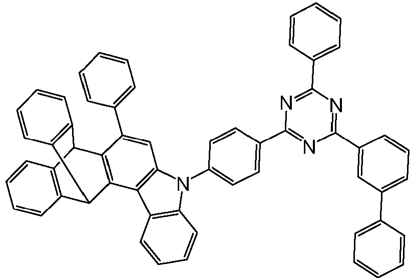 |
| 33 | 34 |
| 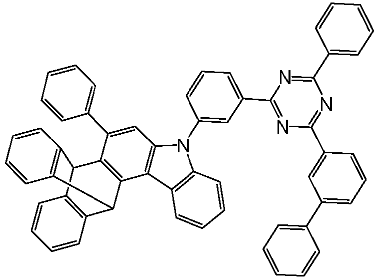 | 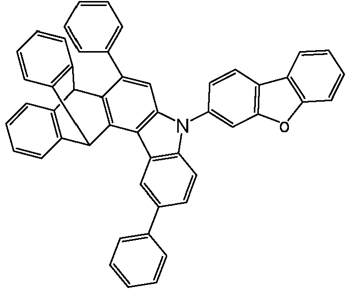 |
| 35 | 36 |
| 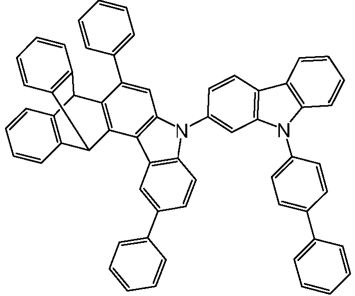 | 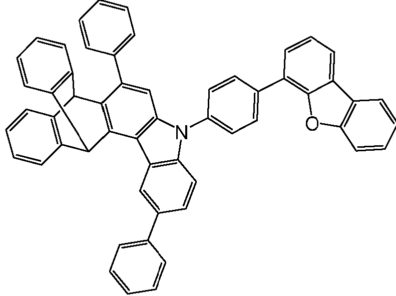 |
| 37 | 38 |
| 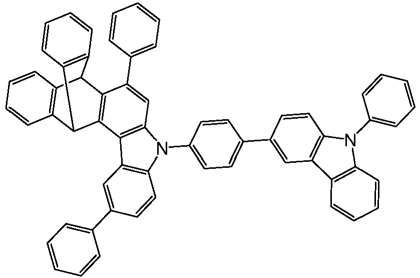 | 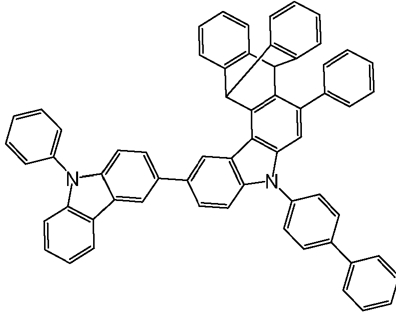 |
| 39 | 40 |
| 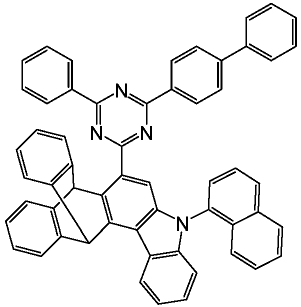 | 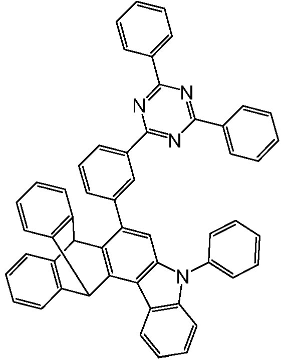 |
| 41 | 42 |
| 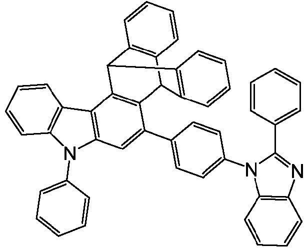 | 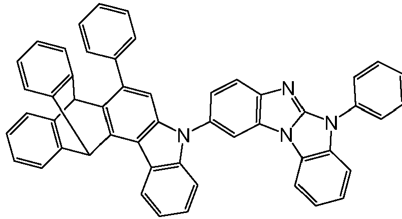 |
| 43 | 44 |
| 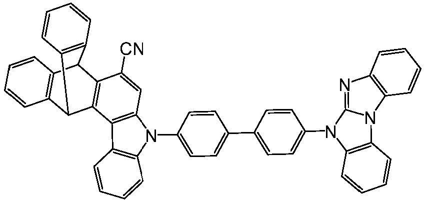 | 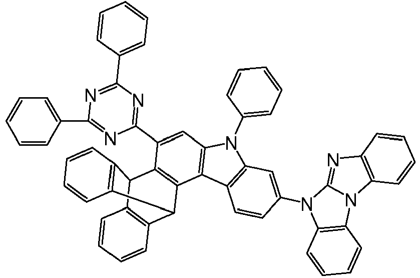 |
| 45 | 46 |
| 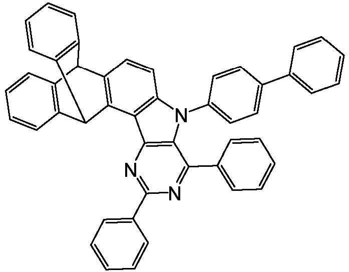 | 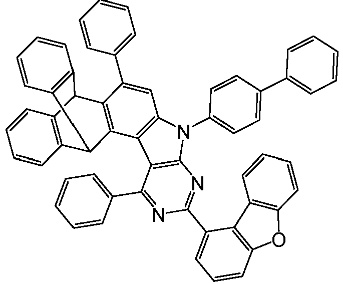 |
| 47 | 48 |
| 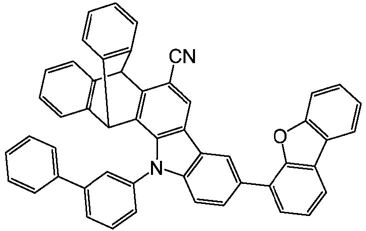 | 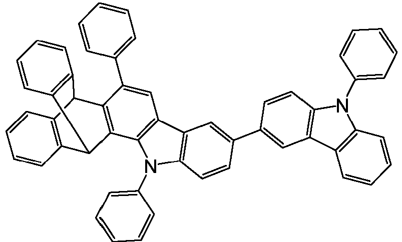 |
| 49 | 50 |
| 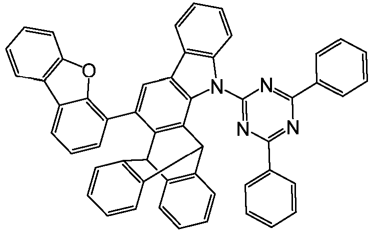 | 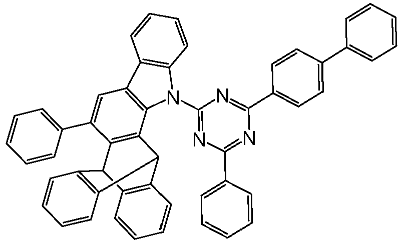 |
| 51 | 52 |
| 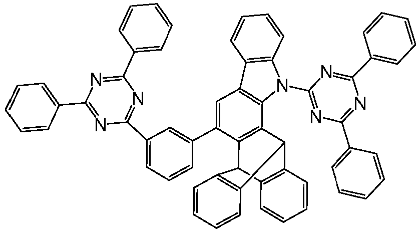 | 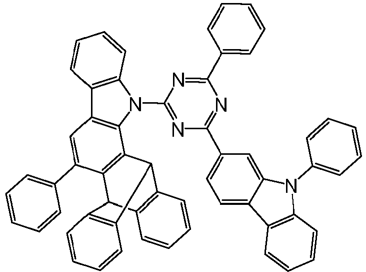 |
| 53 | 54 |
| 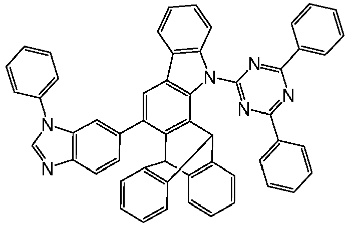 | 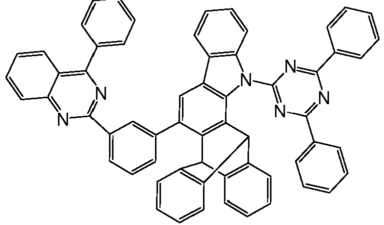 |
| 55 | 56 |
| 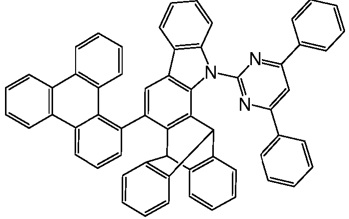 | 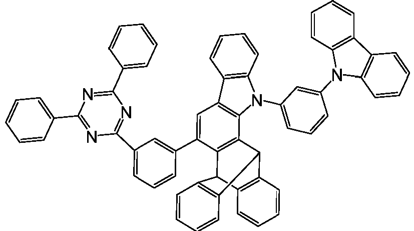 |
| 57 | 58 |
| 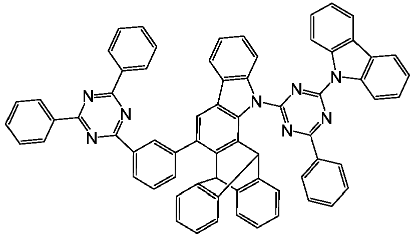 | 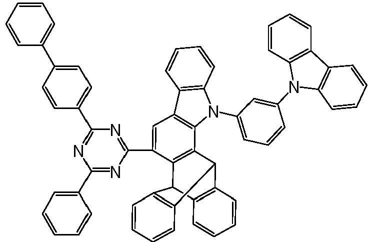 |
| 59 | 60 |
| 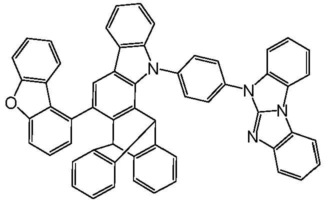 | 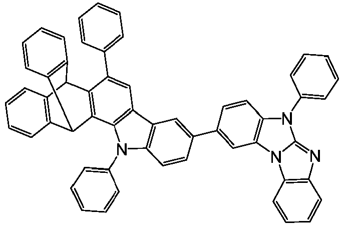 |
| 61 | 62 |
| 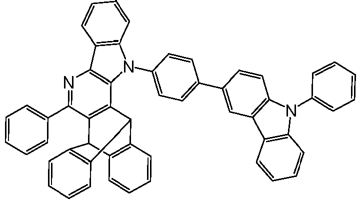 | 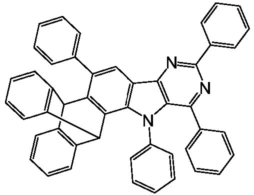 |
| 63 | 64 |
| 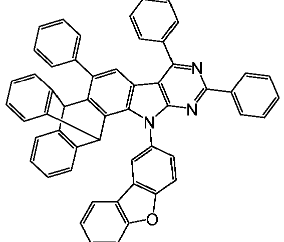 | 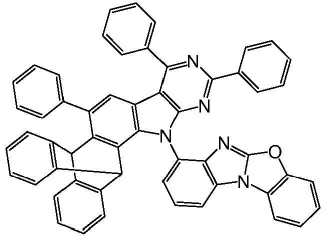 |
| 65 | 66 |
| 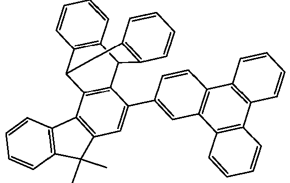 | 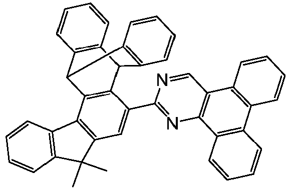 |
| 67 | 68 |
| 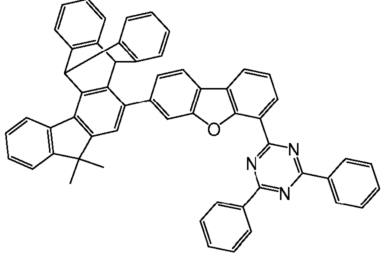 | 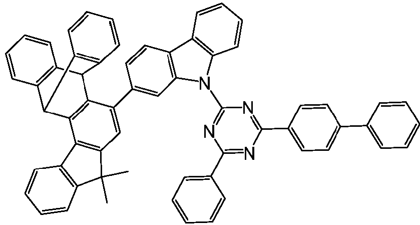 |
| 70 | 71 |
| 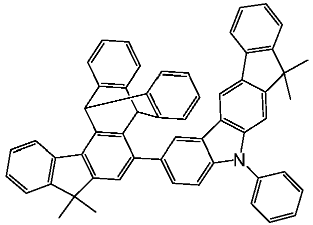 | 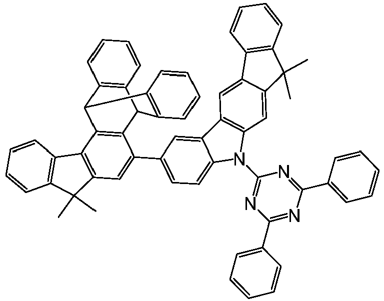 |
| 72 | 73 |
| 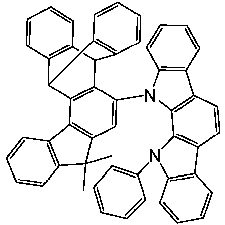 | 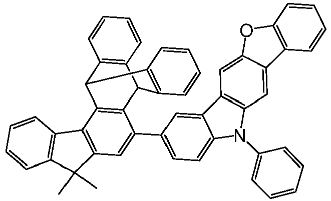 |
| 74 | 75 |
| 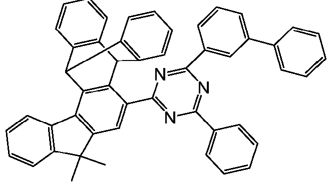 | 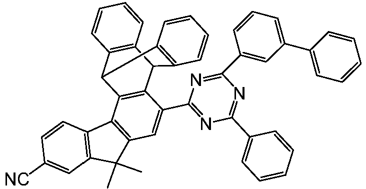 |
| 76 | 77 |
| 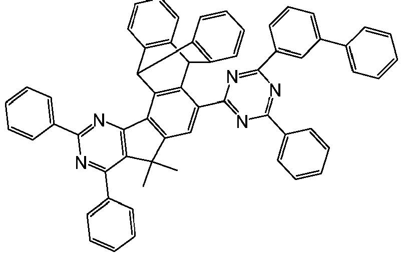 | 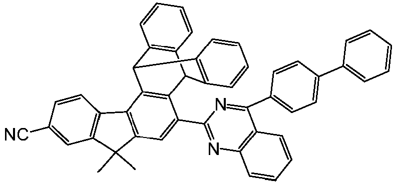 |
| 78 | 79 |
| 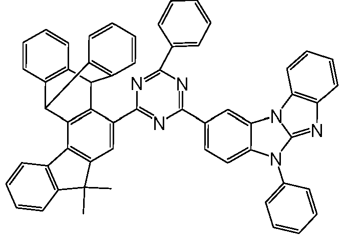 | 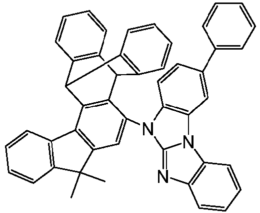 |
| 80 | 81 |
| 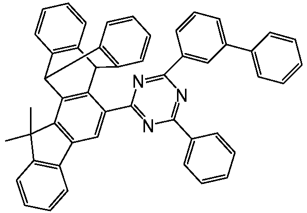 | 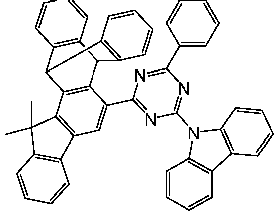 |
| 82 | 83 |
| 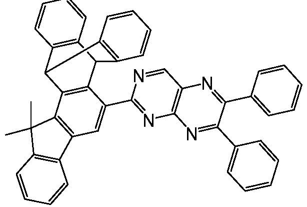 | 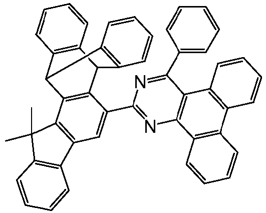 |
| 84 | 85 |
| 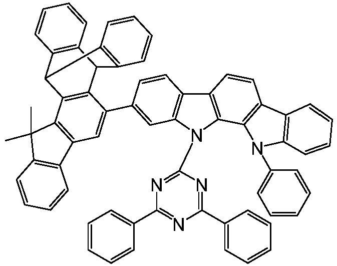 | 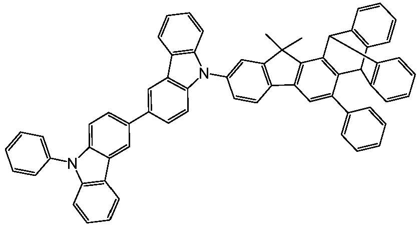 |
| 86 | 87 |
| 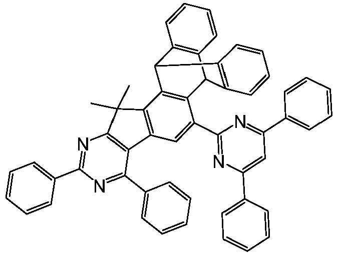 | 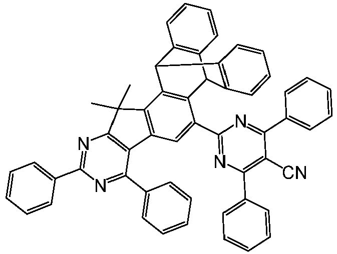 |
| 88 | 89 |
| 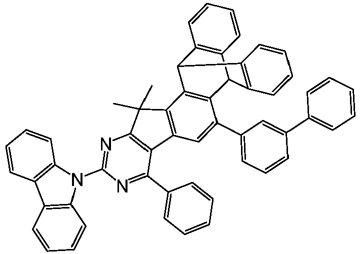 | 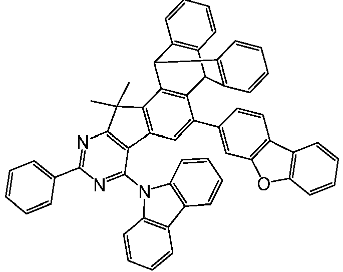 |
| 90 | 91 |
| 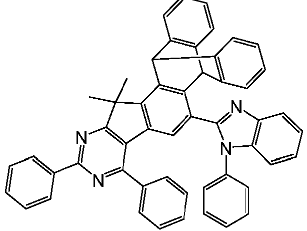 | 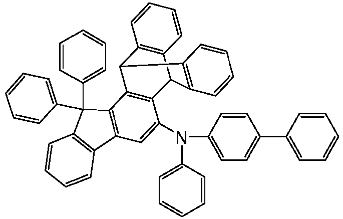 |
| 92 | 93 |
| 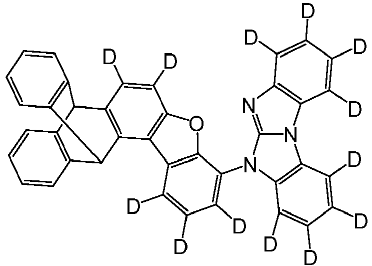 | 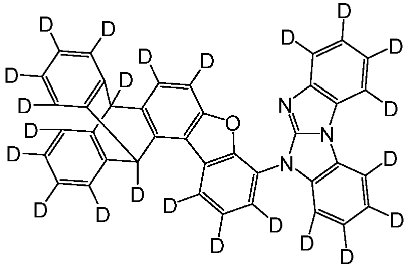 |
| 94 | 95 |
| 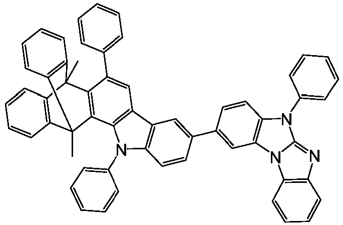 | 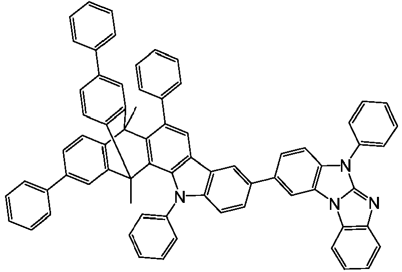 |
| 96 | 97 |
| 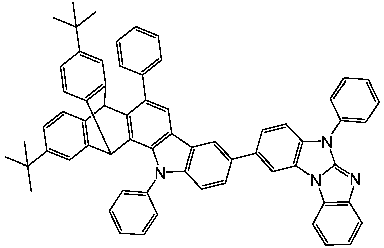 | 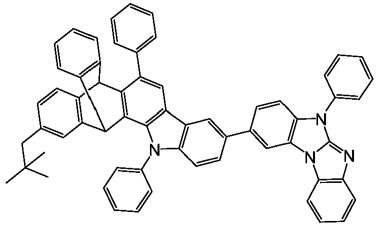 |
| 98 | 99 |
| 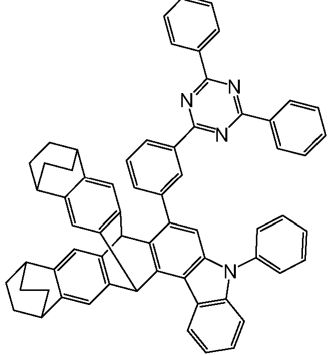 | 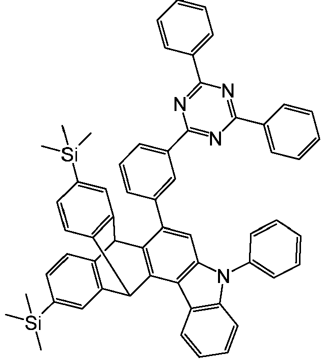 |
| 100 | 101 |
| 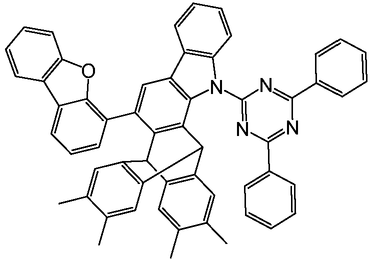 | 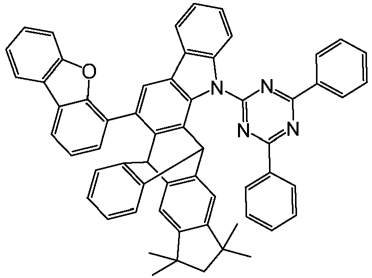 |
| 102 | 103 |
| 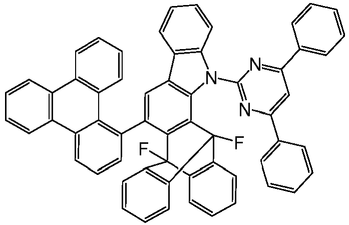 | 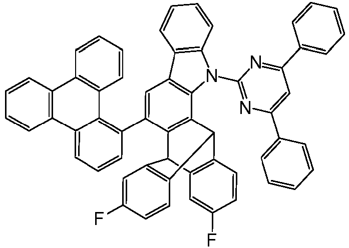 |
| 104 | 105 |
| 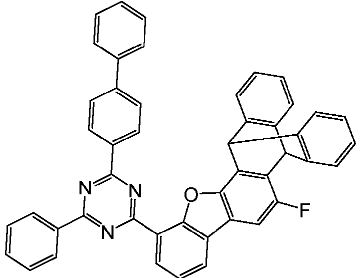 | 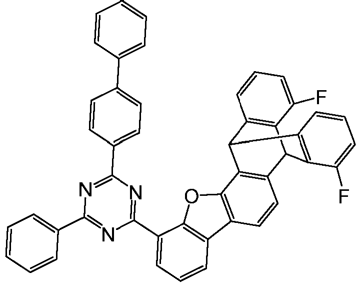 |
| 106 | 107 |

Die erfindungsgemäßen Verbindungen können nach dem Fachmann bekannten Syntheseschritten, wie z. B. Bromierung, Suzuki-Kupplung, Ullmann-Kupplung, Heck-Reaktion, Hartwig-Buchwald-Kupplung, oxidative und Übergangs-Metall-katalysierte Cyclisierungen, etc., dargestellt werden.

Ein weiterer Gegenstand der vorliegenden Erfindung ist daher ein Verfahren zur Herstellung der erfindungsgemäßen Verbindungen, gekennzeichnet durch die folgenden Schritte:
(A) Synthese des Grundgerüsts nach Formel (1);
(B) Ankondensieren der Struktur nach Formel (2) unter Bildung der mit * bezeichneten Bindungen durch Kupplungs- und Ringschlussreaktion.

Die erfindungsgemäßen Verbindungen können ausgehend von:
a) 9,10-Dihydro-4-iodo-9,10[1',2']-benzenoanthracen-1-yl-trifluormethansulsonsäureester [1370032-72-6] durch eine Suzuki-Kupplungen der Iod-Funktion, mit einer Aryl-/Heteroaryl-Boronsäure bzw. -ester ((HO)₂B-Ar), gefolgt von einem Ruthenium-katalysierten Triflat-Bromid-Austausch nach Y. Imazaki et al., J. Am. Chem. Soc., 2012, 134, 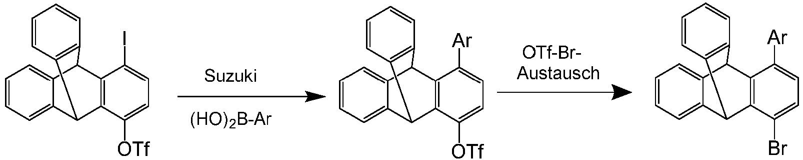
b) 1-Brom-9,10-dihydro-4-iodo-9,10[1',2']-benzenoanthracen [56564-84-2] durch eine Hartwig-Buchwald-Aminierung bzw. alternativ eine Ullmann-Kupplung der Iod-Funktion mit einem sekundären Amin oder Carbazol (Ar1Ar2NH), 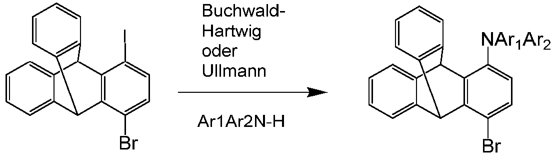 gefolgt von einer C-C-, C-O- oder C-N-Kupplung der Brom-Funktion und einer Cyclisierung unter Aufbau eines Dibenzofurans D vom Typ 1 oder Typ 2, eines Carbazols C vom Typ 1 oder Typ 2 bzw. eines Fluorens F vom Typ 1 erhalten werden, wie dies in den folgenden Schemata 1) bis 5) gezeigt ist:

### 1) Dibenzofuran D vom Typ 1:

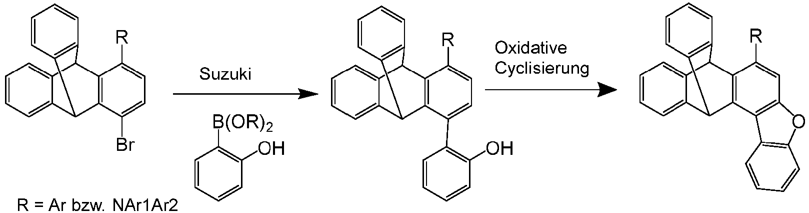

### 2) Dibenzofurane D vom Typ 2:

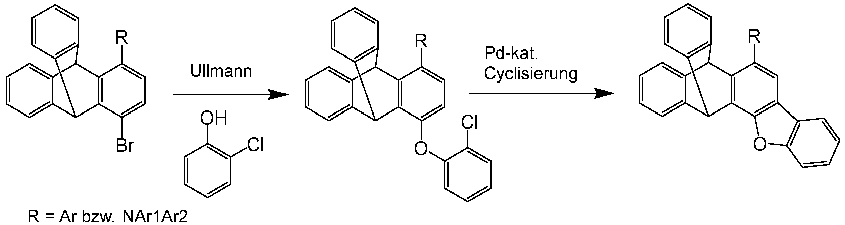

### 3) Carbazole C vom Typ 1:

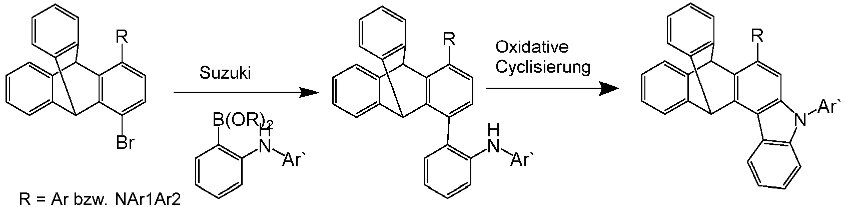

### 4) Carbazole C vom Typ 2:

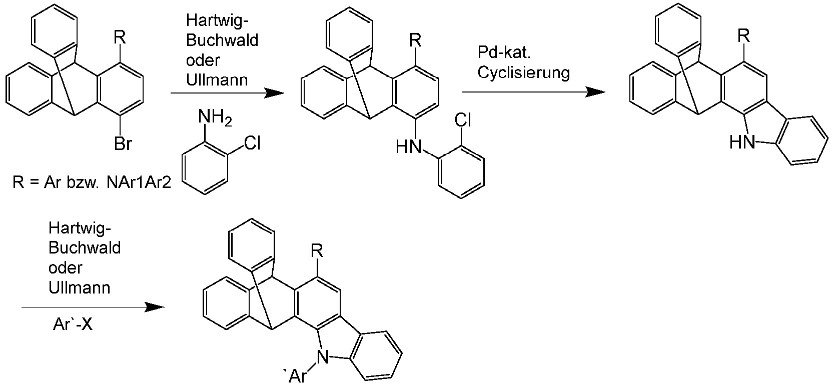

### 5) Fluorene F vom Typ 1:

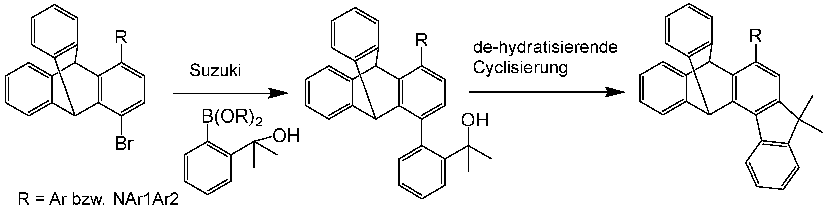

Fluorene F vom Typ 2 können ausgehend von den R-funktionalisierten Triflaten oder Bromiden durch De-Triflatisierung bzw. Dehalogenierung, regioselektive Friedel-Crafts-Alkylierung mit einem tertiären Aralkyl-Rest und anschließende Pd-katalysierte Cyclisierung dargestellt werden.

### 6) Fluorene F vom Typ 2:

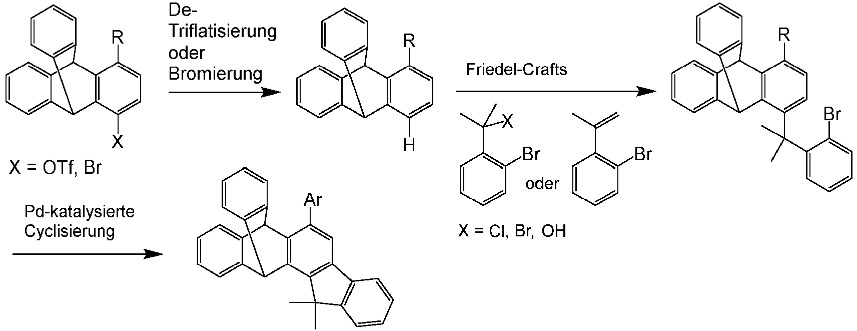

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, insbesondere eine Lösung, Dispersion oder Emulsion, umfassend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die Herstellung solcher Lösungen ist dem Fachmann bekannt und ist beispielsweise beschrieben in WO 2002/072714, WO 2003/019694 und der darin zitierten Literatur. Die weitere Verbindung kann aber auch mindestens eine weitere organische oder anorganische Verbindung sein, die ebenfalls in der elektronischen Vorrichtung eingesetzt wird, beispielsweise eine emittierende Verbindung und/oder ein Matrixmaterial. Diese weitere Verbindung kann auch polymer sein.

Die erfindungsgemäßen Verbindungen eignen sich für die Verwendung in einer elektronischen Vorrichtung, insbesondere in einer organischen Elektrolumineszenzvorrichtung (OLED). Abhängig von der Substituierung können die Verbindungen in unterschiedlichen Funktionen und Schichten verwendet werden.

Ein weiterer Gegenstand der vorliegenden Erfindung ist daher die Verwendung einer erfindungsgemäßen Verbindung in einer elektronischen Vorrichtung.

Ein nochmals weiterer Gegenstand der vorliegenden Erfindung ist eine elektronische Vorrichtung enthaltend mindestens eine erfindungsgemäße Verbindung.

Die erfindungsgemäßen Verbindungen können insbesondere bei ihrer Verwendung als Racemat oder als reines Enantiomer vorliegen.

Eine elektronische Vorrichtung im Sinne der vorliegenden Erfindung ist eine Vorrichtung, welche mindestens eine Schicht enthält, die mindestens eine organische Verbindung enthält. Das Bauteil kann dabei auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), farbstoffsensibilisierten organischen Solarzellen (DSSCs), organischen optischen Detektoren, organischen Photorezeptoren, organischen Feld-Quench-Devices (O-FQDs), lichtemittierenden elektrochemischen Zellen (LECs), organischen Laserdioden (O-Laser) und "organic plasmon emitting devices", bevorzugt aber organischen Elektrolumineszenzvorrichtungen (OLEDs).

Die Vorrichtung ist besonders bevorzugt eine organische Elektrolumineszenzvorrichtung umfassend Kathode, Anode und mindestens eine emittierende Schicht, wobei mindestens eine organische Schicht, welche eine emittierende Schicht, Lochtransportschicht, Elektronentransportschicht, Lochblockierschicht, Elektronenblockierschicht oder eine andere funktionelle Schicht sein kann, mindestens eine erfindungsgemäße Verbindung umfasst. Die Schicht ist abhängig von der Substitution der Verbindung.

Außer diesen Schichten kann die organische Elektrolumineszenzvorrichtung noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten (Charge-Generation Layers) und/oder organische oder anorganische p/n Übergänge. Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, sodass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen (Der prinzipielle Aufbau ist beispielsweise in WO 2005/011013 beschrieben). Es kann sich bei der erfindungsgemäßen organischen Elektrolumineszenzvorrichtung auch um eine Tandem-OLED handeln, insbesondere für weiß emittierende OLEDs.

Bevorzugt wird die Verbindung gemäß Formel (1) in einer organischen Elektrolumineszenzvorrichtung verwendet, welche eine oder mehrere phosphoreszierende Emitter umfasst. Die erfindungsgemäße Verbindung gemäß den oben aufgeführten Ausführungsformen kann dabei in unterschiedlichen Schichten eingesetzt werden, je nach genauer Struktur.

Dabei kann die organische Elektrolumineszenzvorrichtung eine emittierende Schicht enthalten, oder sie kann mehrere emittierende Schichten enthalten, wobei mindestens eine Schicht mindestens eine erfindungsgemäße Verbindung enthält. Weiterhin kann die erfindungsgemäße Verbindung auch in einer Elektronentransportschicht und/oder in einer Lochblockierschicht und/oder in einer Lochtransportschicht und/oder in einer Exzitonenblockierschicht eingesetzt werden.

Der Ausdruck "phosphoreszierende Verbindung" bezeichnet typischerweise Verbindungen, bei denen die Aussendung von Licht durch einen spin-verbotenen Übergang erfolgt, z. B. einen Übergang von einem angeregten Triplett-Zustand oder einem Zustand mit einer höheren Spin-Quantenzahl, z. B. einem Quintett-Zustand.

Geeignete phosphoreszierende Verbindungen (= Triplett-Emitter) sind insbesondere Verbindungen, die bei geeigneter Anregung Licht, vorzugsweise im sichtbaren Bereich, emittieren und außerdem mindestens ein Atom der Ordnungszahl größer als 20, vorzugsweise größer als 38 und kleiner als 84, besonders bevorzugt größer als 56 und kleiner als 80 enthalten. Bevorzugt werden als phosphoreszierende Verbindungen alle lumineszierenden Komplexe mit Übergangsmetallen oder Lanthaniden angesehen, insbesondere wenn sie Kupfer, Molybdän, Wolfram, Rhenium, Ruthenium, Osmium, Rhodium, Iridium, Palladium, Platin, Silber, Gold oder Europium enthalten, insbesondere Verbindungen, die Iridium, Platin oder Kupfer enthalten. Im Rahmen der vorliegenden Erfindung werden alle lumineszierenden Iridium-, Platin- oder Kupferkomplexe als phosphoreszierende emittierende Verbindungen betrachtet.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/041769, WO 2019/020538, WO 2018/178001, WO 2019/115423 und WO 2019/158453 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden. Für den Fachmann ist es auch ohne erfinderische Tätigkeit möglich, weitere phosphoreszierende Komplexe in Kombination mit den Verbindungen der Formel (1) in organischen Elektrolumineszenzvorrichtungen zu verwenden. Weitere Beispiele sind in einer nachfolgenden Tabelle aufgeführt.

Erfindungsgemäß ist es auch möglich, die Verbindung der Formel (1) in einer elektronischen Vorrichtung zu verwenden, die eine oder mehrere fluoreszierende emittierende Verbindungen enthält.

In einer bevorzugten Ausführungsform der Erfindung werden die Verbindungen der Formel (1) als löchertransportierendes Material verwendet. In diesem Fall sind die Verbindungen vorzugsweise in einer Lochtransportschicht, einer Elektronenblockierschicht oder einer Lochinjektionsschicht enthalten. Besonders bevorzugt ist die Verwendung in einer Elektronenblockierschicht.

Eine Lochtransportschicht im Sinne der vorliegenden Anmeldung ist eine Schicht mit lochtransportierender Funktion zwischen der Anode und der emittierenden Schicht.

Unter Lochinjektionsschichten und Elektronenblockierschichten werden im Rahmen der vorliegenden Anmeldung bestimmte Ausführungsformen von Lochtransportschichten verstanden. Eine Lochinjektionsschicht ist im Falle einer Mehrzahl von Lochtransportschichten zwischen Anode und emittierender Schicht eine Lochtransportschicht, die direkt an die Anode angrenzt oder nur durch eine einzige Beschichtung der Anode von dieser getrennt ist. Eine Elektronenblockierschicht ist im Falle mehrerer Lochtransportschichten zwischen Anode und emittierender Schicht diejenige Lochtransportschicht, die anodenseitig direkt an die emittierende Schicht angrenzt. Vorzugsweise umfasst die erfindungsgemäße OLED zwischen Anode und emittierender Schicht zwei, drei oder vier löchertransportierende Schichten, von denen vorzugsweise mindestens eine, besonders bevorzugt genau eine oder zwei eine Verbindung der Formel (1) enthalten.

Wird die Verbindung der Formel (1) als Lochtransportmaterial in einer Lochtransportschicht, einer Lochinjektionsschicht oder einer Elektronenblockierschicht verwendet, so kann die Verbindung als reines Material, d.h. in einem Anteil von 100 %, in der Lochtransportschicht eingesetzt werden, oder sie kann in Kombination mit einer oder mehreren weiteren Verbindungen verwendet werden. In einer bevorzugten Ausführungsform enthält die organische Schicht, die die Verbindung der Formel (1) enthält, dann zusätzlich ein oder mehrere p-Dotiermittel. p-Dotiermittel, die gemäß der vorliegenden Erfindung verwendet werden, sind vorzugsweise solche organischen Elektronenakzeptorverbindungen, die in der Lage sind, eine oder mehrere der anderen Verbindungen in der Mischung zu oxidieren.

Besonders bevorzugte Ausführungsformen von p-Dotiermitteln sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709, US 2010/0096600, WO 2012/095143 und DE 102012209523 offenbarten Verbindungen.

Besonders bevorzugte p-Dotiermittel sind Chinodimethanverbindungen, Azaindenofluorendione, Azaphenylene, Azatriphenylene, I₂, Metallhalogenide, vorzugsweise Übergangsmetallhalogenide, Metalloxide, vorzugsweise Metalloxide, die mindestens ein Übergangsmetall oder ein Metall der 3. Hauptgruppe enthalten, und Übergangsmetallkomplexe, vorzugsweise Komplexe von Cu, Co, Ni, Pd und Pt mit Liganden, die mindestens ein Sauerstoffatom als Bindungsstelle enthalten. Bevorzugt werden ferner Übergangsmetalloxide als Dotiermittel, vorzugsweise Oxide von Rhenium, Molybdän und Wolfram, besonders bevorzugt Re₂O₇, MoOs, WO₃ und ReOs.

Die p-Dotiermittel liegen vorzugsweise in einer im Wesentlichen homogenen Verteilung in den p-dotierten Schichten vor. Dies kann z. B. durch Coevaporation des p-Dotiermittels und der Lochtransportmaterialmatrix erreicht werden.

Bevorzugte p-Dotiermittel sind insbesondere die folgenden Verbindungen:

| | | |
|---|---|---|
| 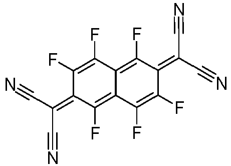 | 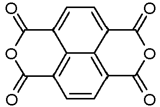 | 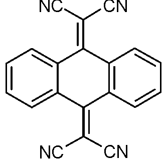 |
| (D-1) | (D-2) | (D-3) |
| 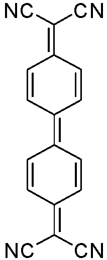 | 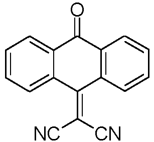 | 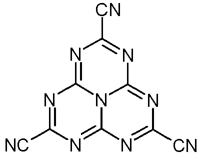 |
| (D-4) | (D-5) | (D-6) |
| 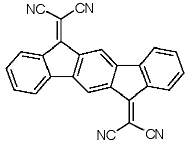 | 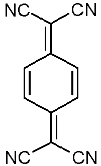 | 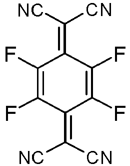 |
| (D-7) | (D-8) | (D-9) |
| 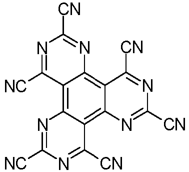 | 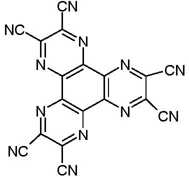 | 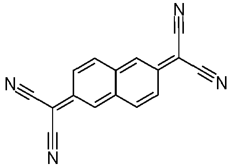 |
| (D-10) | (D-11) | (D-12) |
| 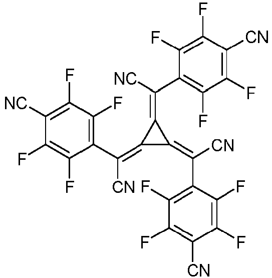 | | |
| (D-13) | | |

In einer weiteren bevorzugten Ausführungsform der Erfindung wird die Verbindung der Formel (1) als Lochtransportmaterial in Kombination mit einem Hexaazatriphenylenderivat, wie in US 2007/0092755 beschrieben, eingesetzt. Besonders bevorzugt wird hier das HexaazatriphenylenDerivat in einer separaten Schicht eingesetzt.

In einer weiteren Ausführungsform der vorliegenden Erfindung wird die Verbindung der Formel (1) in einer emittierenden Schicht als Matrixmaterial in Kombination mit einer oder mehreren emittierenden Verbindungen, vorzugsweise phosphoreszierenden Verbindungen, eingesetzt.

Der Anteil des Matrixmaterials in der emittierenden Schicht liegt in diesem Fall zwischen 50,0 und 99,9 Vol.-%, bevorzugt zwischen 80,0 und 99,5 Vol.-%, besonders bevorzugt zwischen 92,0 und 99,5 Vol-%. für fluoreszierende emittierende Schichten und zwischen 85,0 und 97,0 Vol.-% für phosphoreszierende emittierende Schichten.

Entsprechend liegt der Anteil der emittierenden Verbindung zwischen 0,1 und 50,0 Vol.-%, bevorzugt zwischen 0,5 und 20,0 Vol.-%, besonders bevorzugt zwischen 0,5 und 8,0 Vol.-% für fluoreszierende emittierende Schichten und zwischen 3,0 und 15,0 Vol.-%. für phosphoreszierende emittierende Schichten.

Eine emittierende Schicht einer organischen Elektrolumineszenzvorrichtung kann auch Systeme umfassen, die eine Vielzahl von Matrixmaterialien (Mischmatrixsysteme) und/oder eine Vielzahl von emittierenden Verbindungen enthalten. Auch in diesem Fall sind in der Regel die emittierenden Verbindungen diejenigen, die den kleineren Anteil im System haben und die Matrixmaterialien diejenigen, die den größeren Anteil im System haben. In Einzelfällen kann jedoch der Anteil eines einzelnen Matrixmaterials im System geringer sein als der Anteil einer einzelnen emittierenden Verbindung.

Vorzugsweise werden die Verbindungen der Formel (1) als Bestandteil von Mischmatrixsystemen eingesetzt. Die Mischmatrixsysteme bestehen vorzugsweise aus zwei oder drei verschiedenen Matrixmaterialien, besonders bevorzugt aus zwei verschiedenen Matrixmaterialien. Vorzugsweise ist in diesem Fall eines der beiden Materialien ein Material mit löchertransportierenden Eigenschaften und das andere Material ist ein Material mit elektronentransportierenden Eigenschaften. Die Verbindung der Formel (1) ist vorzugsweise das Matrixmaterial mit löchertransportierenden Eigenschaften. Die gewünschten elektronentransportierenden und löchertransportierenden Eigenschaften der gemischten Matrixkomponenten können jedoch auch überwiegend oder vollständig in einer einzigen gemischten Matrixkomponente kombiniert sein, wobei die weitere(n) gemischte(n) Matrixkomponente(n) andere Funktionen erfüllt (erfüllen). Die beiden unterschiedlichen Matrixmaterialien können in einem Verhältnis von 1:50 bis 1:1, bevorzugt 1:20 bis 1:1, noch bevorzugter 1:10 bis 1:1 und am meisten bevorzugt 1:4 bis 1:1 vorliegen. Bevorzugt werden Mischmatrixsysteme in phosphoreszierenden organischen Elektrolumineszenzvorrichtungen eingesetzt. Eine Quelle für detailliertere Informationen über Mischmatrixsysteme ist die Anmeldung WO 2010/108579.

Die Mischmatrixsysteme können eine oder mehrere emittierende Verbindungen enthalten, vorzugsweise eine oder mehrere phosphoreszierende Verbindungen. Im Allgemeinen werden Mischmatrixsysteme bevorzugt in phosphoreszierenden organischen Elektrolumineszenzvorrichtungen eingesetzt.

Besonders geeignete Matrixmaterialien, die in Kombination mit den erfindungsgemäßen Verbindungen als Matrixbestandteile eines Mischmatrixsystems verwendet werden können, werden aus den unten genannten bevorzugten Matrixmaterialien für phosphoreszierende Verbindungen oder den bevorzugten Matrixmaterialien für fluoreszierende Verbindungen ausgewählt, je nachdem, welche Art von emittierender Verbindung in dem Mischmatrixsystem verwendet wird.

Bevorzugte phosphoreszierende Verbindungen zur Verwendung in gemischten Matrixsystemen sind die gleichen, wie weiter oben als allgemein bevorzugte phosphoreszierende Emittermaterialien beschrieben.

Bevorzugte Ausführungsformen der verschiedenen Funktionsmaterialien in der elektronischen Vorrichtung sind im Folgenden aufgeführt.

Beispiele für phosphoreszierende Verbindungen sind nachfolgend aufgeführt.

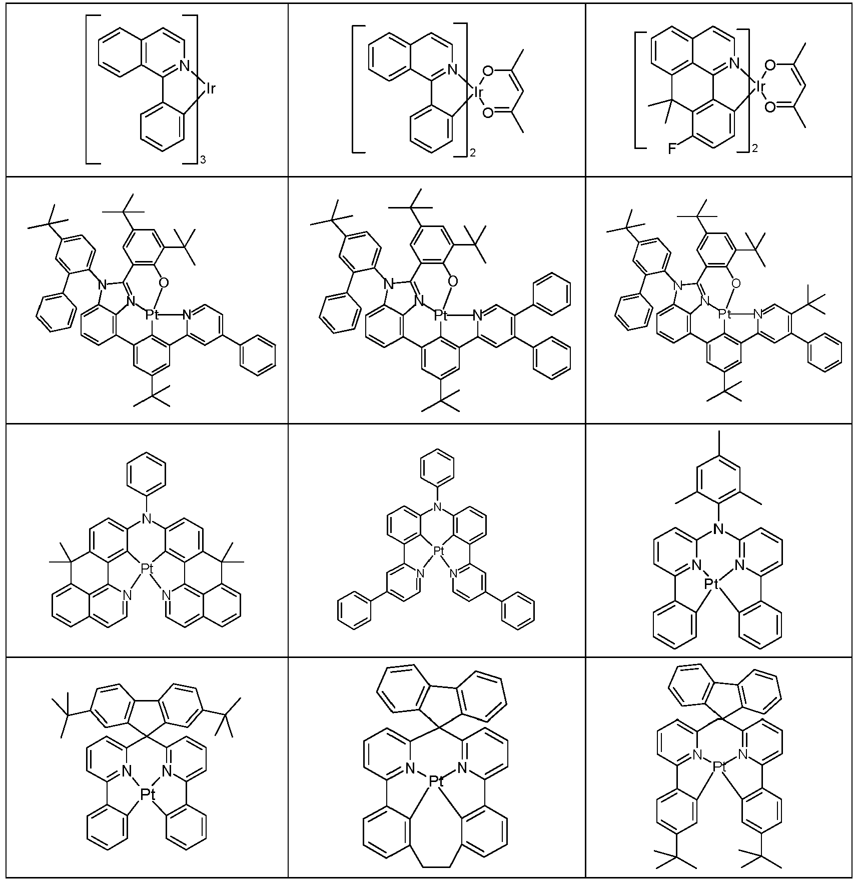

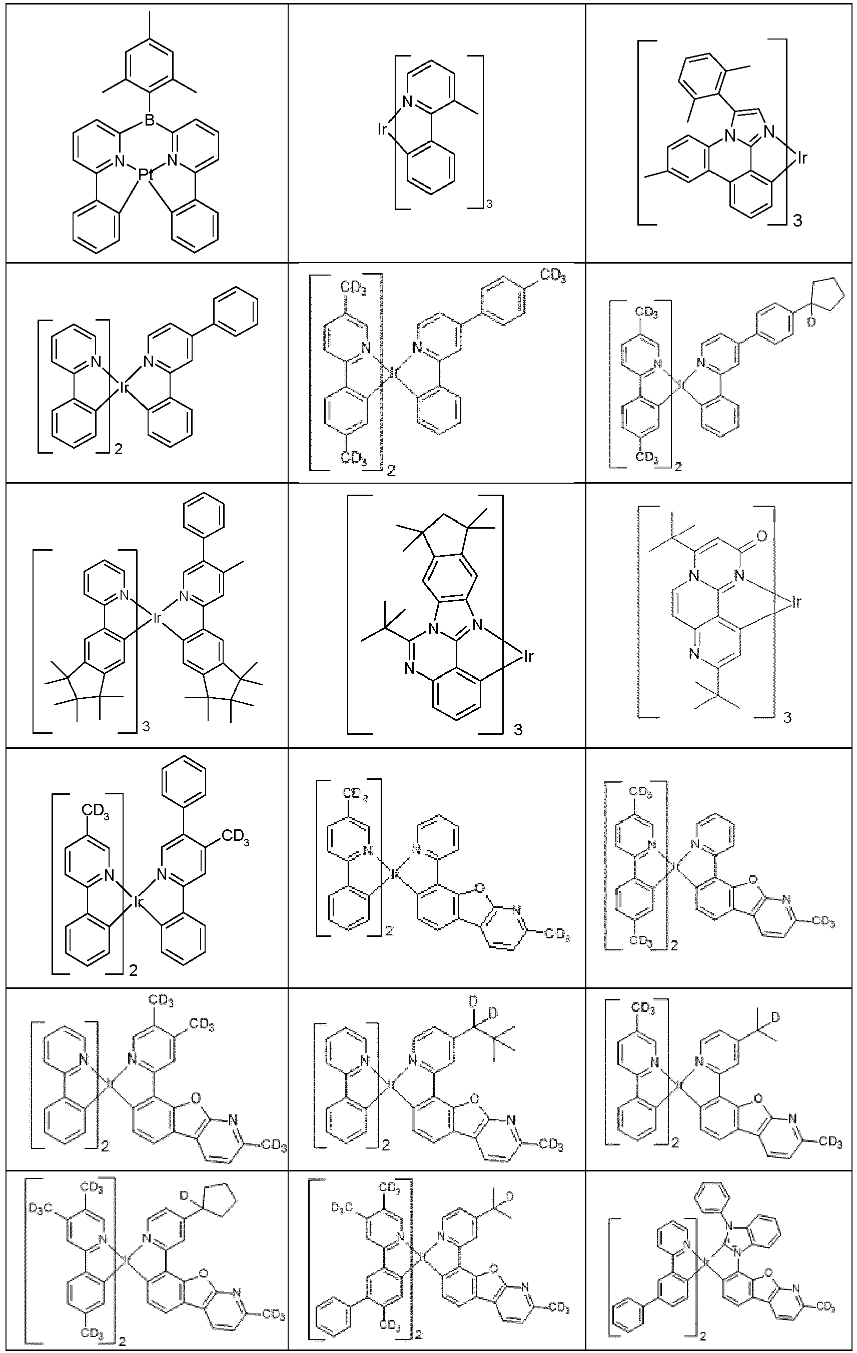

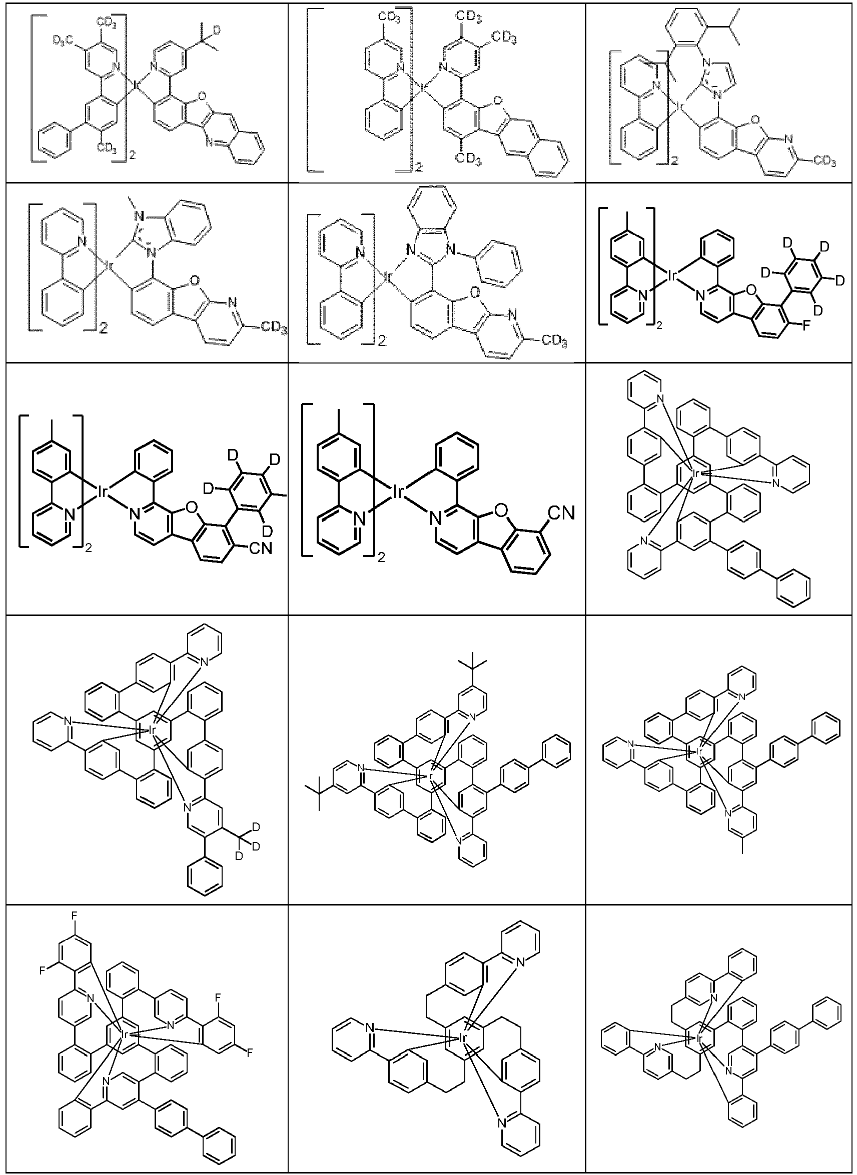

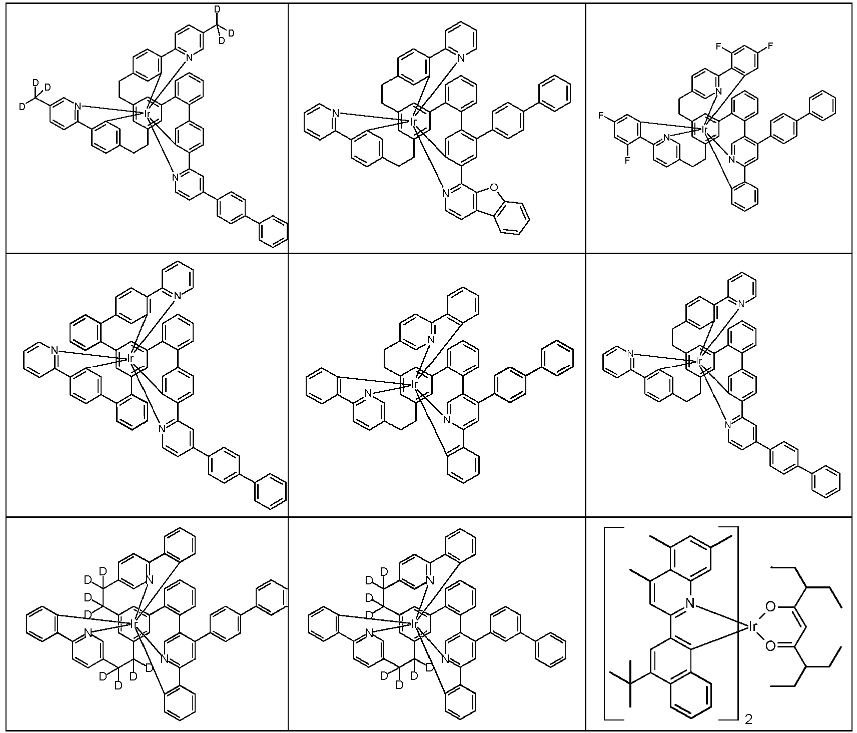

Bevorzugte fluoreszierende emittierende Verbindungen sind ausgewählt aus der Klasse der Arylamine. Unter einem Arylamin oder einem aromatischen Amin wird im Rahmen der vorliegenden Erfindung eine Verbindung verstanden, die drei substituierte oder unsubstituierte aromatische oder heteroaromatische Ringsysteme enthält, die direkt an den Stickstoff gebunden sind. Vorzugsweise ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrenediamine, aromatische Chrysenamine oder aromatische Chrysendiamine. Unter einem aromatischen Anthracenamin versteht man eine Verbindung, bei der eine Diarylaminogruppe direkt an eine Anthracengruppe, vorzugsweise in Position 9, gebunden ist. Unter einem aromatischen Anthracendiamin ist eine Verbindung zu verstehen, in der zwei Diarylaminogruppen direkt an eine Anthracengruppe gebunden sind, vorzugsweise in den Positionen 9, 10. Analog sind aromatische Pyrenamine, Pyrendiamine, Chrysenamine und Chrysendiamine definiert, bei denen die Diarylaminogruppen vorzugsweise in 1-Position oder 1,6-Position an das Pyren gebunden sind. Weitere bevorzugte emittierende Verbindungen sind Indenofluorenamine oder Fluorendiamine, beispielsweise nach WO 2006/108497 oder WO 2006/122630, Benzoindenofluorenamine oder -fluorendiamine, beispielsweise nach WO 2008/006449, und Dibenzoindenofluorenamine oder -diamine, beispielsweise nach WO 2007/140847, sowie die in WO 2010/012328 offenbarten Indenofluorenderivate mit kondensierten Arylgruppen. Ebenso bevorzugt sind die in WO 2012/048780 und in WO 2013/185871 offenbarten Pyrenearylamine. Ebenfalls bevorzugt sind die in WO 2014/037077 offenbarten Benzoindenofluorenamine, die in WO 2014/106522 offenbarten Benzofluorenamine, die in WO 2014/111269 und in WO 2017/036574 offenbarten verlängerten Benzoindenofluorene, die in WO 2017/028940 und in WO 2017/028941 offenbarten Phenoxazine und die in WO 2016/150544 offenbarten an Furaneinheiten oder an Thiopheneinheiten gebundenen Fluorderivate. Weiterhin können BorVerbindung gemäß WO2020208051, WO2015102118, WO2016152418 , WO2018095397, WO2019004248 , WO2019132040, US20200161552, WO2021089450 Verwendung finden.

Nützliche Matrixmaterialien, vorzugsweise für fluoreszierende Verbindungen, umfassen Materialien verschiedener Substanzklassen. Bevorzugte Matrixmaterialien sind ausgewählt aus den Klassen der Oliaoarvle (z.B. 2,2',7,7'-Tetraphenylspirobifluoren nach EP 676461 oder Dinaphthylanthracen), insbesondere der Oligoaryle mit anellierten aromatischen Gruppen, der Oligoarylenvinylene (z.B. DPVBi oder Spiro-DPVBi gemäß EP 676461), der polypodalen Metallkomplexe (z.B. gemäß WO 2004/081017), der lochleitenden Verbindungen (z.B. gemäß WO 2004/058911), der elektronenleitenden Verbindungen, insbesondere Ketone, Phosphinoxide, Sulfoxide etc. (zum Beispiel nach WO 2005/084081 und WO 2005/084082), die Atropisomere (zum Beispiel nach WO 2006/048268), die Boronsäurederivate (zum Beispiel nach WO 2006/117052) oder die Benzanthracene (zum Beispiel nach WO 2008/145239). Besonders bevorzugte Matrixmaterialien sind ausgewählt aus den Klassen der Oligoarylene mit Naphthalin, Anthracen, Benzanthracen und/oder Pyren oder Atropisomeren dieser Verbindungen, den Oligoarylenvinylenen, den Ketonen, den Phosphinoxiden und den Sulfoxiden. Ganz besonders bevorzugte Matrixmaterialien sind ausgewählt aus den Klassen der Oligoarylene, die Anthracen, Benzanthracen, Benzophenanthren und/oder Pyren oder Atropisomere dieser Verbindungen umfassen. Unter einem Oligoarylen ist im Rahmen der vorliegenden Erfindung eine Verbindung zu verstehen, in der mindestens drei Aryl- oder Arylengruppen miteinander verbunden sind. Weiter bevorzugt sind die in WO 2006/097208, WO 2006/131192, WO 2007/065550, WO 2007/110129, WO 2007/065678, WO 2008/145239, WO 2009/100925, WO 2011/054442 und EP 1553154 offenbarten Anthracenderivate, die in EP 1749809, EP 1905754 und US 2012/0187826 offenbarten Pyrenverbindungen, die in WO 2015/158409 offenbarten Benzanthracenylanthracenverbindungen, die in WO 2017/025165 offenbarten Indenobenzofurane und die in WO 2017/036573 offenbarten Phenanthrylanthracene.

Bevorzugte Matrixmaterialien für phosphoreszierende Verbindungen sind, ebenso wie Verbindungen gemäß Formel (1), aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl) oder WO 2005/039246, US 2005/0069729, JP 2004/288381, EP 1205527, WO 2008/086851 oder WO 2013/041176, Indolocarbazolderivate, z. B. gemäß WO 2007/063754 oder WO 2008/056746, Indenocarbazolderivate, z. B. gemäß WO 2010/136109, WO 2011/000455, WO 2013/041176 oder WO 2013/056776, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2007/063754, WO 2008/056746, WO 2010/015306, WO 2011/057706, WO 2011/060859 oder WO 2011/060877, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, verbrückte Carbazol-Derivate, z. B. gemäß WO 2011/042107, WO 2011/060867, WO 2011/088877 und WO 2012/143080, Triphenylenderivate, z. B. gemäß WO 2012/048781, Lactame, z. B. gemäß WO 2011/116865 oder WO 2011/137951, oder Dibenzofuranderivate, z. B. gemäß WO 2015/169412, WO 2016/015810, WO 2016/023608, WO 2017/148564 oder WO 2017/148565. Ebenso kann ein weiterer phosphoreszierender Emitter, welcher kürzerwellig als der eigentliche Emitter emittiert, als Co-Host in der Mischung vorhanden sein oder eine Verbindung, die nicht oder nicht in wesentlichem Umfang am Ladungstransport teilnimmt, wie beispielsweise in WO 2010/108579 beschrieben.

Geeignete Ladungstransportmaterialien, wie sie in der Lochinjektions- oder Lochtransportschicht oder in der Elektronensperrschicht oder in der Elektronentransportschicht des erfindungsgemäßen elektronischen Bauelements verwendet werden können, sind neben den Verbindungen der Formel (1) zum Beispiel die in Y. Shirota et al., Chem. Rev. 2007, 107(4), 953-1010, oder andere Materialien, wie sie in diesen Schichten gemäß dem Stand der Technik verwendet werden.

Vorzugsweise umfasst die erfindungsgemäße OLED zwei oder mehr verschiedene löchertransportierende Schichten. Die Verbindung der Formel (1) kann dabei in einer oder mehreren oder in allen löchertransportierenden Schichten verwendet werden. In einer bevorzugten Ausführungsform wird die Verbindung der Formel (1) in genau einer oder genau zwei löchertransportierenden Schichten eingesetzt, und in den weiteren vorhandenen löchertransportierenden Schichten werden andere Verbindungen, vorzugsweise aromatische Aminverbindungen, eingesetzt. Weitere Verbindungen, die neben den Verbindungen der Formel (1) vorzugsweise in löchertransportierenden Schichten der erfindungsgemäßen OLEDs eingesetzt werden, sind insbesondere Indenofluorenamin-Derivate (z.B. nach WO 06/122630 oder WO 06/100896), die in EP 1661888 offenbarten Aminderivate, Hexaazatriphenylen-Derivate (z.B. nach WO 01/049806), Aminderivate mit anellierten Aromaten (zum Beispiel nach US 5,061,569), die in WO 95/09147 offenbarten Aminderivate, Monobenzoindenofluorenamine (zum Beispiel nach WO 08/006449), Dibenzoindenofluorenamine (zum Beispiel nach WO 07/140847), Spirobifluorenamine (zum Beispiel nach WO 2012/034627 oder WO 2013/120577), Fluorenamine (zum Beispiel nach WO 2014/015937, WO 2014/015938, WO 2014/015935 und WO 2015/082056), Spirodibenzopyranamine (zum Beispiel gemäß WO 2013/083216), Dihydroacridin-Derivate (zum Beispiel gemäß WO 2012/150001), Spirodibenzofurane und Spirodibenzothiophene (zum Beispiel nach WO 2015/022051, WO 2016/102048 und WO 2016/131521), Phenanthrendiarylamine (zum Beispiel nach WO 2015/131976), Spirotribenzotropolone (zum Beispiel gemäß WO 2016/087017), Spirobifluorene mit meta-Phenyldiamingruppen (zum Beispiel gemäß WO 2016/078738), Spirobisacridine (zum Beispiel gemäß WO 2015/158411), Xanthendiarylamine (zum Beispiel gemäß WO 2014/072017), und 9,10-Dihydroanthracen-Spiroverbindungen mit Diarylaminogruppen gemäß WO 2015/086108.

Ganz besonders bevorzugt ist die Verwendung von durch Diarylaminogruppen in 4-Position substituierten Spirobifluorenen als löchertransportierende Verbindungen, insbesondere die Verwendung derjenigen Verbindungen, die in WO 2013/120577 beansprucht und offenbart sind, und die Verwendung von durch Diarylaminogruppen in 2-Position substituierten Spirobifluorenen als löchertransportierende Verbindungen, insbesondere die Verwendung derjenigen Verbindungen, die in WO 2012/034627 beansprucht und offenbart sind.

Als Materialien für die Elektronentransportschicht können alle Materialien verwendet werden, die nach dem Stand der Technik als Elektronentransportmaterialien in der Elektronentransportschicht eingesetzt werden. Besonders geeignet sind Aluminiumkomplexe, z.B. Alq3, Zirkoniumkomplexe, z.B. Zrq4, Lithiumkomplexe, z.B. Liq, Benzimidazol-Derivate, Triazin-Derivate, Pyrimidin-Derivate, PyridinDerivate, Pyrazin-Derivate, Chinoxalin-Derivate, Chinolin-Derivate, Oxadiazol-Derivate, aromatische Ketone, Lactame, Borane, Diazaphosphol-Derivate und Phosphinoxid-Derivate. Weitere geeignete Materialien sind Derivate der vorgenannten Verbindungen, wie sie in JP 2000/053957, WO 2003/060956, WO 2004/028217, WO 2004/080975 und WO 2010/072300 offenbart sind.

Bevorzugte Kathoden des elektronischen Bauelements sind Metalle mit geringer Austrittsarbeit, Metalllegierungen oder Mehrschichtstrukturen aus verschiedenen Metallen, z. B. Erdalkalimetallen, Alkalimetallen, Hauptgruppenmetallen oder Lanthanoiden (z. B. Ca, Ba, Mg, Al, In, Mg, Yb, Sm, etc.). Zusätzlich geeignet sind Legierungen aus einem Alkali- oder Erdalkalimetall und Silber, z. B. eine Legierung aus Magnesium und Silber. Bei Mehrschichtstrukturen können neben den genannten Metallen auch weitere Metalle mit einer relativ hohen Austrittsarbeit verwendet werden, z. B. Ag oder Al, wobei in der Regel Kombinationen der Metalle wie z. B. Ca/Ag, Mg/Ag oder Ba/Ag eingesetzt werden. Es kann auch vorteilhaft sein, eine dünne Zwischenschicht aus einem Material mit einer hohen Dielektrizitätskonstante zwischen einer metallischen Kathode und dem organischen Halbleiter einzuführen. Beispiele für geeignete Materialien sind Alkali- oder Erdalkalimetallfluoride, aber auch die entsprechenden Oxide oder Carbonate (z. B. LiF, Li₂O, BaF₂, MgO, NaF, CsF, Cs₂CO₃ usw.). Es ist auch möglich, Lithiumchinolinat (LiQ) zu diesem Zweck zu verwenden. Die Schichtdicke dieser Schicht liegt vorzugsweise zwischen 0,5 und 5 nm.

Bevorzugte Anoden sind Materialien mit einer hohen Austrittsarbeit. Vorzugsweise hat die Anode eine Austrittsarbeit von mehr als 4,5 eV gegen Vakuum. Dazu eignen sich erstens Metalle mit hohem Redoxpotential, z. B. Ag, Pt oder Au. Zum anderen können auch Metall/Metalloxid-Elektroden (z. B. Al/Ni/NiOx, Al/PtOx) bevorzugt werden. Für einige Anwendungen muss mindestens eine der Elektroden transparent oder teiltransparent sein, um die Bestrahlung des organischen Materials (organische Solarzelle) oder die Emission von Licht (OLED, O-Laser) zu ermöglichen. Bevorzugte Anodenmaterialien sind hier leitfähige Metallmischoxide. Besonders bevorzugt werden Indiumzinnoxid (ITO) oder Indiumzinkoxid (IZO). Weiter bevorzugt werden leitfähig dotierte organische Materialien, insbesondere leitfähig dotierte Polymere. Darüber hinaus kann die Anode auch aus zwei oder mehr Schichten bestehen, zum Beispiel aus einer inneren Schicht aus ITO und einer äußeren Schicht aus einem Metalloxid, vorzugsweise Wolframoxid, Molybdänoxid oder Vanadiumoxid.

Die Vorrichtung wird entsprechend (je nach Anwendung) strukturiert, kontaktiert und abschließend versiegelt, um schädliche Einflüsse durch Wasser und Luft auszuschließen.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen gemäß Formel (1) bzw. den oben ausgeführten bevorzugten Ausführungsformen einsetzen.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Erfindungsgemäß können die elektronischen Vorrichtungen, die eine oder mehrere Verbindungen der Formel (1) enthalten, in Displays, als Lichtquellen in Beleuchtungsanwendungen und als Lichtquellen in medizinischen und/oder kosmetischen Anwendungen (z.B. Lichttherapie) eingesetzt werden.

Die erfindungsgemäßen Verbindungen und die erfindungsgemäßen organischen Elektrolumineszenzvorrichtungen zeichnen sich durch einen oder mehrere der folgenden Eigenschaften aus:
1. Die erfindungsgemäßen Verbindungen führen zu langen Lebensdauern.
2. Die erfindungsgemäßen Verbindungen führen zu hohen Effizienzen, insbesondere zu einer hohen EQE.
3. Die erfindungsgemäßen Verbindungen führen zu geringen Betriebsspannungen.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße Verbindungen herstellen und diese in elektronischen Vorrichtungen verwenden bzw. das erfindungsgemäße Verfahren anwenden.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbinden die mehrere enantiomere, diastereomere oder tautomere Formen aufweisen können wird eine Form stellvertretend gezeigt.

### Literaturbekannte Synthone LS:

| | | | |
|---|---|---|---|
| LS1 | 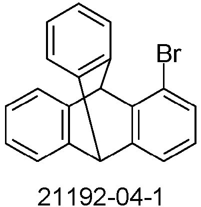 | LS2 | 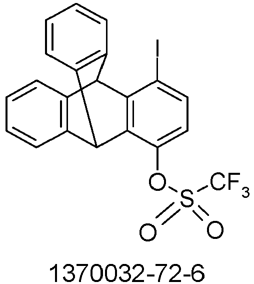 |
| LS3 | 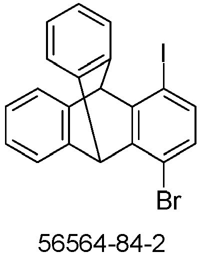 | | |

### A) Synthese von Synthonen S:

### Beispiel S1:

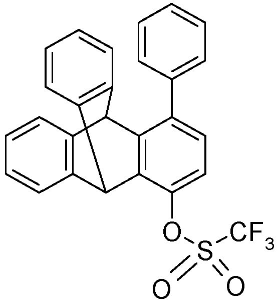

Ein gut gerührtes Gemisch aus 52.8 g (100 mmol) LS2, 12.8 g (105 mmol) Phenylboronsäure [98-80-6], 48.9 g (150 mmol) Casiumcarbonat, wasserfrei, 1.43 g (2 mmol) Bis(triphenyphosphino)palladiumdichlorid, 100 g Glaskugeln (3 mm Durchmesser) und 400 ml THF wird 24 h bei 60 °C gerührt. Nach vollständigem Umsatz saugt man noch heiß über ein mit THF vorgeschlämmtes Celite-Bett ab, engt das Filtrat zur Trockene ein, nimmt den Rückstand in 500 ml Dichlormethan (DCM) auf, wäscht zweimal mit je 200 ml Wasser, einmal mit 100 ml ges. Kochsalzlösung und trocknet über Natriumsulfat. Man filtriert vom Trockenmittel über ein mit DCM vorgeschlämmtes Kieselgel-Bett ab, engt das Filtrat langsam ein, ersetzt das DCM sukzessive mit ca. 200 ml Methanol, saugt das auskristallisierte Produkt ab, wäscht mit wenig Methanol nach und trocknet im Vakuum. Ausbeute: 44.5 g (93 mmol) 93 %; Reinheit: ca. 97 % ig n. ¹H-NMR.

Analog können folgende Verbindungen dargestellt werden:

| Bsp. | Edukte | Produkt | Ausbeute |
|---|---|---|---|
| S2 | 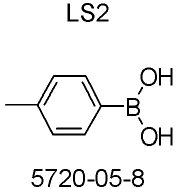 | 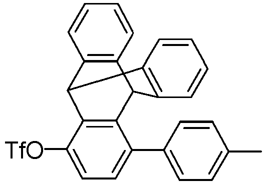 | 95 % |
| S3 | 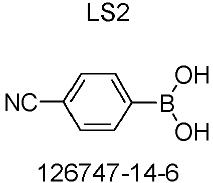 | 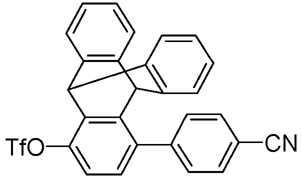 | 90 % |
| S4 | 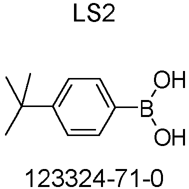 | 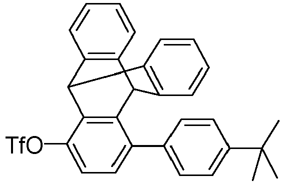 | 91 % |
| S5 | 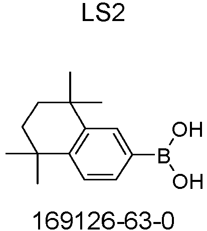 | 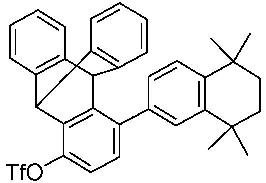 | 94 % |
| S6 | 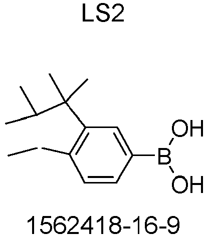 | 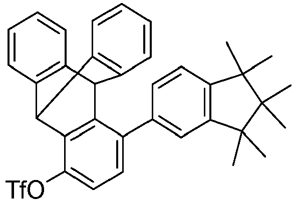 | 93 % |
| S7 | 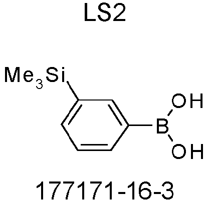 | 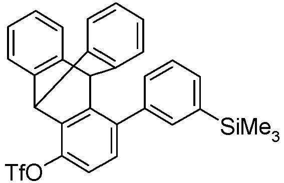 | 65 % |
| S8 | 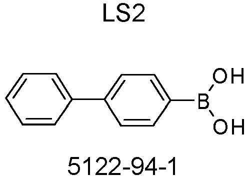 | 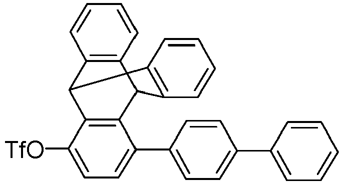 | 94 % |
| S9 | 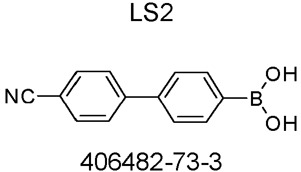 | 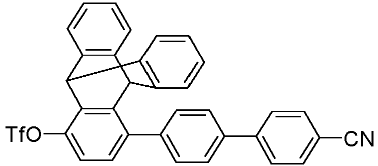 | 88 % |
| S10 | 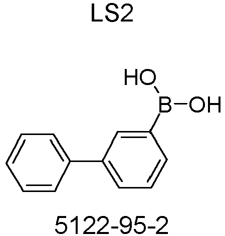 | 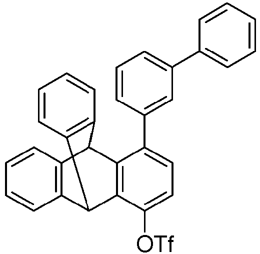 | 85% |
| S11 | 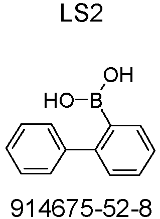 | 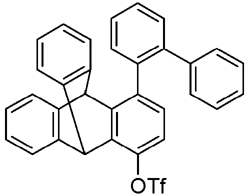 | 93 % |
| S12 | 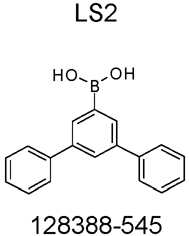 | 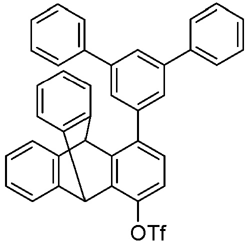 | 90% |
| S13 | 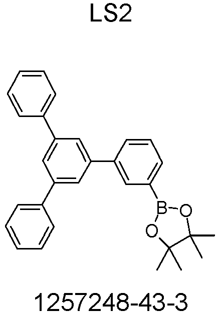 | 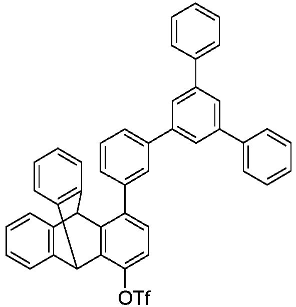 | 87 % |
| S14 | 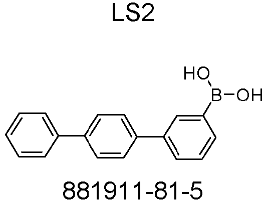 | 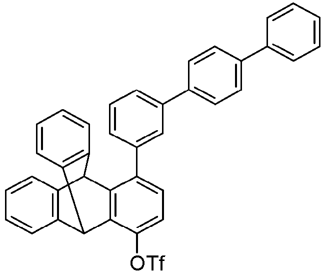 | 90 % |
| S15 | 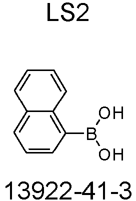 | 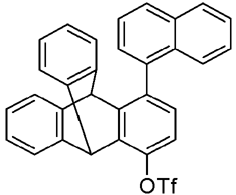 | 92 % |
| S16 | 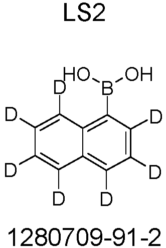 | 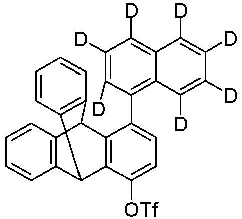 | 93 % |
| S17 | 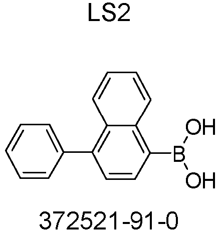 | 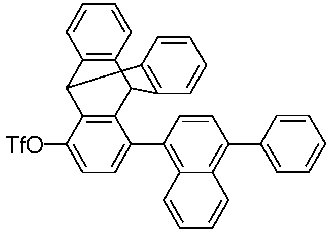 | 95 % |
| S18 | 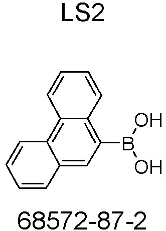 | 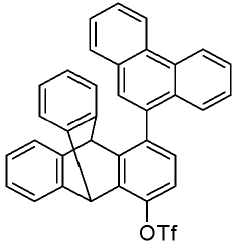 | 91 % |
| S19 | 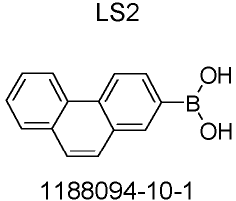 | 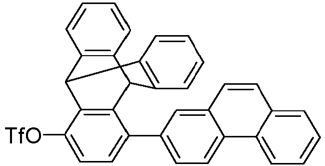 | 93 % |
| S20 | 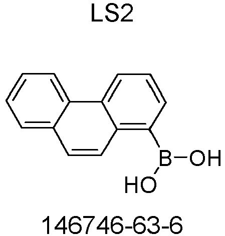 | 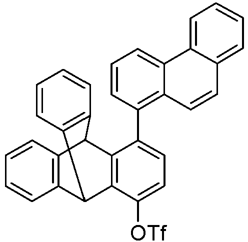 | 94 % |
| S21 | 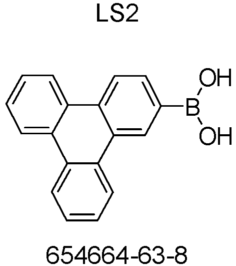 | 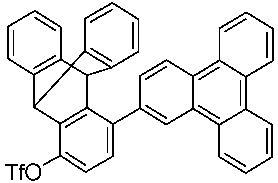 | 96 % |
| S22 | 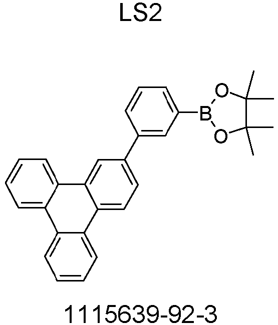 | 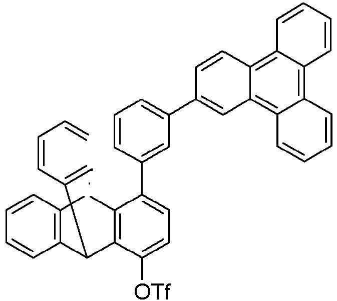 | 89 % |
| S23 | 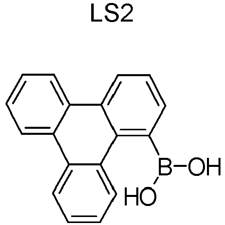 | 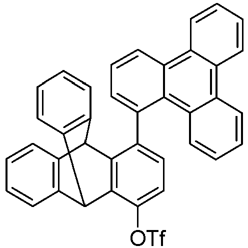 | 68 % |
| | 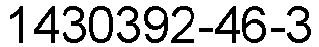 | | |
| S24 | 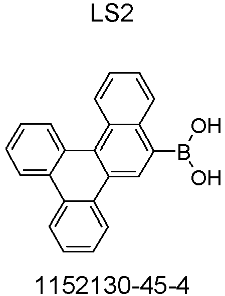 | 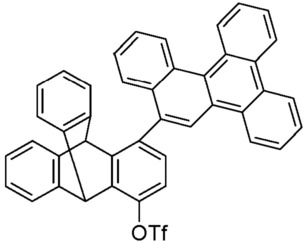 | 88 % |
| S25 | 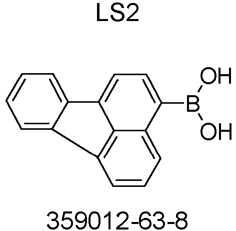 | 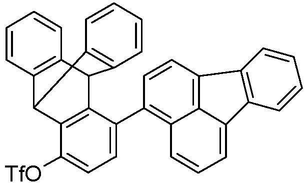 | 90 % |
| S26 | 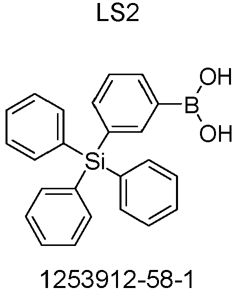 | 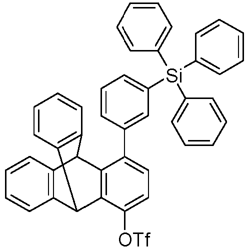 | 73 % |
| S27 | 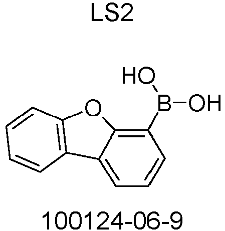 | 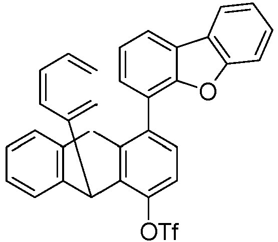 | 90 % |
| S28 | 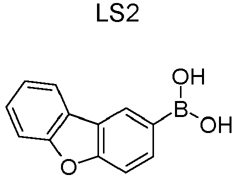 | 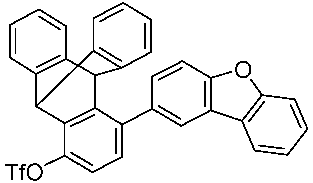 | |
| | 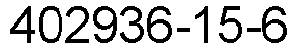 | | |
| S29 | 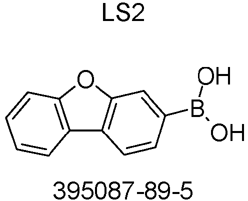 | 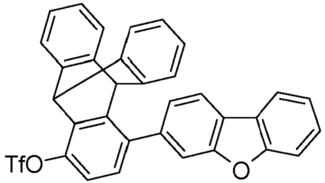 | 86 % |
| S30 | 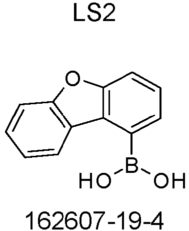 | 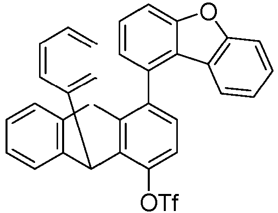 | 80 % |
| S31 | 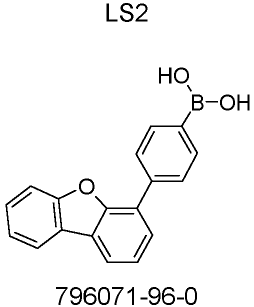 | 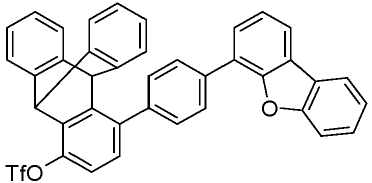 | 87 % |
| S32 | 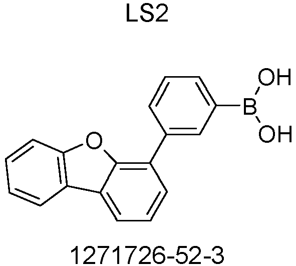 | 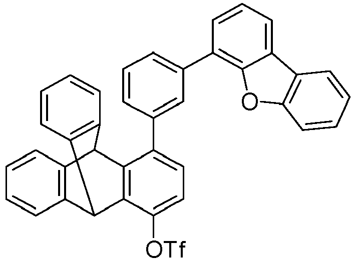 | 85% |
| S33 | 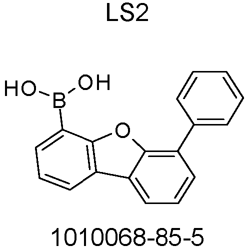 | 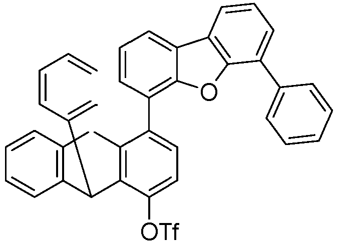 | 80 % |
| S34 | 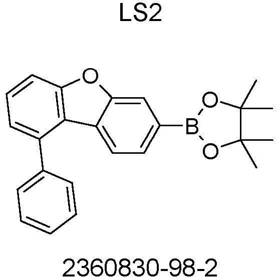 | 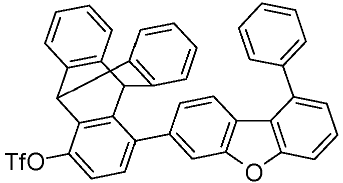 | 90 % |
| S35 | 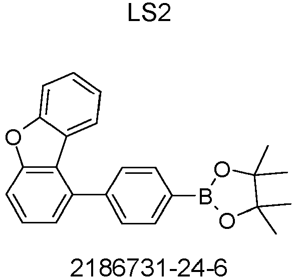 | 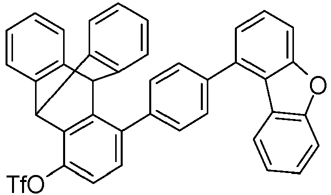 | 91% |
| S36 | 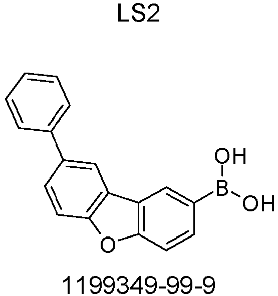 | 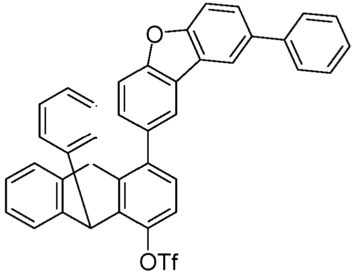 | 89 % |
| S37 | 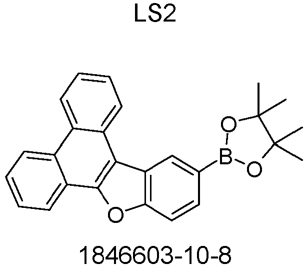 | 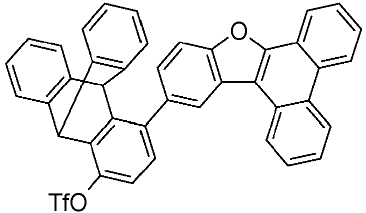 | 92 % |
| S38 | 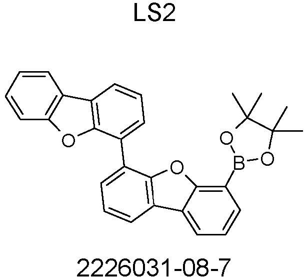 | 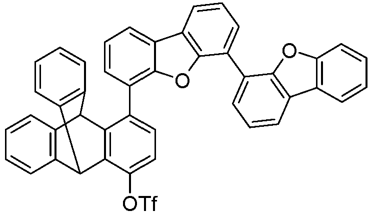 | 88 % |
| S39 | 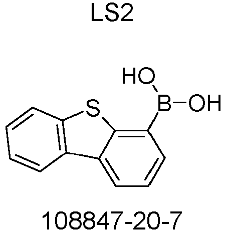 | 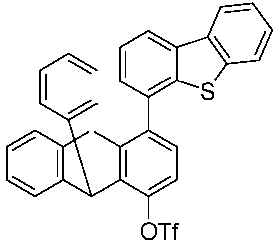 | 85 % |
| S40 | 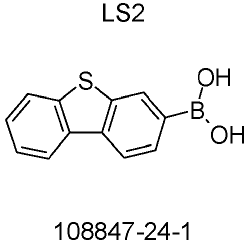 | 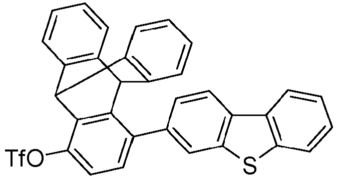 | 86 % |
| S41 | 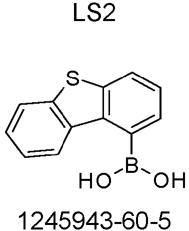 | 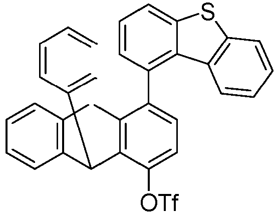 | 70 % |
| S42 | 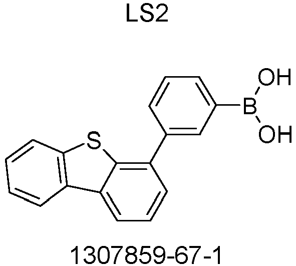 | 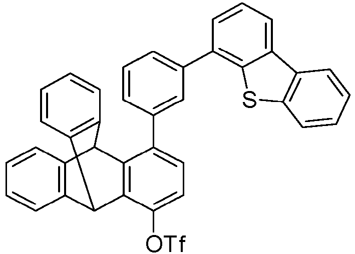 | 86 % |
| S43 | 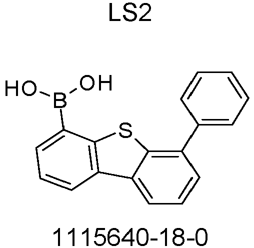 | 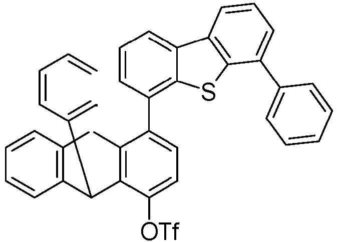 | 88 % |
| S44 | 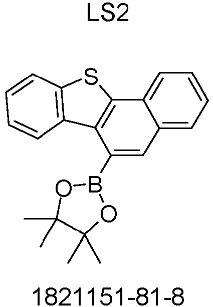 | 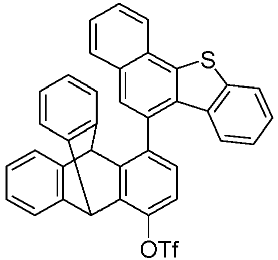 | 75 % |
| S45 | 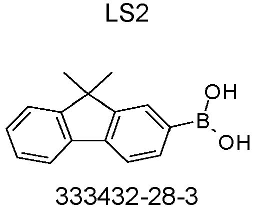 | 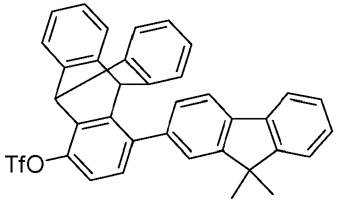 | 92 % |
| S46 | 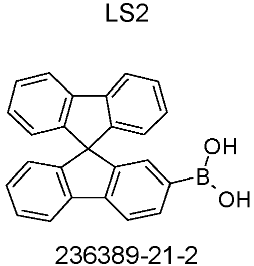 | 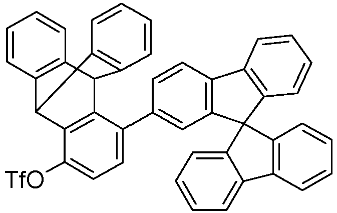 | 90 % |
| S47 | 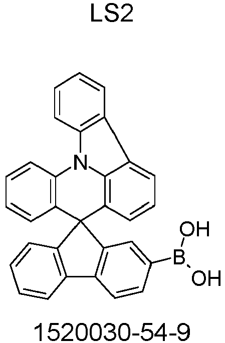 | 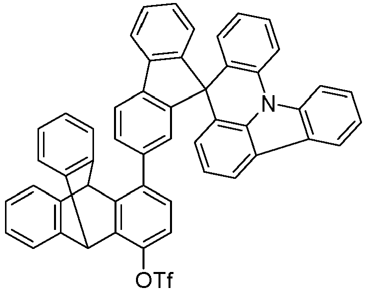 | 90 % |
| S48 | 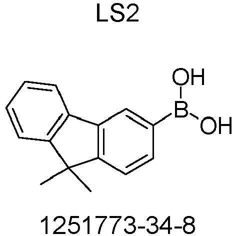 | 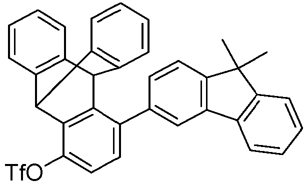 | 91 % |
| S49 | 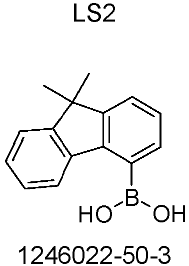 | 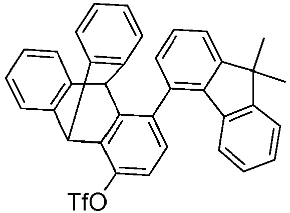 | 82 % |
| S50 | 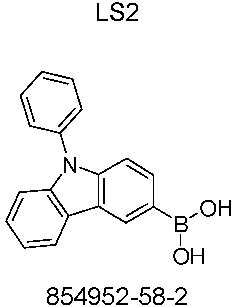 | 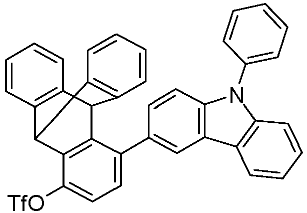 | 87 % |
| S51 | 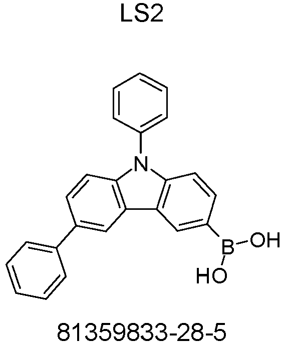 | 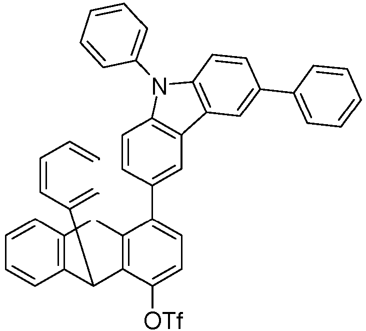 | 85% |
| S52 | 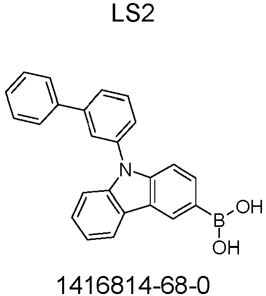 | 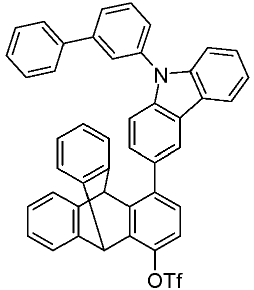 | 87 % |
| S53 | 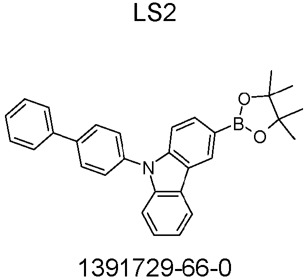 | 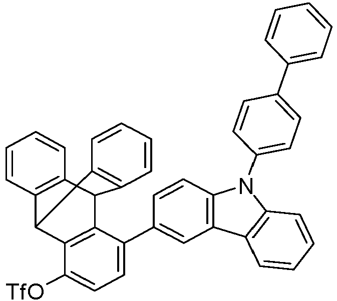 | 88 % |
| S54 | 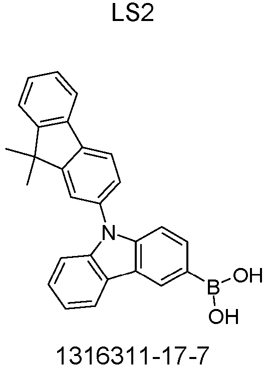 | 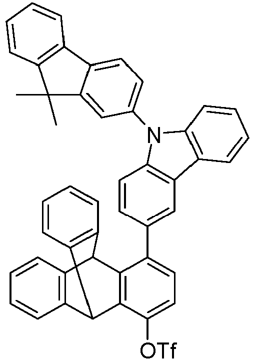 | 85% |
| S55 | 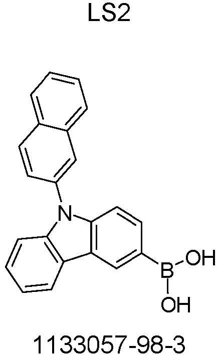 | 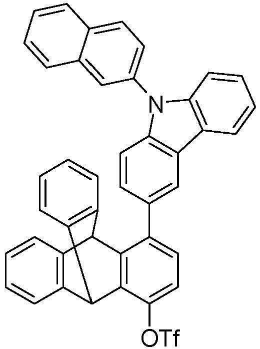 | 84 % |
| S56 | 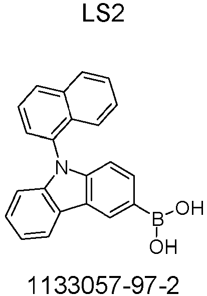 | 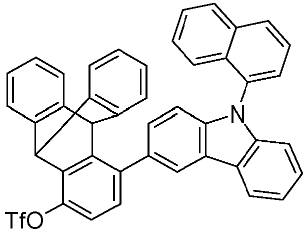 | 87 % |
| S57 | 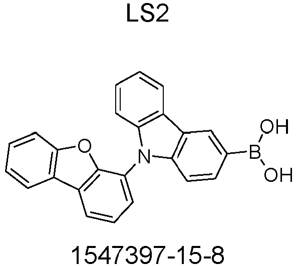 | 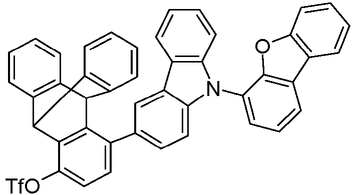 | 85% |
| S58 | 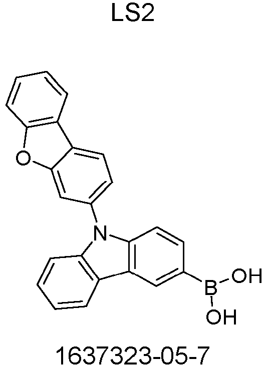 | 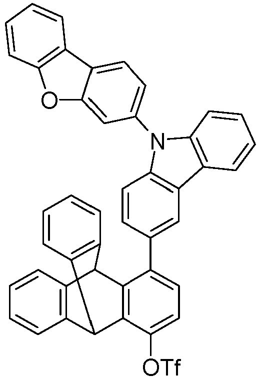 | 83 % |
| S59 | 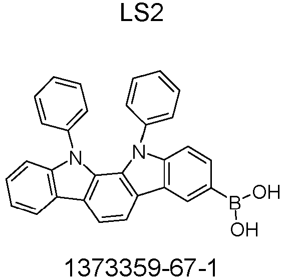 | 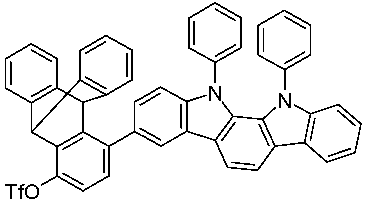 | 87 % |
| S60 | 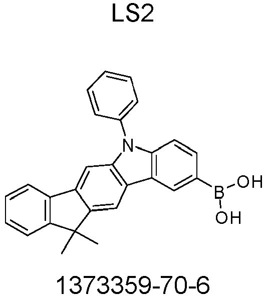 | 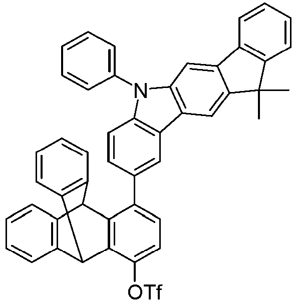 | 90 % |
| S61 | 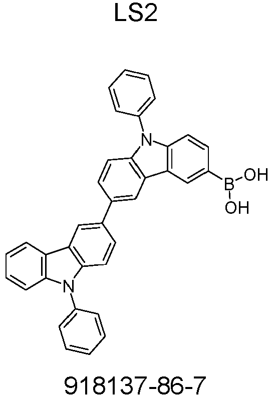 | 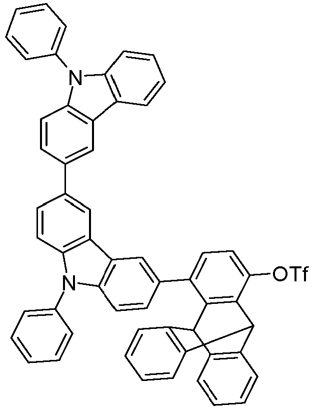 | 86 % |
| S62 | 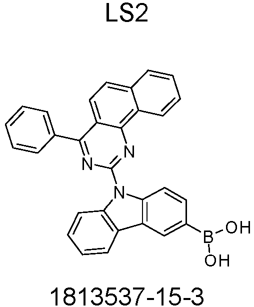 | 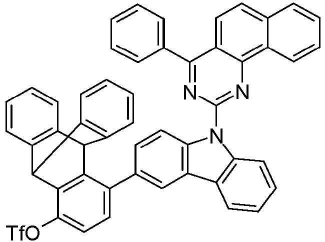 | 74 % |
| S63 | 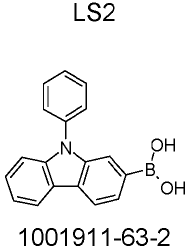 | 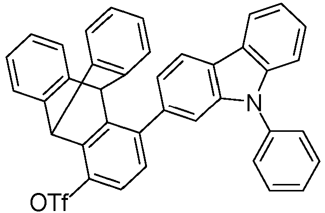 | 89 % |
| S64 | 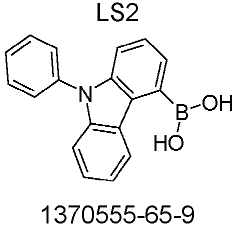 | 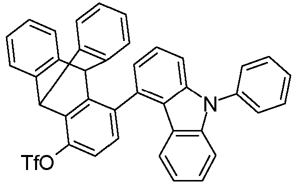 | 77 % |
| S65 | 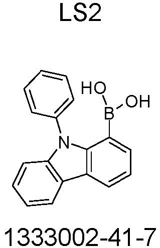 | 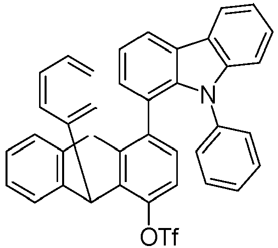 | 61 % |
| S66 | 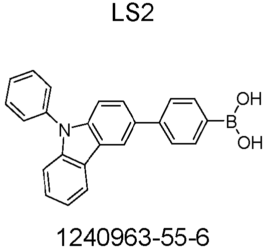 | 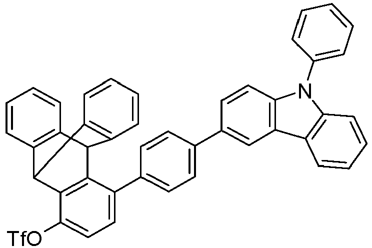 | 89 % |
| S67 | 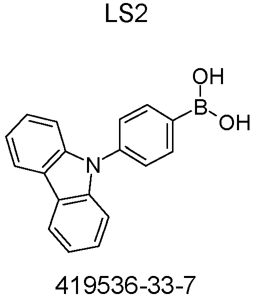 | 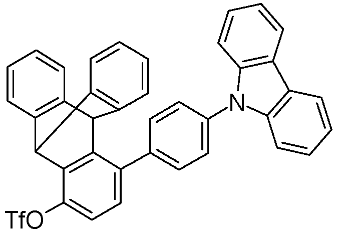 | 90 % |
| S68 | 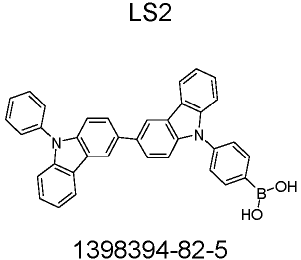 | 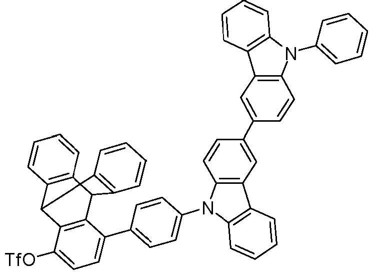 | 91 % |
| S69 | 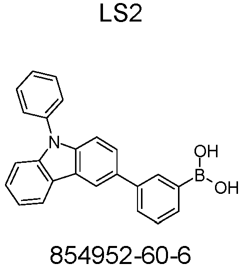 | 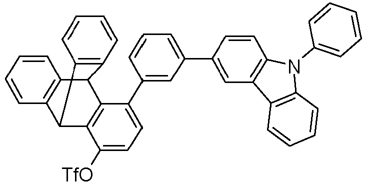 | 86 % |
| S70 | 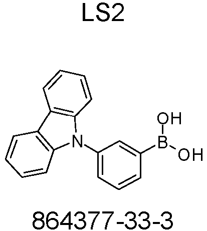 | 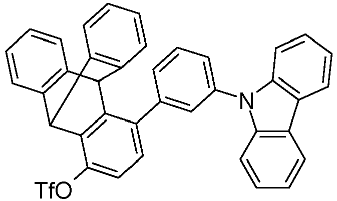 | 85 % |
| S71 | 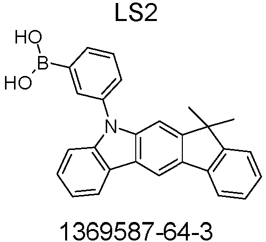 | 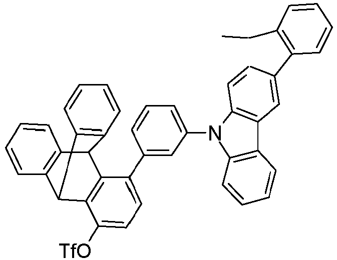 | 80 % |
| S72 | 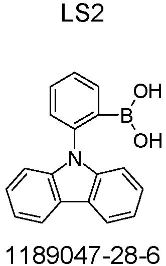 | 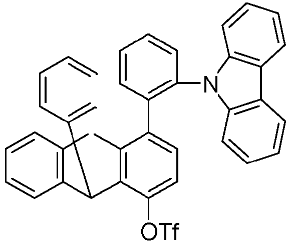 | 67 % |
| S73 | 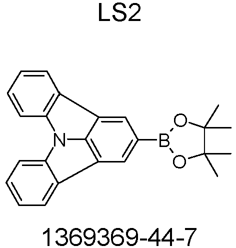 | 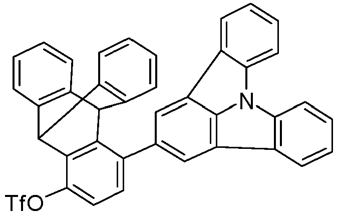 | 80 % |
| S74 | 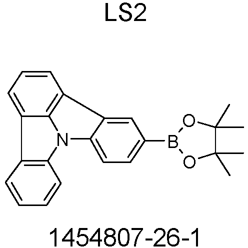 | 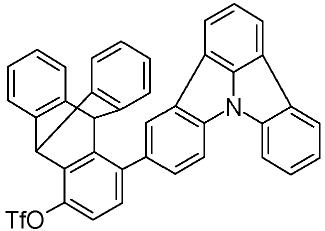 | 83 % |
| S75 | 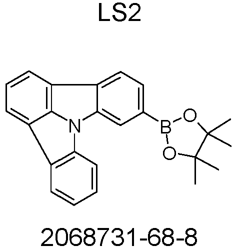 | 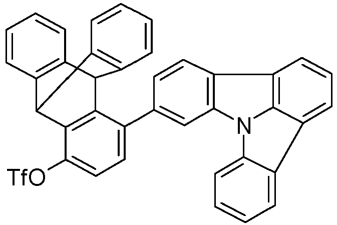 | 87 % |
| S76 | 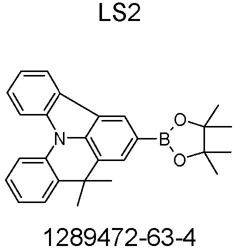 | 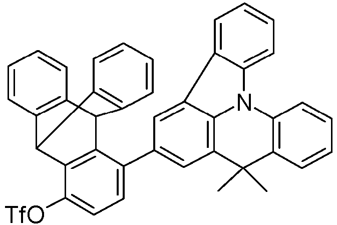 | 81% |
| S77 | 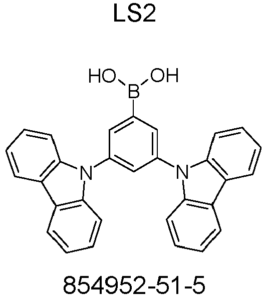 | 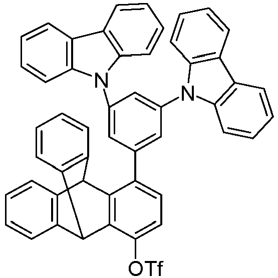 | 86 % |
| S78 | 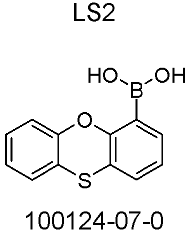 | 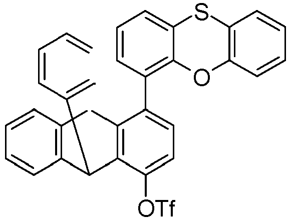 | 88 % |
| S79 | 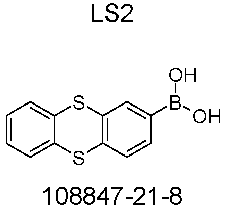 | 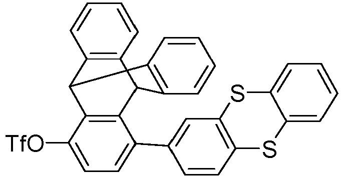 | 80 % |
| S80 | 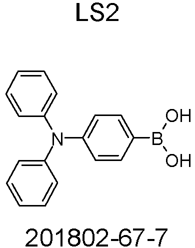 | 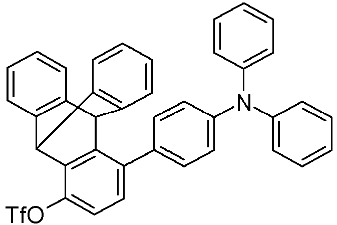 | 83 % |
| S81 | 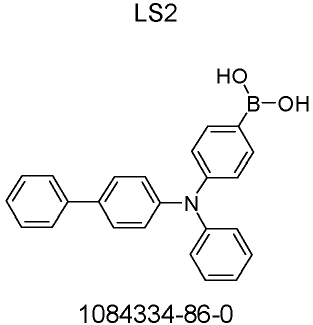 | 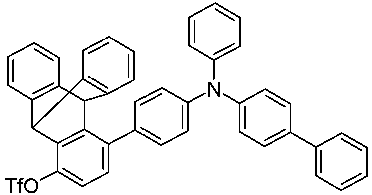 | 83 % |
| S82 | 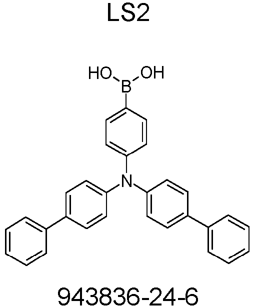 | 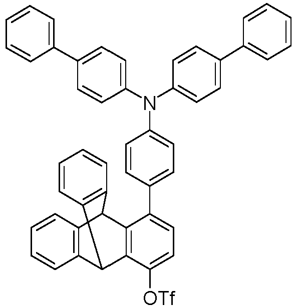 | 86 % |
| S83 | 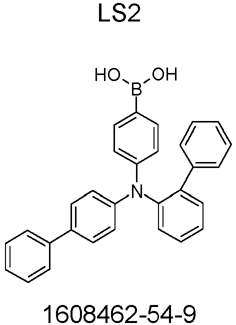 | 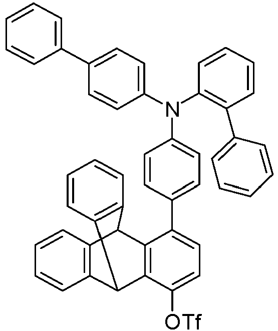 | 83 % |
| S84 | 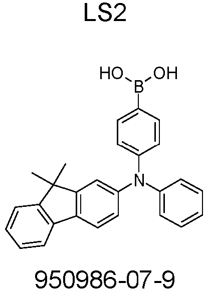 | 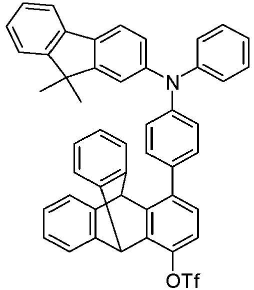 | 85 % |
| S85 | 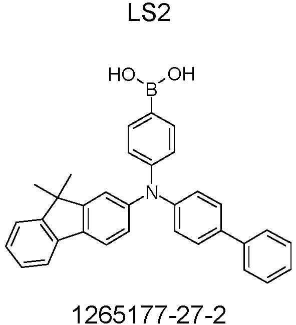 | 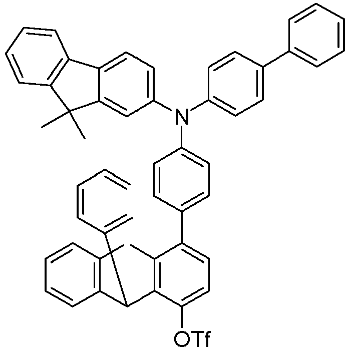 | 89 % |
| S86 | 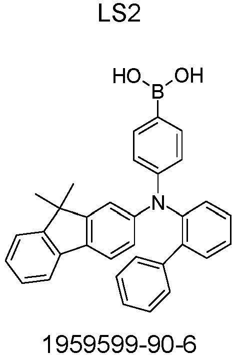 | 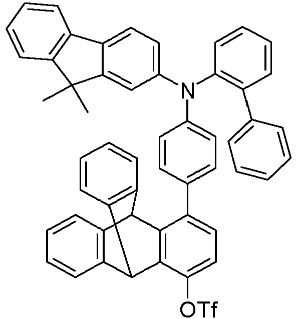 | 88 % |
| S87 | 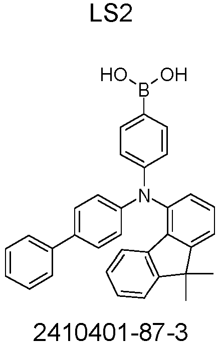 | 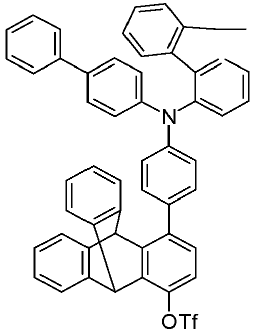 | 85 % |
| S88 | 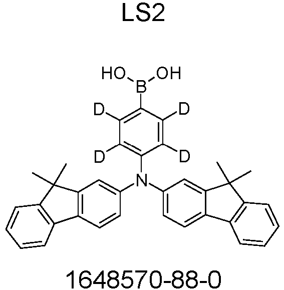 | 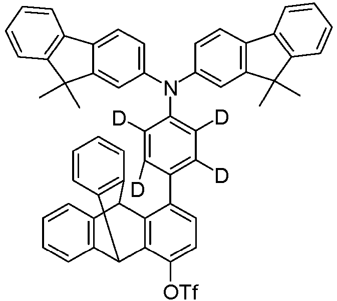 | 83 % |
| S89 | 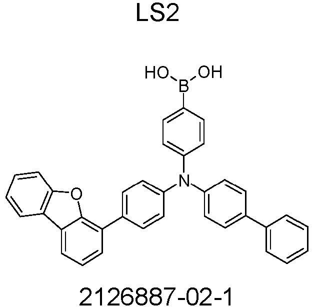 | 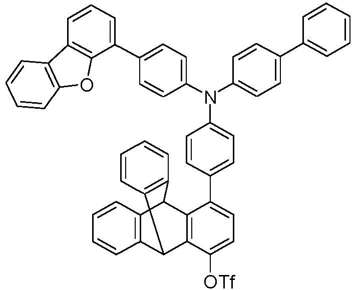 | 87 % |
| S90 | 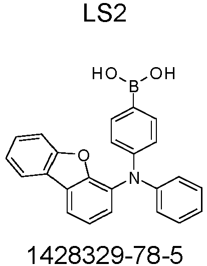 | 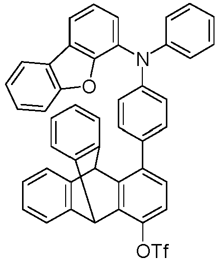 | 85 % |
| S91 | 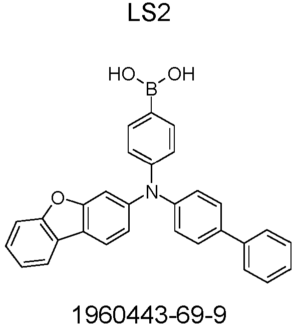 | 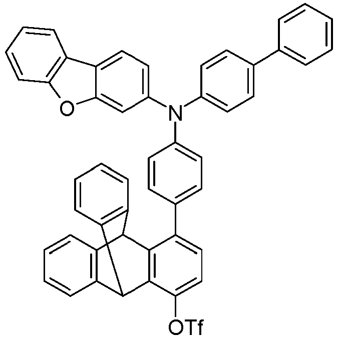 | 86 % |
| S92 | 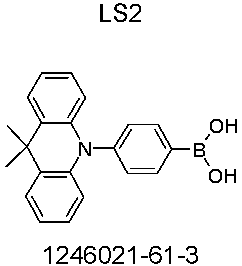 | 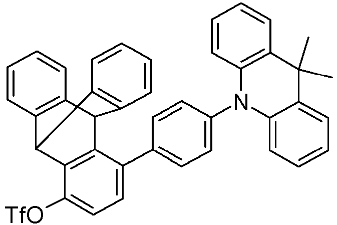 | 74 % |
| S93 | 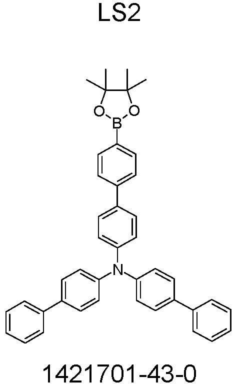 | 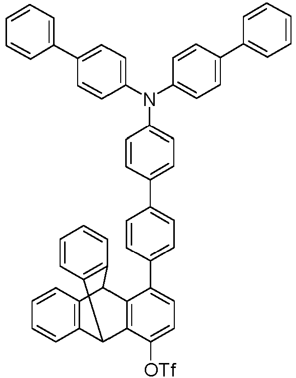 | 90 % |
| S94 | 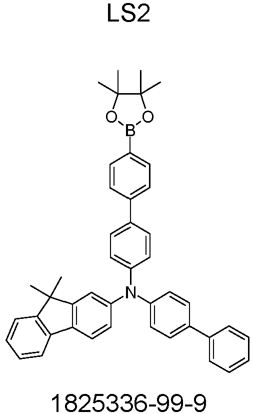 | 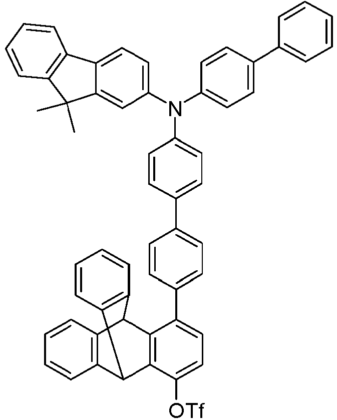 | 85 % |
| S95 | 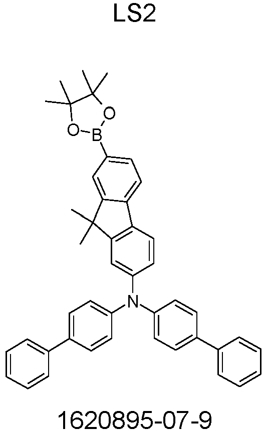 | 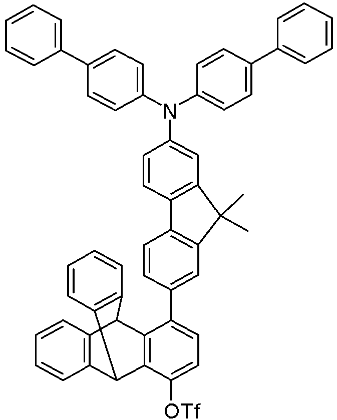 | 89 % |
| S96 | 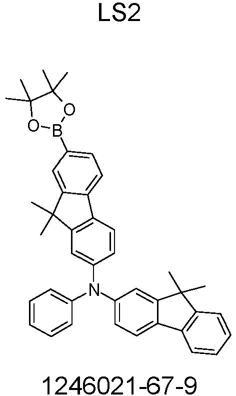 | 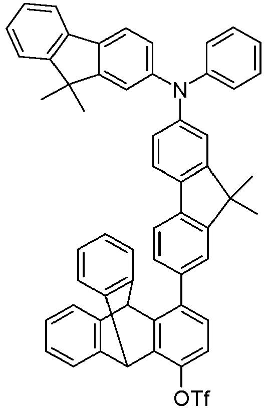 | 90 % |
| S97 | 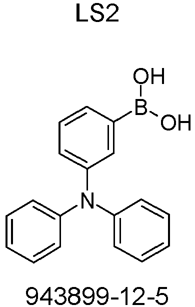 | 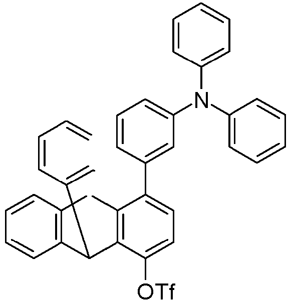 | 87 % |
| S98 | 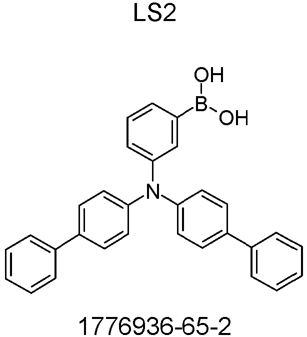 | 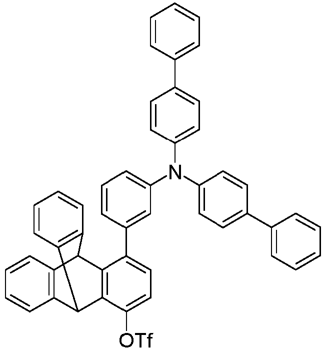 | 88 % |
| S99 | 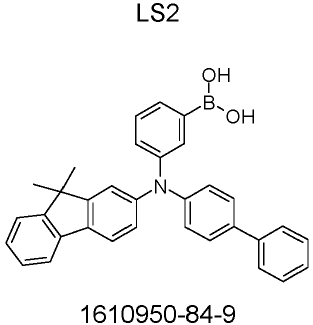 | 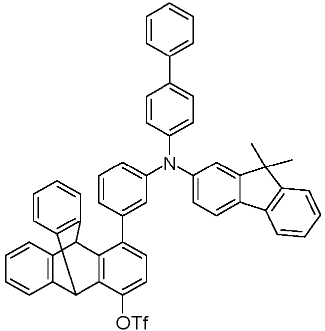 | 89 % |
| S100 | 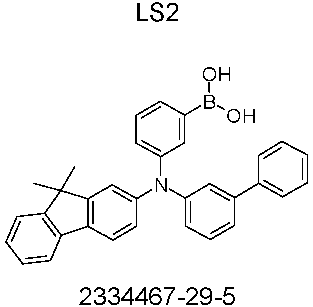 | 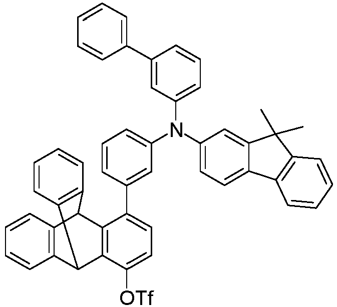 | 83 % |
| S101 | 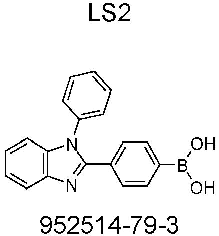 | 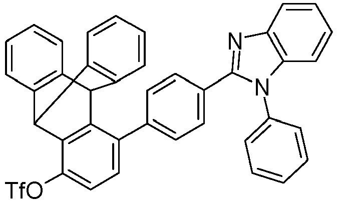 | 85 % |
| S102 | 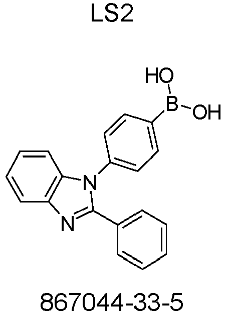 | 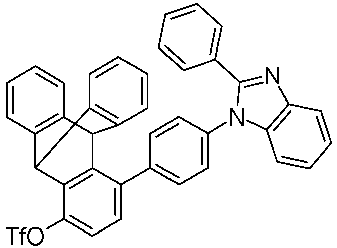 | 87 % |
| S103 | 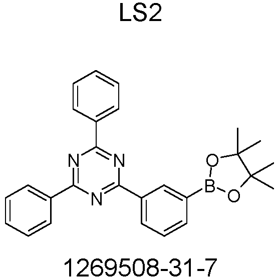 | 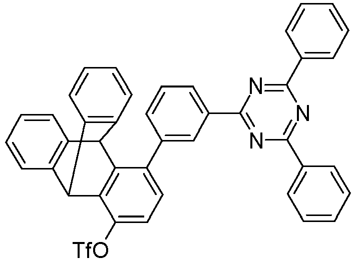 | 83 % |
| S104 | 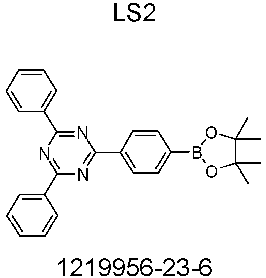 | 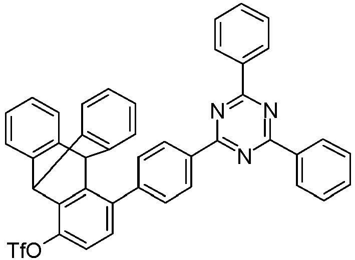 | 86 % |
| S105 | 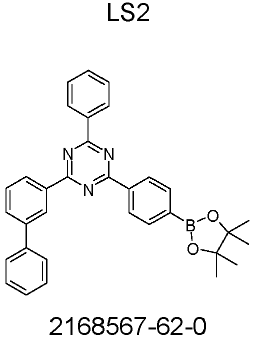 | 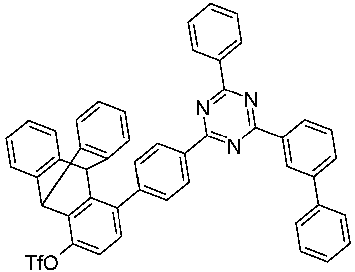 | 88 % |
| S106 | 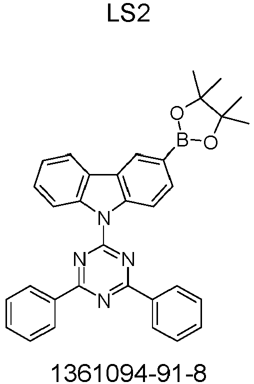 | 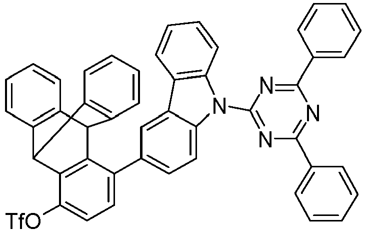 | 73 % |
| S107 | 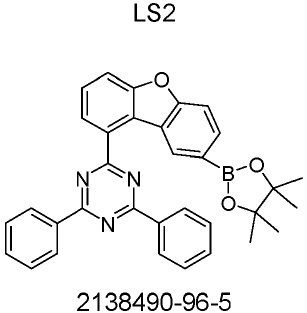 | 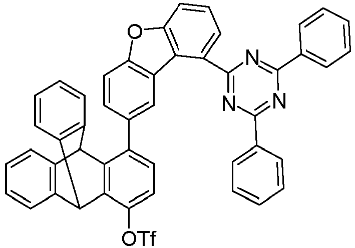 | 85% |
| S108 | 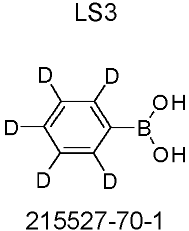 | 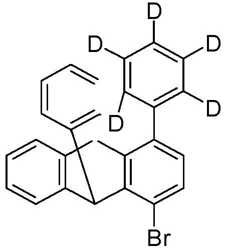 | 93 % |

### Beispiel S200:

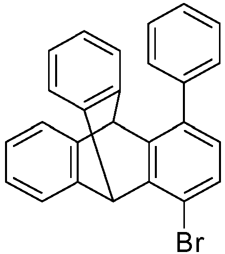

Durchführung analog zu Y. Imazaki et al, J. Am. Chem. Soc., 2012, 134, 14760.

Ein gut gerührtes Gemisch aus 47.9 g (100 mmol) S1, 130.4 g (150 mmol) Lithiumbromid, 2.54 g (5 mmol) Cp*Ru(MeCN)₃OTf [113860-02-9], 100 g Glaskugeln (3 mm Durchmesser) und 400 ml NMP wird 40 h bei 100 °C gerührt. Nach vollständigem Umsatz dekantiert man von den Glaskugeln ab, entfernt das NMP im Vakuum, nimmt den Rückstand in 500 ml Ethylacetat (EE) auf, wäscht zweimal mit je 300 ml Wasser, einmal mit 200 ml ges. Kochsalzlösung und trocknet über Magnesiumsulfat. Man filtriert vom Trockenmittel über ein mit EE vorgeschlämmtes Kieselgel-Bett ab, engt das Filtrat zur Trockene ein, rührt den Rückstand mit 200 ml Methanol heiß aus, saugt das Produkt ab, wäscht mit wenig Methanol nach und trocknet im Vakuum. Ausbeute: 36.9 g (90 mmol) 90 %; Reinheit: ca. 97 % ig n. ¹H-NMR.

Analog können folgende Verbindungen dargestellt werden:

| Bsp. | Edukt | Produkt | Ausbeute |
|---|---|---|---|
| S201 | S2 | 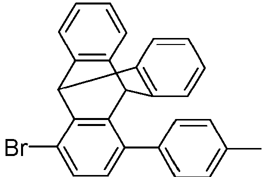 | 89 % |
| S202 | S3 | 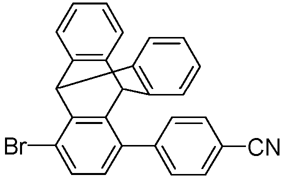 | 67 % |
| S203 | S4 | 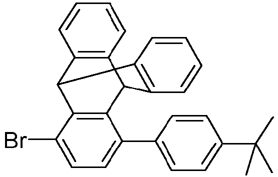 | 92 % |
| S204 | S5 | 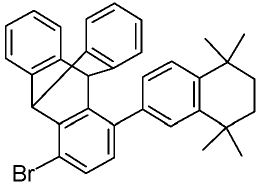 | 90 % |
| S205 | S6 | 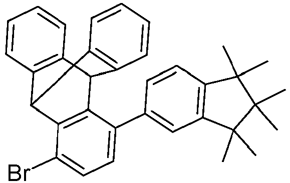 | 89 % |
| S206 | S7 | 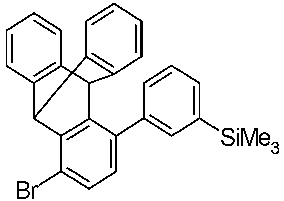 | 44 % |
| S207 | S8 | 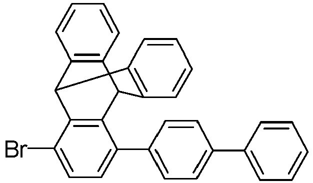 | 90 % |
| S208 | S9 | 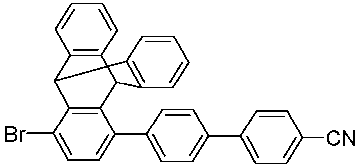 | 89 % |
| S209 | S10 | 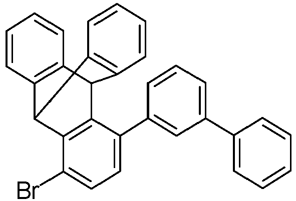 | 91 % |
| S210 | S11 | 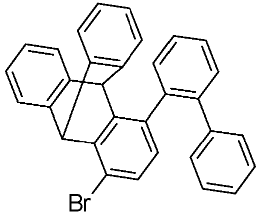 | 90 % |
| S211 | S12 | 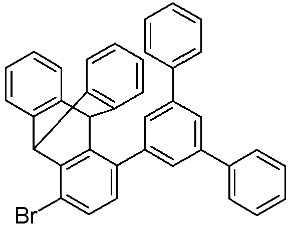 | 91% |
| S212 | S13 | 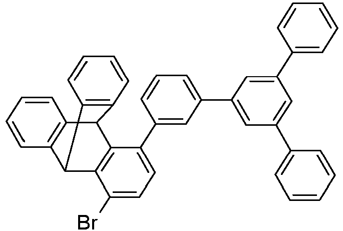 | 89 % |
| S213 | S14 | 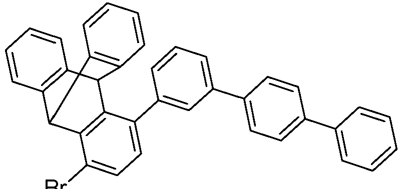 | 92 % |
| S214 | S15 | 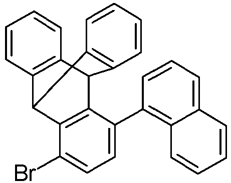 | 90 % |
| S215 | S16 | 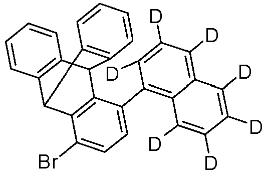 | 89 % |
| S216 | S17 | 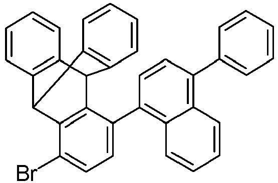 | 87 % |
| S217 | S18 | 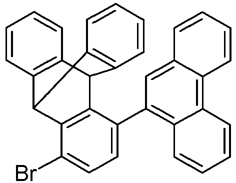 | 92 % |
| S218 | S19 | 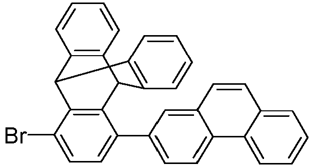 | 90 % |
| S219 | S20 | 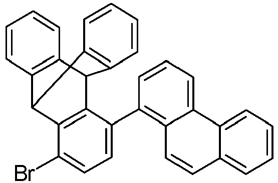 | 88 % |
| S220 | S21 | 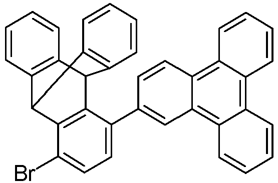 | 89 % |
| S221 | S22 | 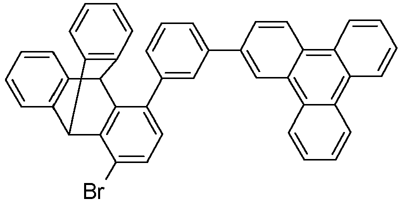 | 87 % |
| S222 | S23 | 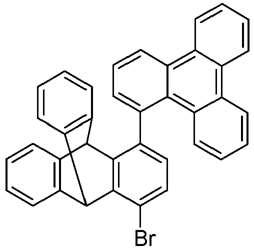 | 90 % |
| S223 | S24 | 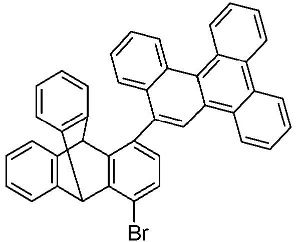 | 93 % |
| S224 | S25 | 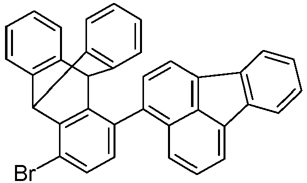 | 89 % |
| S225 | S26 | 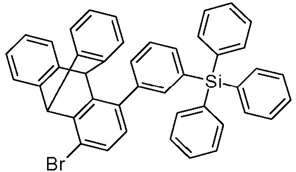 | 47 % |
| S226 | S27 | 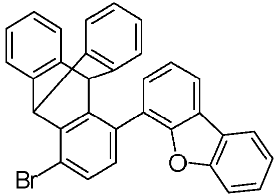 | 90 % |
| S227 | S28 | 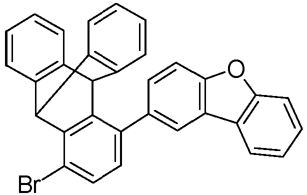 | 89 $ |
| S228 | S29 | 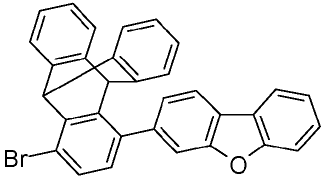 | 92 % |
| S229 | S30 | 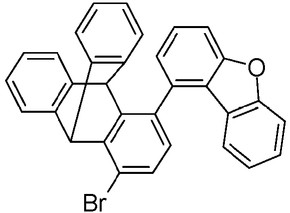 | 89 % |
| S230 | S31 | 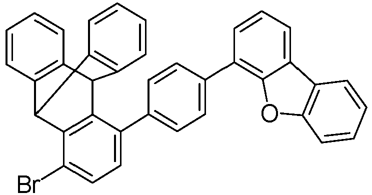 | 89 % |
| S231 | S32 | 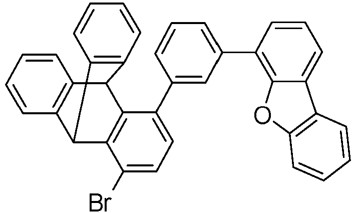 | 89 % |
| S232 | S33 | 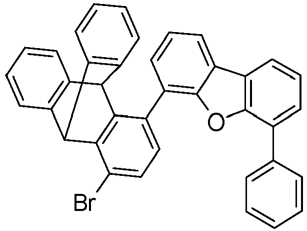 | 90 % |
| S233 | S34 | 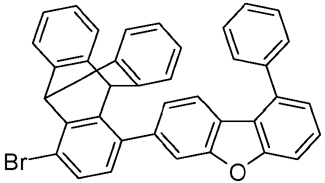 | 87 % |
| S234 | S35 | 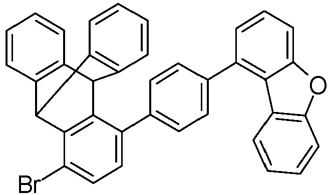 | 90 % |
| S235 | S36 | 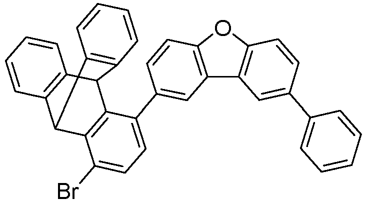 | 86 % |
| S236 | S37 | 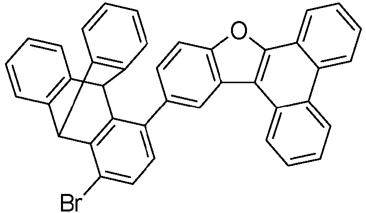 | 89 % |
| S237 | S38 | 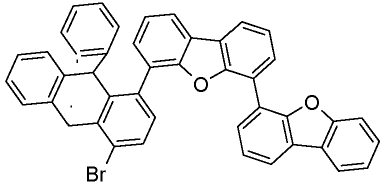 | 85 % |
| S238 | S39 | 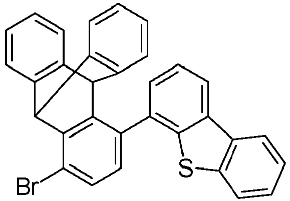 | 92 % |
| S239 | S40 | 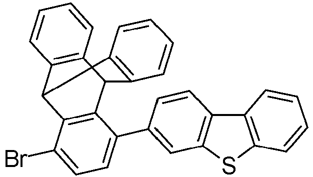 | 89 % |
| S240 | S41 | 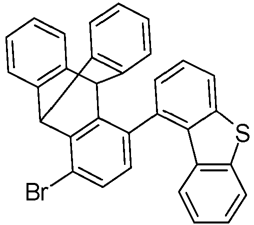 | 92 % |
| S241 | S42 | 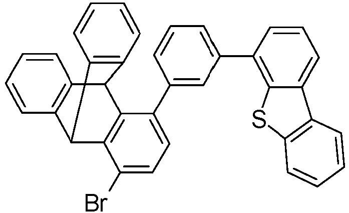 | 92 % |
| S242 | S43 | 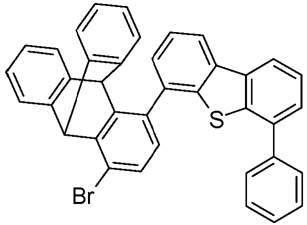 | 89 % |
| S243 | S44 | 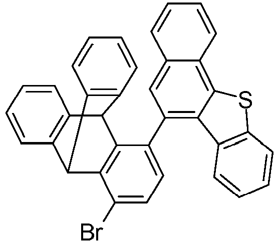 | 90 % |
| S244 | S45 | 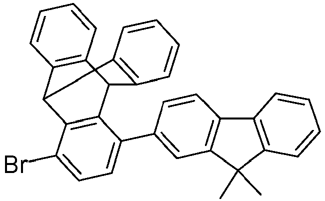 | 92 % |
| S245 | S46 | 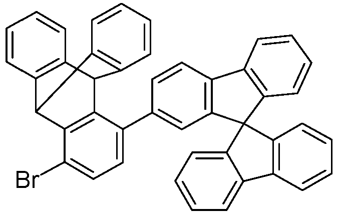 | 94 % |
| S246 | S47 | 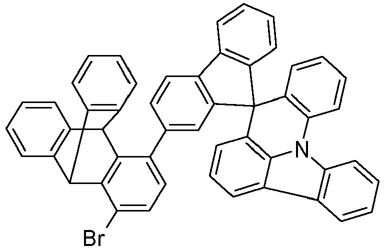 | 89 % |
| S247 | S48 | 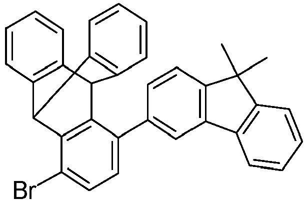 | 87 % |
| S248 | S49 | 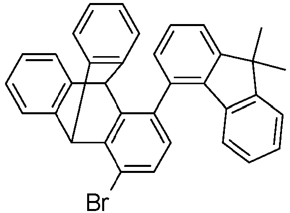 | 92 % |
| S249 | S50 | 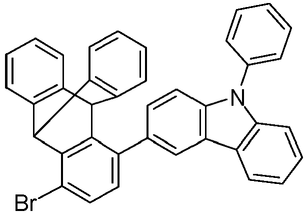 | 89 % |
| S250 | S51 | 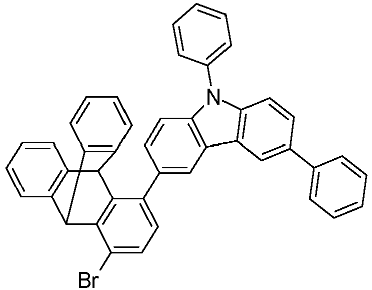 | 88 % |
| S251 | S52 | 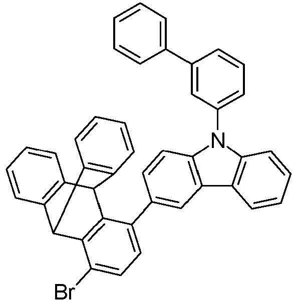 | 90 % |
| S252 | S53 | 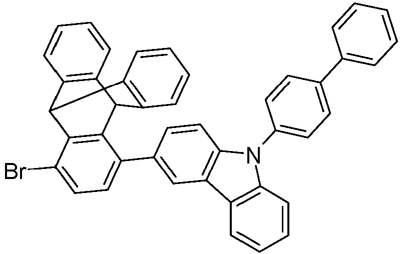 | 90 % |
| S253 | S54 | 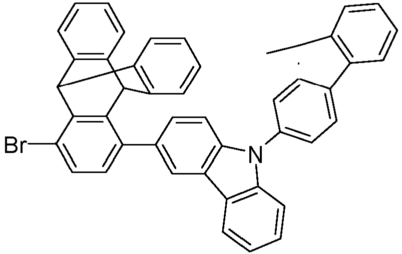 | 92 % |
| S254 | S55 | 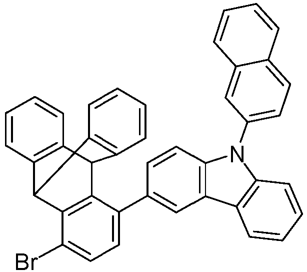 | 87 % |
| S255 | S56 | 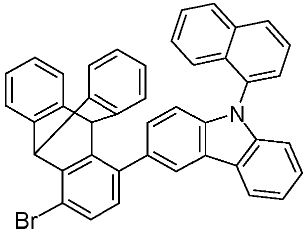 | 89 % |
| S256 | S57 | 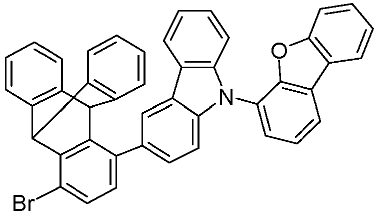 | 92 % |
| S257 | S58 | 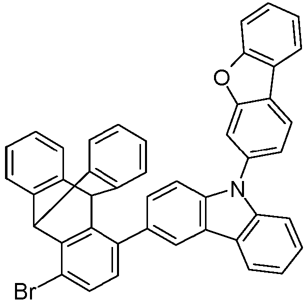 | 92 % |
| S258 | S59 | 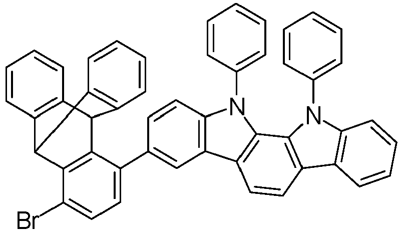 | 90 % |
| S259 | S60 | 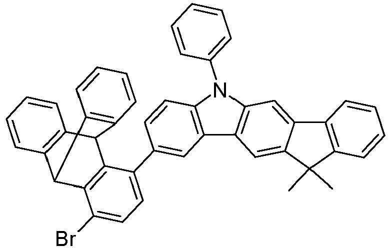 | 87 % |
| S260 | S61 | 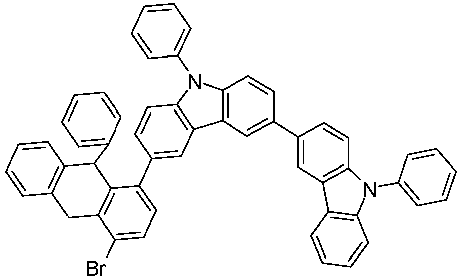 | 89 % |
| S261 | S62 | 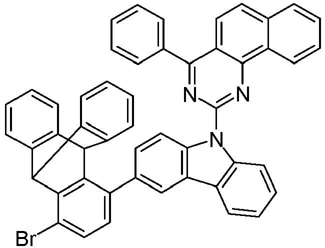 | 90 % |
| S262 | S63 | 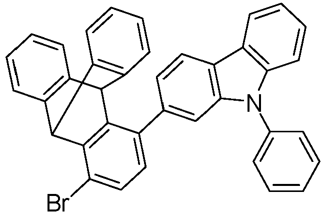 | 90 % |
| S263 | S64 | 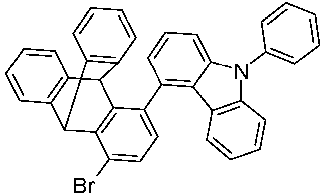 | 92 % |
| S264 | S65 | 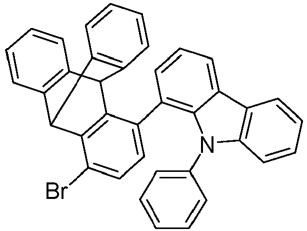 | 91 % |
| S265 | S66 | 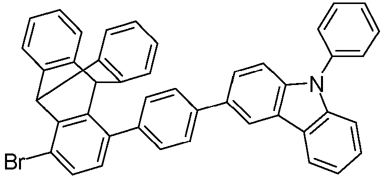 | 88 % |
| S266 | S67 | 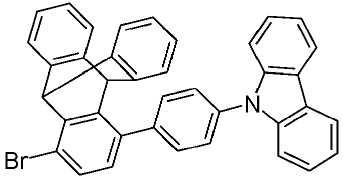 | 92 % |
| S267 | S68 | 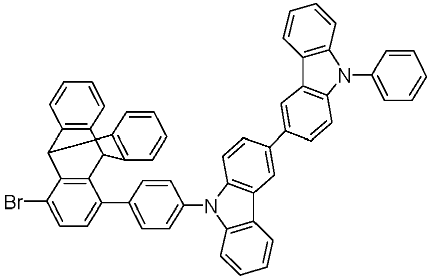 | 88 % |
| S268 | S69 | 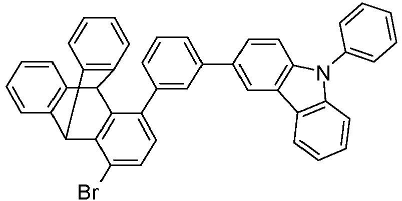 | 89 % |
| S269 | S70 | 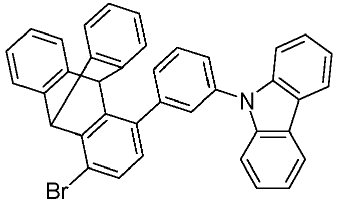 | 94 % |
| S270 | S71 | 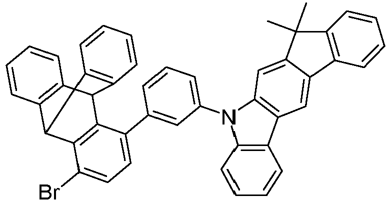 | 90 % |
| S271 | S72 | 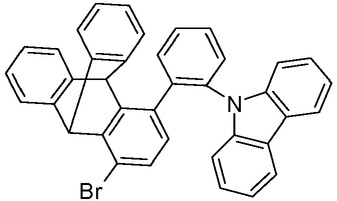 | 89 % |
| S272 | S73 | 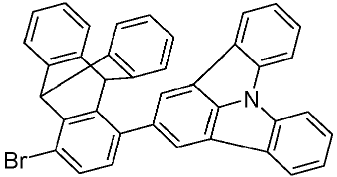 | 85 % |
| S273 | S74 | 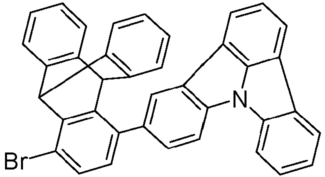 | 86 % |
| S274 | S75 | 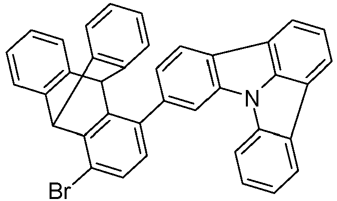 | 92 % |
| S275 | S76 | 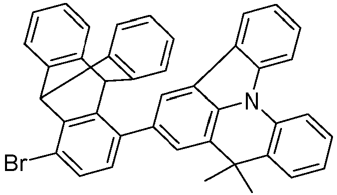 | 89 % |
| S276 | S77 | 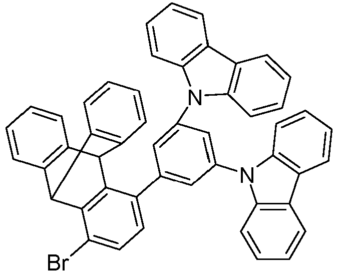 | 90 % |
| S277 | S78 | 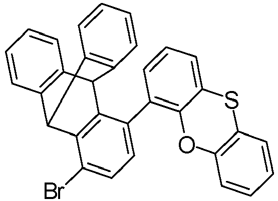 | 91 % |
| S278 | S79 | 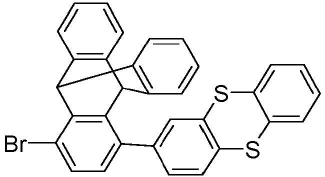 | 89 % |
| S279 | S80 | 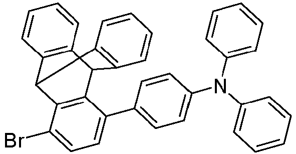 | 88 % |
| S280 | S81 | 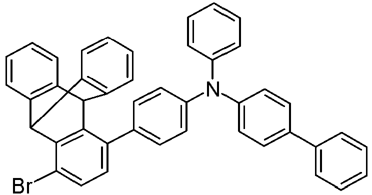 | 89 % |
| S281 | S82 | 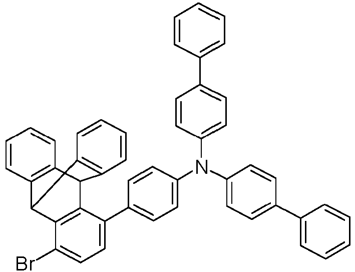 | 92 % |
| S282 | S83 | 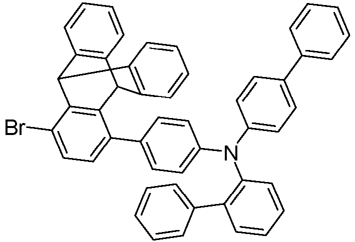 | 87 % |
| S283 | S84 | 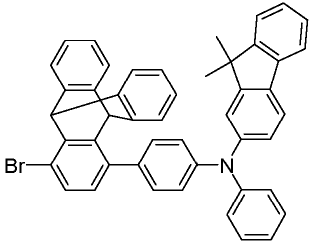 | 89 % |
| S284 | S85 | 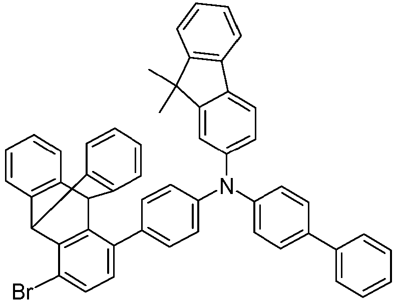 | 89 % |
| S285 | S86 | 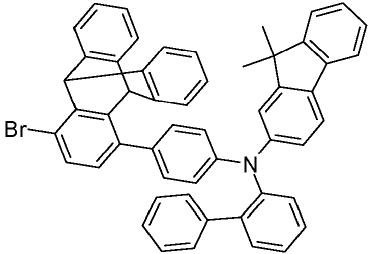 | 88 % |
| S286 | S87 | 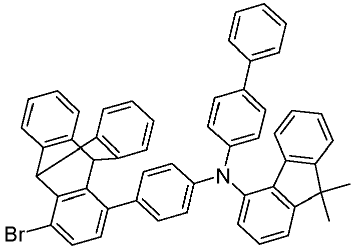 | 85 % |
| S287 | S88 | 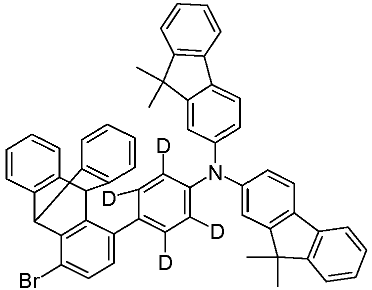 | 88 % |
| S288 | S89 | 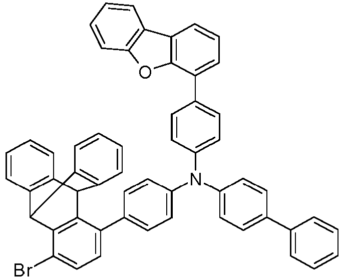 | 89 % |
| S289 | S90 | 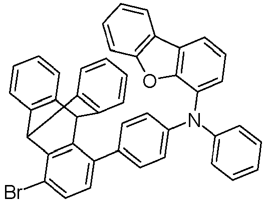 | 93 % |
| S290 | S91 | 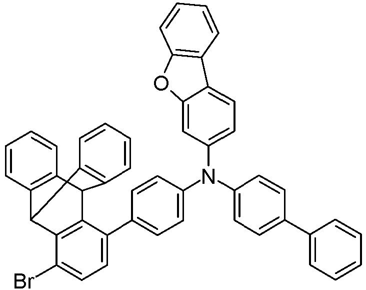 | 90 % |
| S291 | S92 | 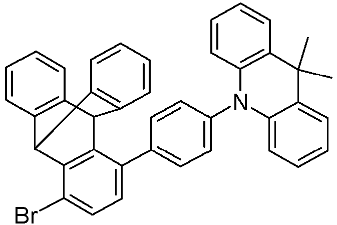 | 89 % |
| S292 | S93 | 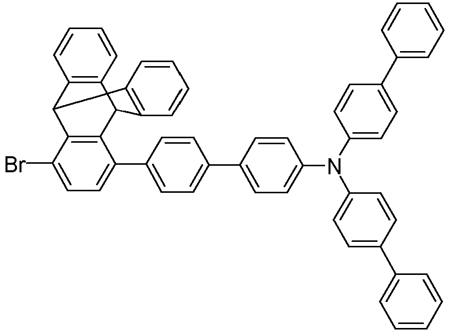 | 92 % |
| S293 | S94 | 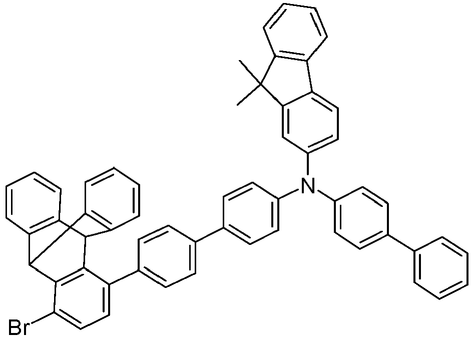 | 90 % |
| S294 | S95 | 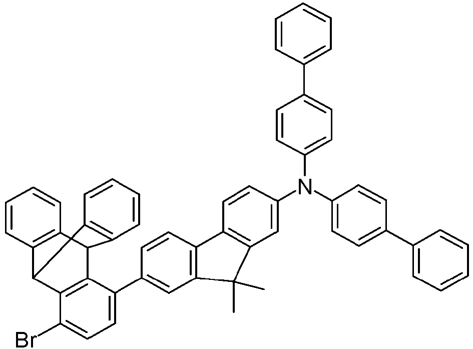 | 93 % |
| S295 | S96 | 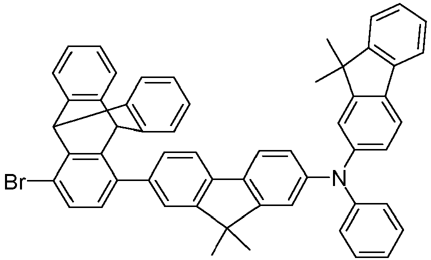 | 89 % |
| S296 | S97 | 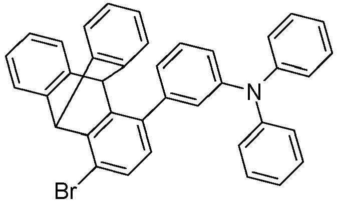 | 91 % |
| S297 | S98 | 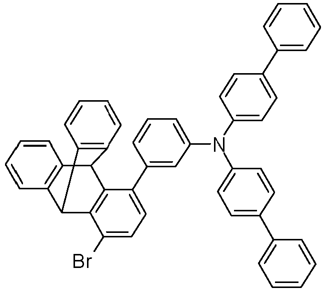 | 89 % |
| S298 | S99 | 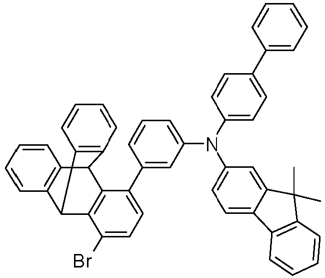 | 90 % |
| S299 | S100 | 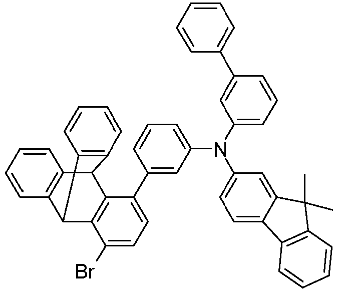 | 88 % |
| S300 | S101 | 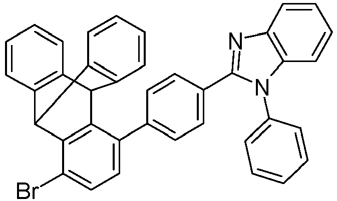 | 92 % |
| S301 | S102 | 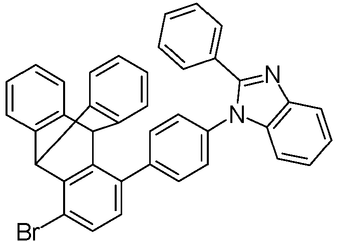 | 90 % |
| S302 | S103 | 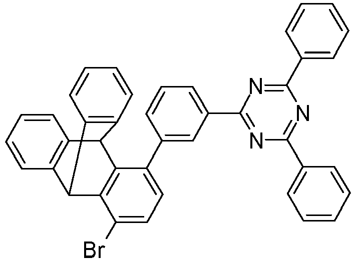 | 81 % |
| S303 | S104 | 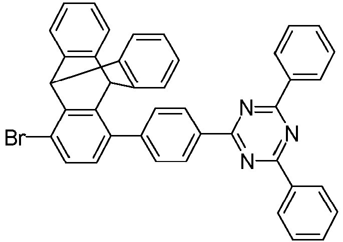 | 85 % |
| S304 | S105 | 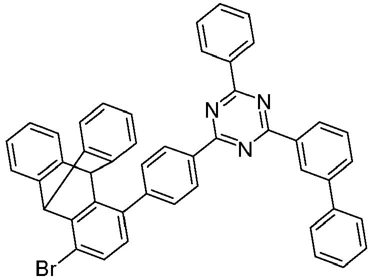 | 83 % |
| S305 | S106 | 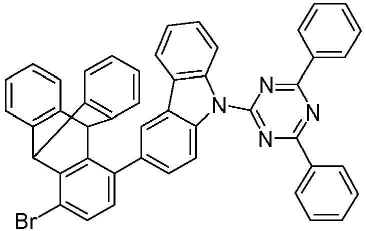 | 87 % |
| S306 | S107 | 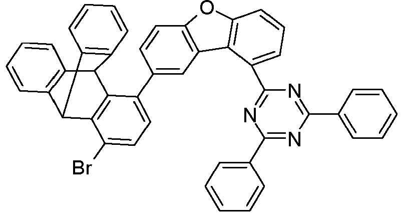 | 81 % |

### Beispiel S400:

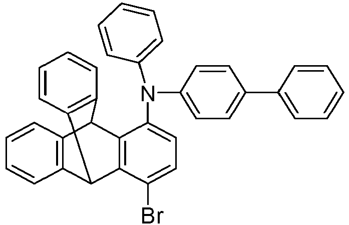

Durchführung analog zu Y. Kanazawa et al., Tetrahedron, 2015, 71, 1395. Ein gut gerührtes Gemisch aus 45.9 g (100 mmol) LS3, 24.5 g (100 mmol) N-Phenyl[1,1'-biphenyl]-4-amin [32228-99-2], 14.4 g (150 mmol) Natrium-tert-butanolat, 579 mg (1 mmol) XanthPhos, 224 mg (1 mmol) Palladium(II)acetat und 500 ml Dioxan wird 16 h bei 100 °C gerührt. Nach vollständigem Umsatz entfernt man das Dioxan im Vakuum, nimmt den Rückstand in 500 ml DCM auf, wäscht zweimal mit je 300 ml Wasser, einmal mit 200 ml ges. Kochsalzlösung und trocknet über Magnesiumsulfat. Man filtriert vom Trockenmittel über ein mit EE vorgeschlämmtes Kieselgel-Bett ab, engt das Filtrat zur Trockene ein, rührt den Rückstand mit 200 ml Methanol heiß aus, saugt das Produkt ab, wäscht mit wenig Methanol nach und trocknet im Vakuum. Ausbeute: 49.2 g (85 mmol) 85 %; Reinheit: ca. 97 % ig n. ¹H-NMR.

Analog können folgende Verbindungen dargestellt werden:

| Bsp. | Edukt | Produkt | Ausbeute |
|---|---|---|---|
| S401 | 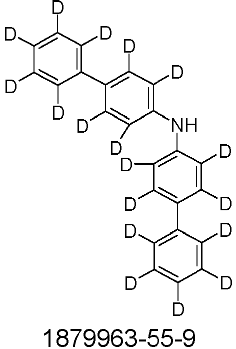 | 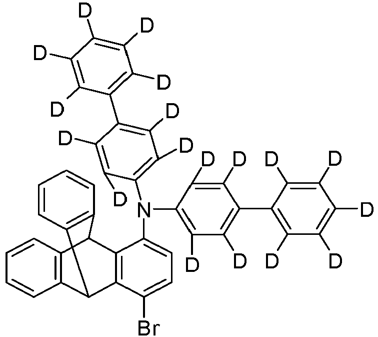 | 90 % |
| S402 | 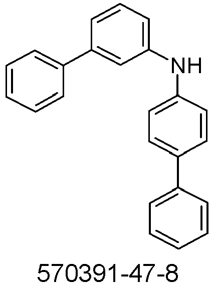 | 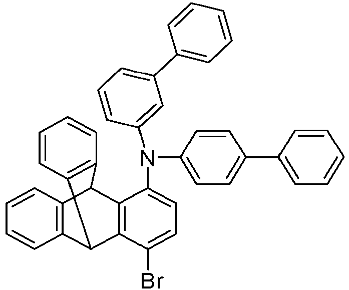 | 87 % |
| S403 | 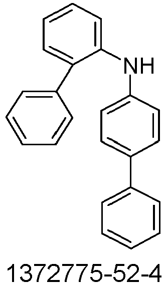 | 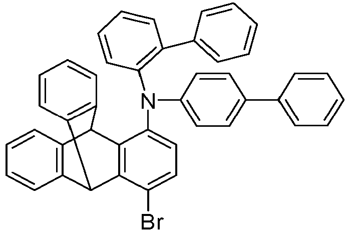 | 81 % |
| S404 | 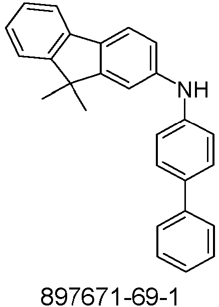 | 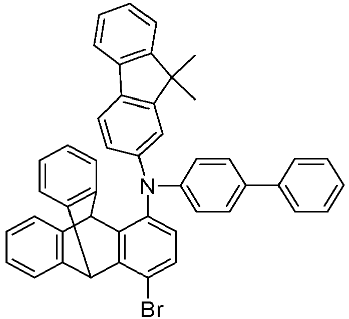 | 90 % |
| S405 | 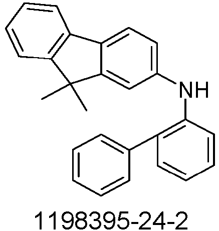 | 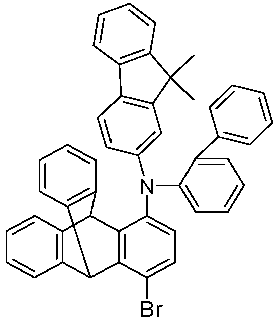 | 83 % |
| S406 | 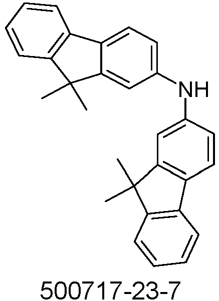 | 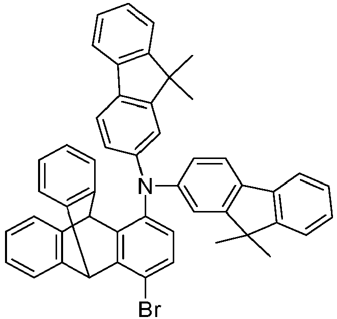 | 92 % |
| S407 | 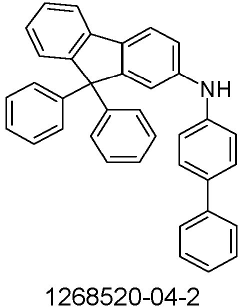 | 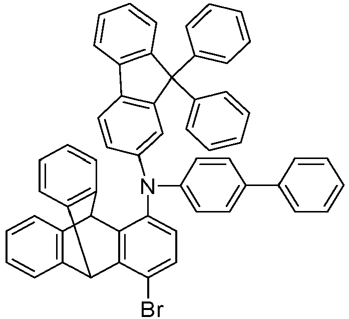 | 85 % |
| S408 | 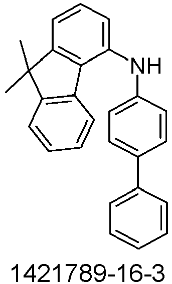 | 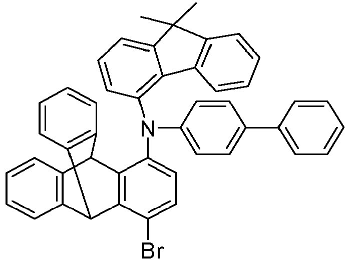 | 82 % |
| S409 | 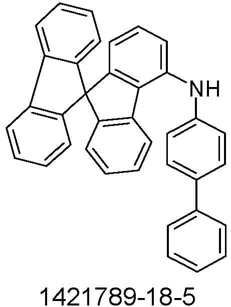 | 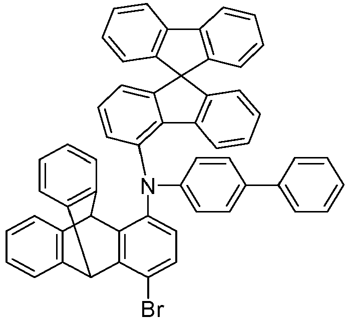 | 80 % |
| S410 | 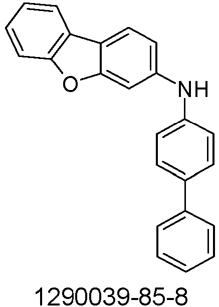 | 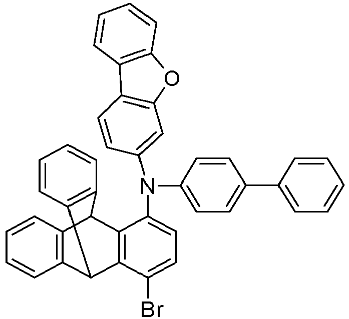 | 91 % |
| S411 | 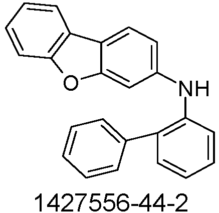 | 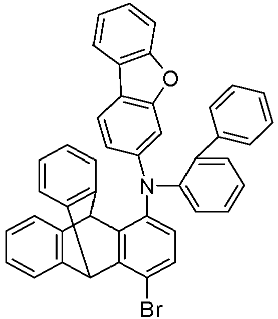 | 88 % |
| S412 | 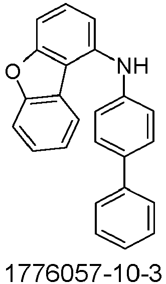 | 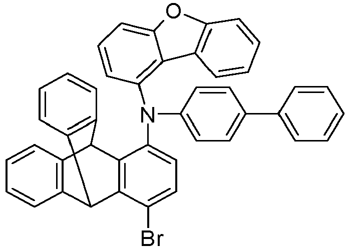 | 84 % |
| S413 | 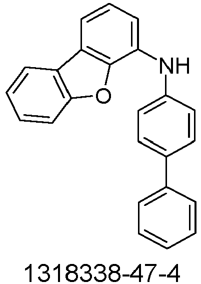 | 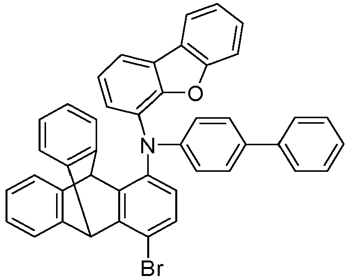 | 86 % |
| S414 | 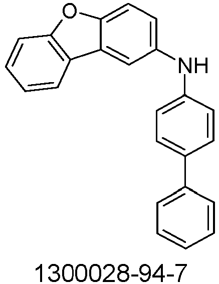 | 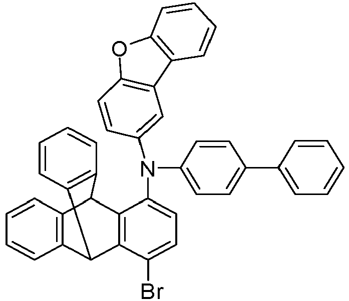 | 89 % |
| S415 | 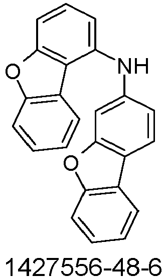 | 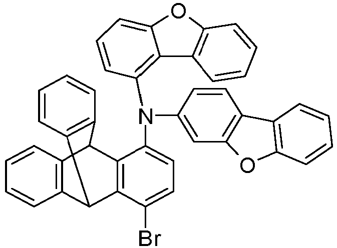 | 87 % |
| S416 | 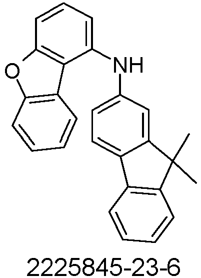 | 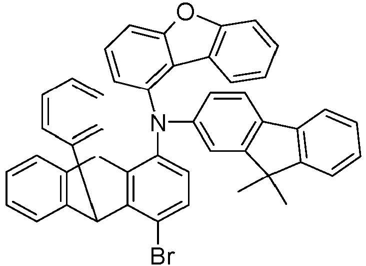 | 83 % |
| S417 | 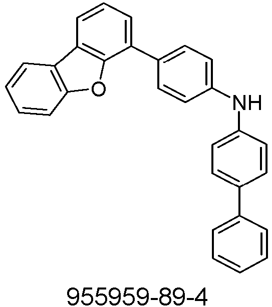 | 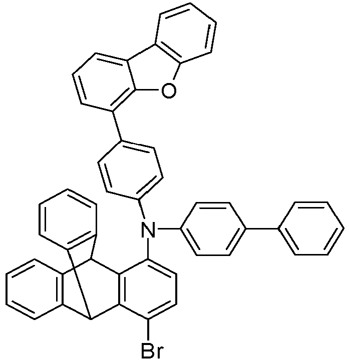 | 90 % |
| S418 | 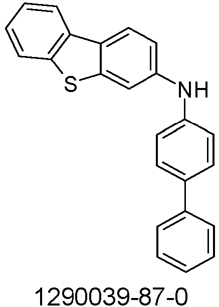 | 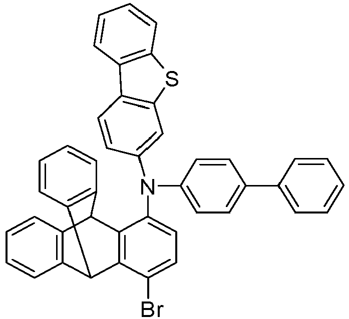 | 88 % |

### B) Synthese der erfindungsgemäßen Verbindungen

### Beispiel D1: Dibenzofuran Typ1

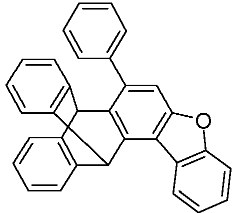

### A) Suzuki-Kupplung

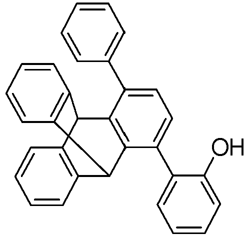

Durchführung analog zu S. Duan et al., Chem. Commun., 2016, 52(69), 10529. Ein Gemisch aus 40.9 g (100 mmol) S200, 15.2 g (110 mmol) 2-Hydroxyphenyl-boronsäure [89466-08-0], 31.0 ml (220 mmol) Di-isopropylamin, 112 mg (0.5 mmol) Palladium(II)acetat und 250 ml Wasser wird 2 h bei 100° C im Rührautoklaven gerührt. Nach Erkalten gibt man 500 ml ges. Kochsalzlösung und 46 ml (230 mmol) 5 N HCl zu und extrahiert das Gemisch dreimal mit je 200 ml Dichlormethan (DCM). Die vereinigten org. Phasen werden zweimal mit je 300 ml Wasser und einmal mit 200 ml ges. Kochsalzlösung gewaschen und dann über Natriumsulfat getrocknet. Man filtriert vom Trockenmittel ab, engt das Filtrat ein und substituiert das abrotierte DCM kontinuierlich durch Methanol. Man saugt vom auskristallisierten Feststoff ab, wäscht zweimal mit je 50 ml Methanol und trocknet im Vakuum. Ausbeute: 33.4 g (79 mmol), 79 %; Reinheit: ca. 98 % ig. n. ¹H-NMR.

### B) Oxidative Cyclisierung

Durchführung analog zu B. Xiao et al., J. Am, Chem, Soc., 2011, 133, 9250. In ein gut gerührtes, auf 130 °C temperiertes Gemisch aus 42.3 g (100 mmol) D1 Stufe A), 27.6 g (200 mmol) Kaliumcarbonat, wasserfrei, 9.3 g (50 mmol) Natrium-2,4,6-trimethylbenzoat, 4.27 g (10 mmol) 1,3-Bis-(2,6-diisopropylphenyl)-imidazoliniumchlorid, 1.12 g (5 mmol) Palladium(II)acetat, 1.82 g (10 mmol) 4,5-Diazafluorenon, 100 g Molsieb 3 A und 500 ml Mesitylen wird während 20 h ein langsamer Luftstrom eingeleitet. Man filtriert noch heiß über ein mit Mesitylen vorgeschlämmtes Celite-Bett ab, wäscht mit Toluol nach, engt das Filtrat zur Trockene ein. Man nimmt den Rückstand in 500 ml DCM auf, wäscht dreimal mit je 200 ml Wasser, einmal mit 200 ml ges. Kochsalzlösung, trocknet über Magnesiumsulfat. Man filtriert vom Trockenmittel über ein mit DCM vorgeschlämmtes Kieselgel-Bett ab, engt das Filtrat ein und substituiert das abrotierte DCM kontinuierlich durch Methanol. Man saugt vom auskristallisierten Feststoff ab, wäscht zweimal mit je 50 ml Methanol und trocknet im Vakuum. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum. Ausbeute: 27.0 g (64 mmol) 64 %; Reinheit: ca. 99.9 % ig n. HPLC.

Analog können folgende Verbindungen dargestellt werden:

| Bsp. | Edukt | Produkt | Ausbeute |
|---|---|---|---|
| D2 | 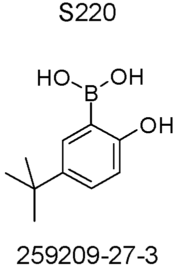 | 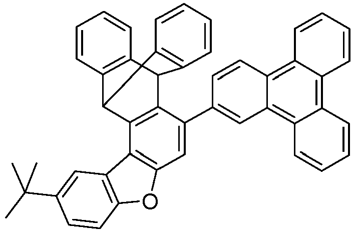 | 54 % |
| D3 | 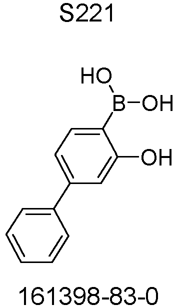 | 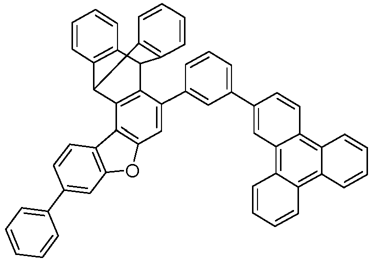 | 59 % |
| D4 | 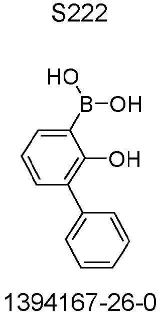 | 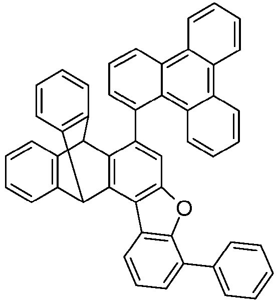 | 62 % |
| D5 | 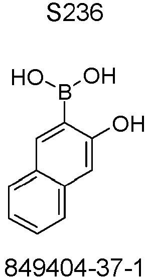 | 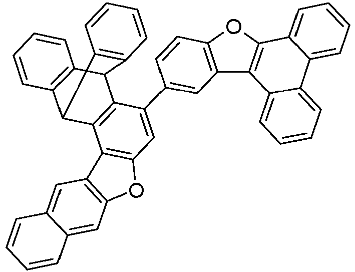 | 48 % |
| D6 | 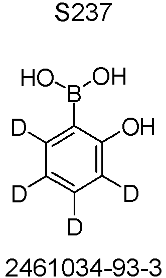 | 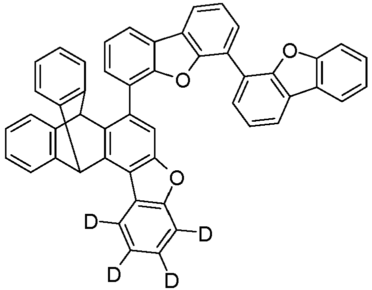 | 55 % |
| D7 | 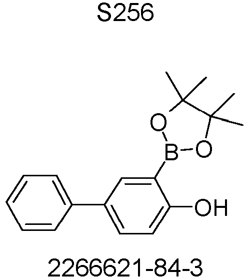 | 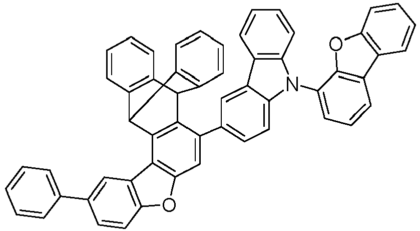 | 53 % |
| D8 | 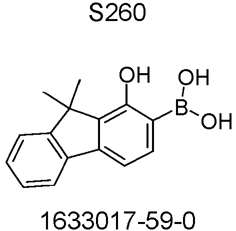 | 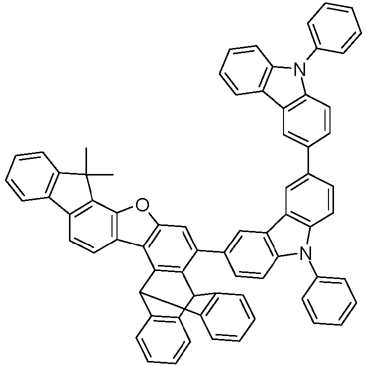 | 41 % |
| D9 | 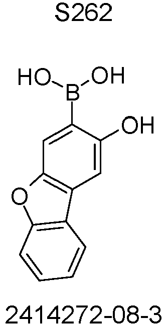 | 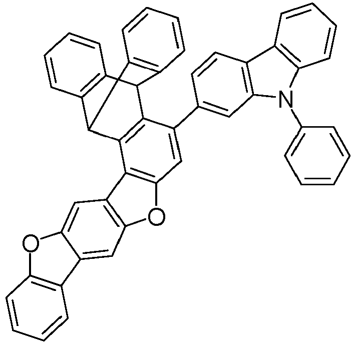 | 49 % |
| D10 | 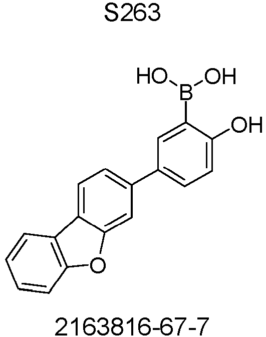 | 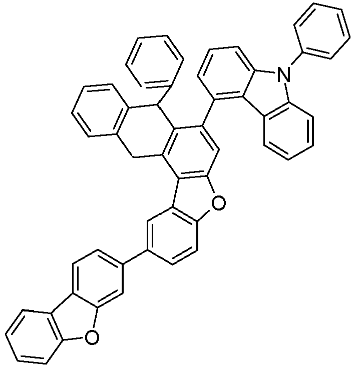 | 52 % |
| D11 | 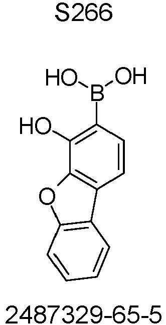 | 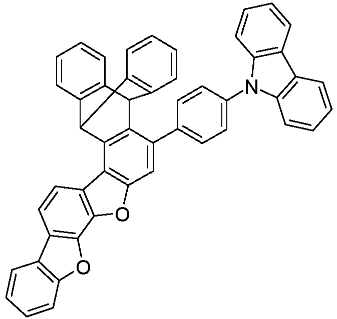 | 50 % |
| D12 | 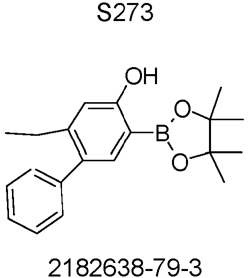 | 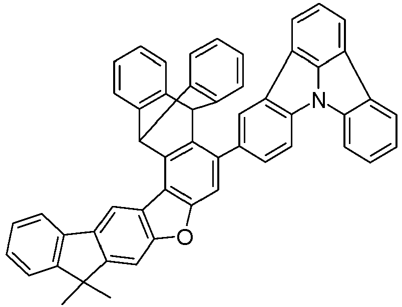 | 47 % |
| D13 | 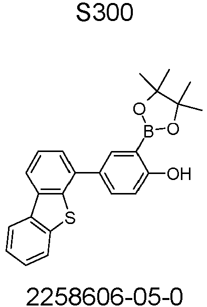 | 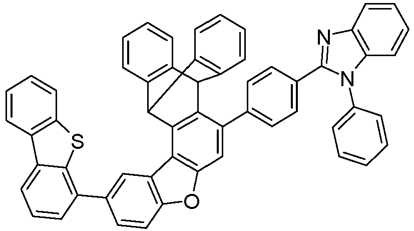 | 36 % |
| D14 | 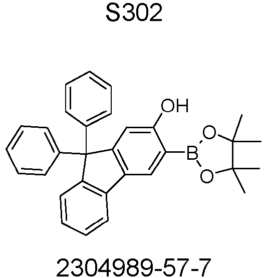 | 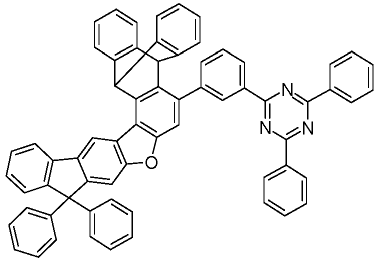 | 51 % |
| D15 | 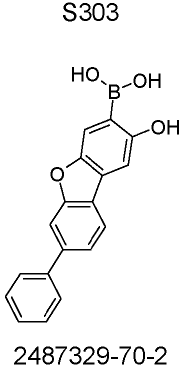 | 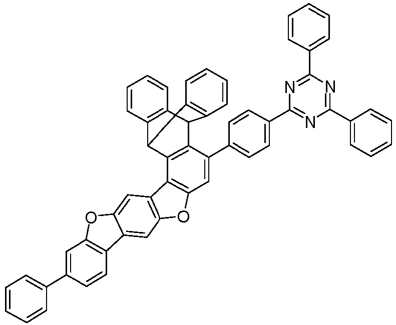 | 45% |
| D16 | 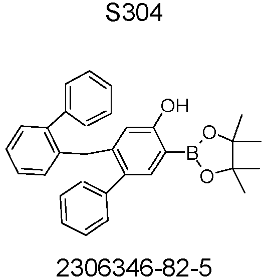 | 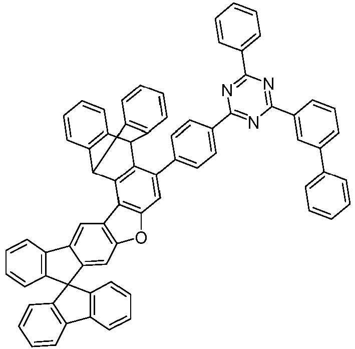 | 56 % |
| D17 | 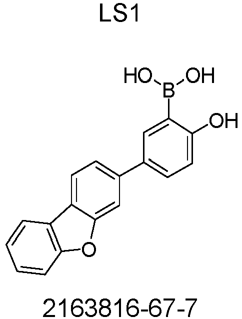 | 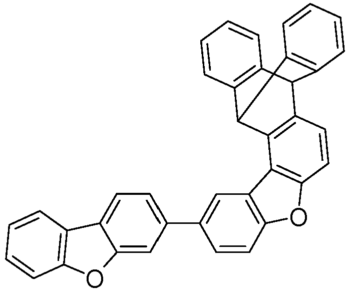 | 64 % |
| D18 | 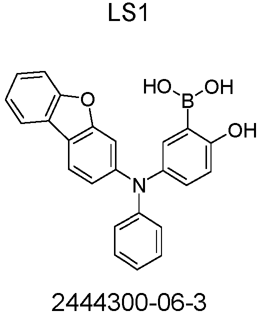 | 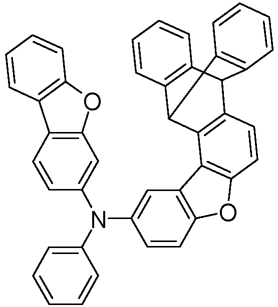 | 32 % |
| D19 | 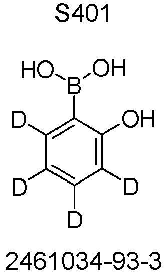 | 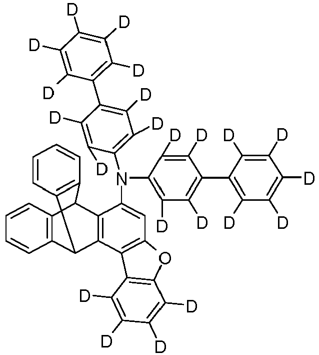 | 46 % |
| D20 | 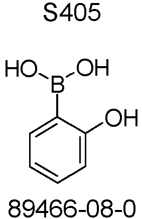 | 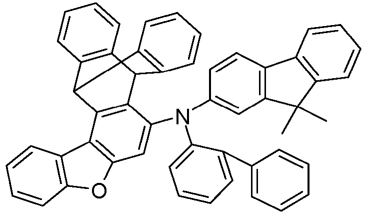 | 43 % |
| D21 | 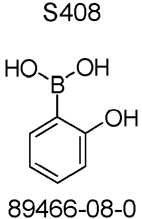 | 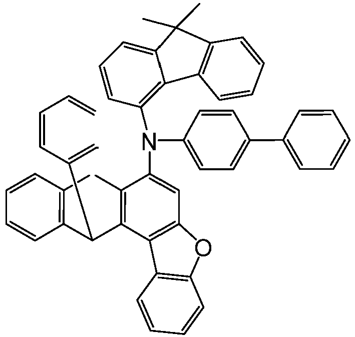 | 52 % |
| D22 | 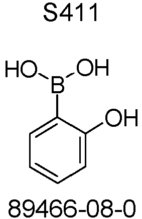 | 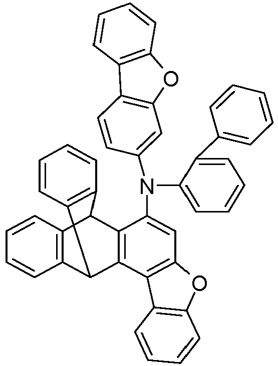 | 49 % |

### Beispiel D100: Dibenzofuran Typ2

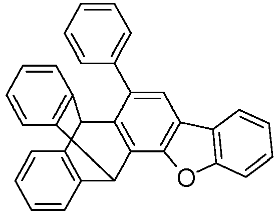

### A) Ullmann-Kupplung

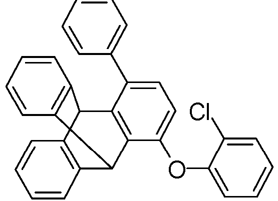

Ein Gemisch aus 40.9 g (100 mmol) S200, 14.2 g (110 mmol) 2-Chlorphenol [95-57-8], 42.5 g (200 mmol) Trikaliumphosphat wasserfrei, 1.23 g (10 mmol) Picolinsäure, 952 mg (5 mmol) Kupfer(I)iodid, 100 g Glaskugeln (3 mm Durchmesser) und 300 ml DMSO wird 20 h bei 100° C gerührt. Man saugt noch heiß über ein mit DMSO vorgeschlämmtes Celite-Bett ab, engt das Filtrat weitgehend ein, rührt den Rückstand mit 300 ml eines Methanol / Wasser Gemisch (1:1 vv) heiß aus, saugt vom Rohprodukt ab, wäscht zweimal mit je 50 ml Methanol nach, trocknet im Vakuum und kristallisiert aus Acetonitril um. Ausbeute: 30.1 g (66 mmol), 66 %; Reinheit: ca. 95 % ig. n. ¹H-NMR.

### B) Cyclisierung

Durchführung analog Campeau et al., J. Am. Chem. Soc., 2006, 128, 593. Ein Gemisch aus 45.7 g (100 mmol) D100 Stufe A), 27.6 g (200 mmol) Kaliumcarbonat, 3.68 g (10 mmol) Tricyclohexylphosphonium-tetrafluoroborat [58656-04-5], 1.12 g (5 mmol) Palladium(II)acetat, 100 g Glaskugeln (3 mm Durchmesser) und 300 ml Dimethylacetamid (DMA) wird 20 h bei 130° C gerührt. Man saugt noch heiß über ein mit DMA vorgeschlämmtes Celite-Bett ab, engt das Filtrat weitgehend ein, rührt den Rückstand mit 300 ml eines Methanol / Wasser Gemischs (1:1 vv) heiß aus, saugt vom Rohprodukt ab, wäscht zweimal mit je 50 ml Methanol nach und trocknet im Vakuum. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum. Ausbeute: 28.6 g (68 mmol) 68 %; Reinheit: ca. 99.9 % ig n. HPLC.

Analog können folgende Verbindungen dargestellt werden:

| Bsp. | Edukt | Produkt | Ausbeute |
|---|---|---|---|
| D101 | 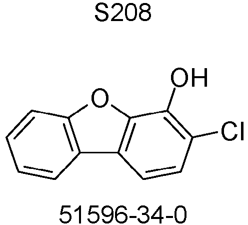 | 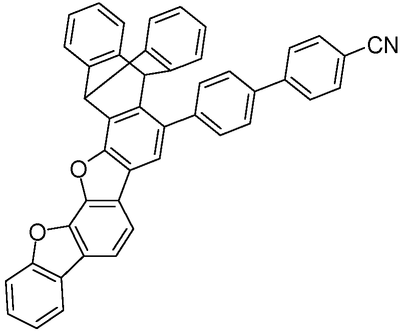 | 40 % |
| D102 | 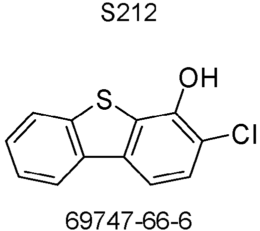 | 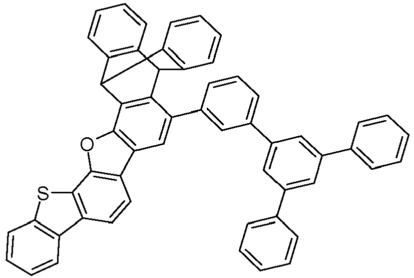 | 37 % |
| D103 | 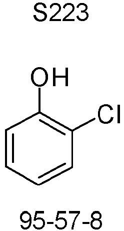 | 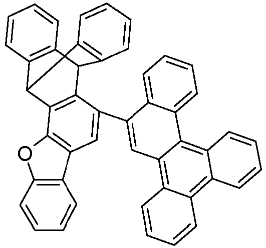 | 48 % |
| D104 | 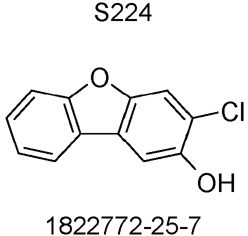 | 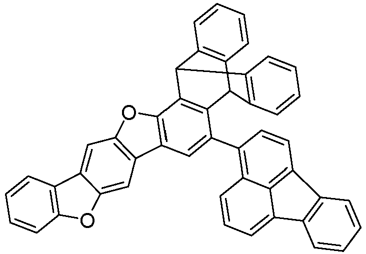 | 45 % |
| D105 | 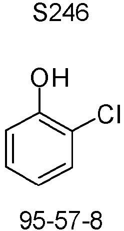 | 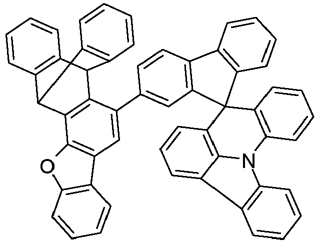 | 50 % |
| D106 | 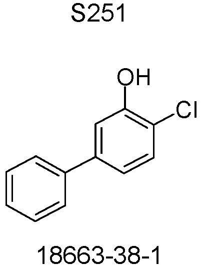 | 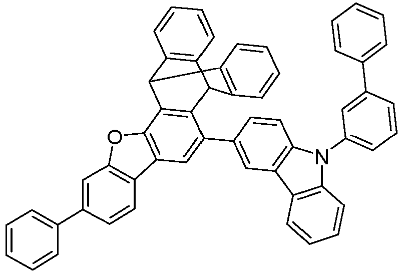 | 52 % |
| D107 | 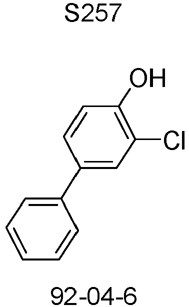 | 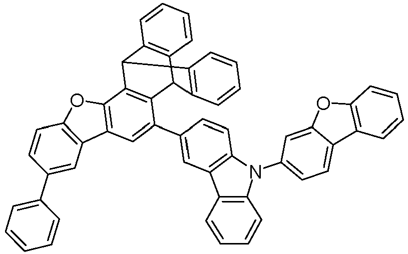 | 50 % |
| D108 | 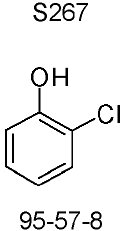 | 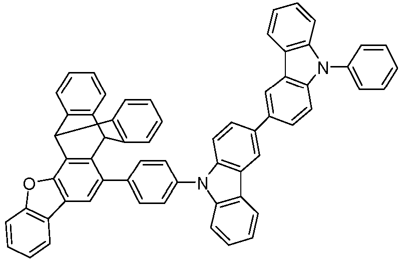 | 55 % |
| D109 | 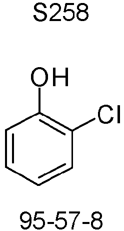 | 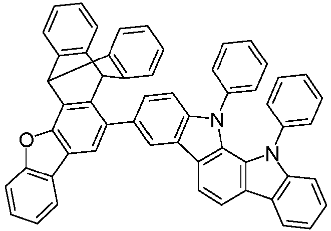 | 53 % |
| D110 | 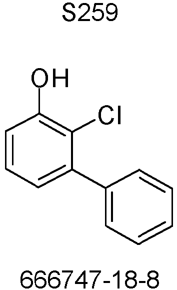 | 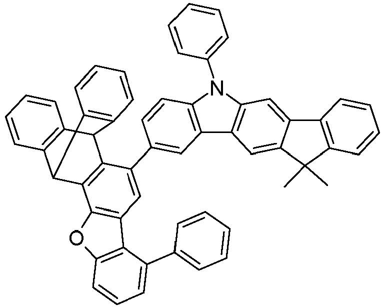 | 35 % |
| D111 | 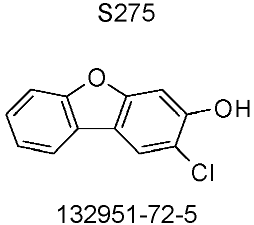 | 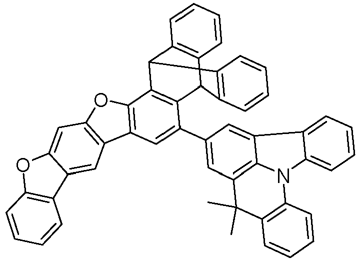 | 42 % |
| D112 | 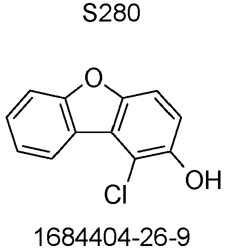 | 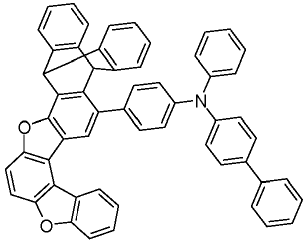 | 46 % |
| D113 | 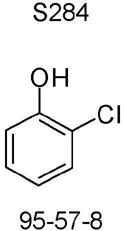 | 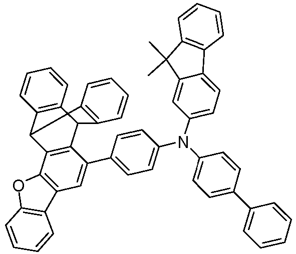 | 54 % |
| D114 | 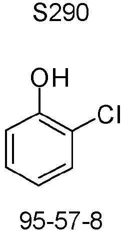 | 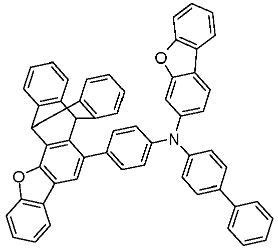 | 56 % |
| D115 | 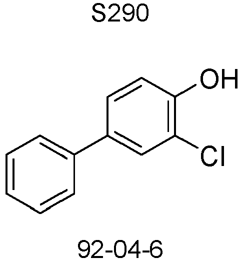 | 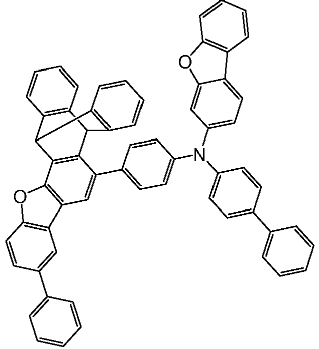 | 53 % |
| D116 | 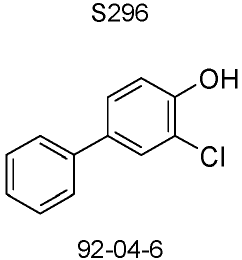 | 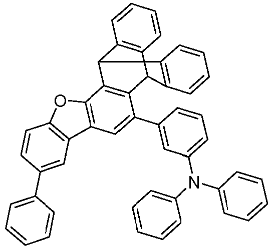 | 51% |
| D117 | 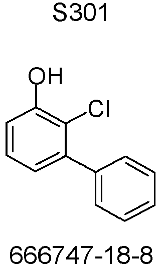 | 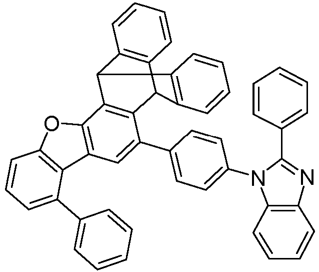 | 38 % |
| D118 | 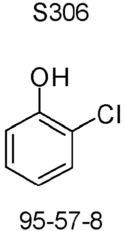 | 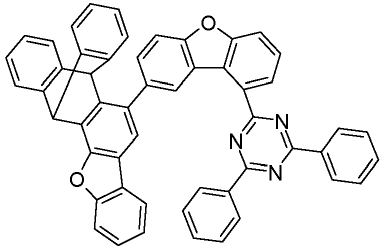 | 54 % |
| D119 | 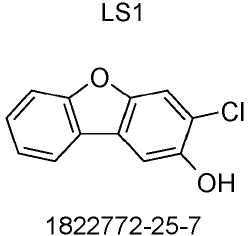 | 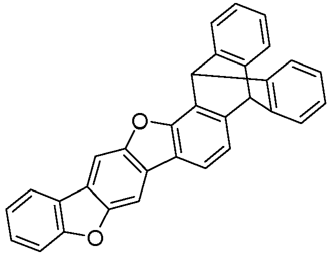 | 53 % |
| D120 | 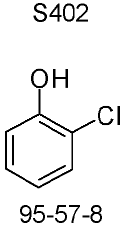 | 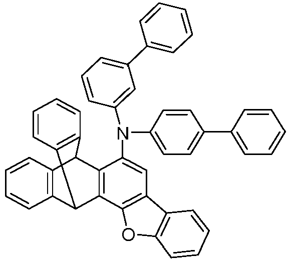 | 42 % |
| D121 | 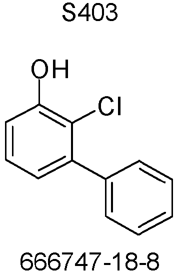 | 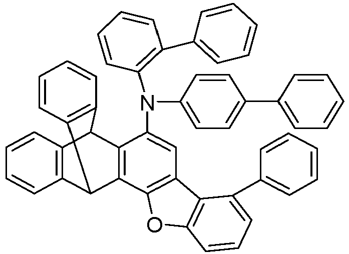 | 41 % |
| D122 | 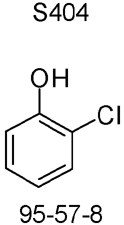 | 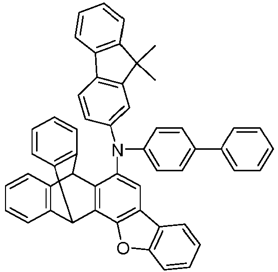 | 40% |
| D123 | 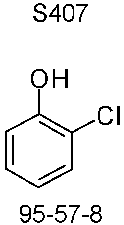 | 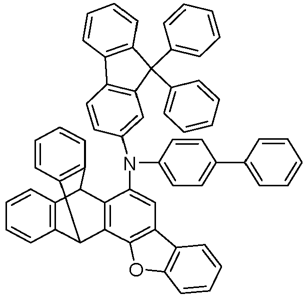 | 45 % |

### Beispiel C1: Carbazole vom Typ 1

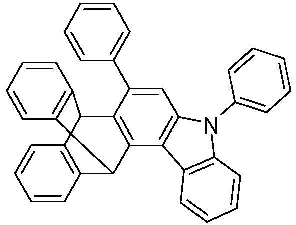

### A) Suzuki-Kupplung

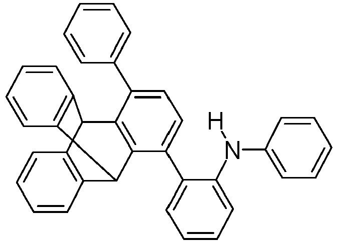

Ein gut gerührtes Gemisch aus 40.9 g (100 mmol) S200, 38.4 g (130 mmol) N-Phenyl-2-(4,4,5,5-tetramethyl-1,3,2-dioxaborolan-2-yl)benzenamin [1801421-24-8], 42.0 g (500 mmol) Natriumhydrogencarbonat, 1.15 g (1 mmol) Tetrakis-tri-phenylphosphino-palladium(0), 400 ml 1,2-Dimethoxyethan und 100 ml Wasser wird 30 h unter Rückfluss erhitzt. Man entfernt das Lösungsmittel weitgehend im Vakuum, nimmt den Rückstand in 500 ml DCM auf, wäscht dreimal mit je 300 ml Wasser, einmal mit 200 ml ges. Kochsalzlösung und trocknet über Natriumsulfat. Man filtriert vom Trockenmittel über ein mit DCM vorgeschlämmtes Celite-Bett ab, engt das Filtrat ein und substituiert das abrotierte DCM kontinuierlich durch Methanol. Man saugt das Produkt ab, wäscht zweimal mit je 50 ml Methanol, trocknet im Vakuum und kristallisiert abschließend aus Acetonitril / DCM um. Ausbeute: 33.8 g (68 mmol) 68 %; Reinheit: ca. 97 % ig. n. ¹H-NMR.

### B) Cyclisierung

Durchführung analog zu X. Liu et al., Chem. Commun., 2020, 56, 1665. Ein gut gerührtes Gemisch aus 49.8 g (100 mmpl) C1 Stufe A), 32.6 g (100 mmol) Cäsiumcarbonat, 18.2 g (100 mmol) Kupfer(II)acetat, 2.62 g (10 mmol) Triphenylphosphin, 1.12 g (5 mmol) Palladium(II)acetat, 100 g Glaskugeln (3 mm Durchmesser) und 1000 ml DMF wird an Luft 12 h bei 120 °C gerührt. Man filtriert noch warm über ein mit DMF vorgeschlämmtes Celite-Bett ab, engt das Filtrat weitgehend ein, nimmt den Rückstand in 500 ml DCM auf, wäscht dreimal mit je 200 ml 10 Gew.-%iger AmmoniakLösung, zweimal mit je 200 ml Wasser, einmal mit 200 ml ges. Kochsalzlösung und trocknet über Natriumsulfat. Man filtriert vom Trockenmittel über ein mit DCM vorgeschlämmtes Kieselgel-Bett ab, engt das Filtrat weitgehend ein, rührt den Rückstand mit 300 ml Methanol heiß aus, saugt vom Rohprodukt ab, wäscht zweimal mit je 50 ml Methanol nach und trocknet im Vakuum. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum. Ausbeute: 27.4 g (55 mmol) 55 %; Reinheit: ca. 99.9 % ig n. HPLC.

Analog können folgende Verbindungen dargestellt werden:

| Bsp. | Edukt | Produkt | Ausbeute |
|---|---|---|---|
| C2 | 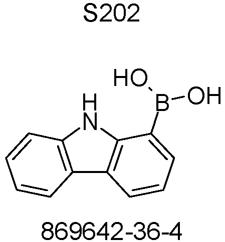 | 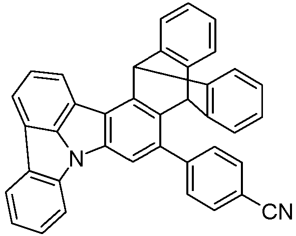 | 21 % |
| C3 | 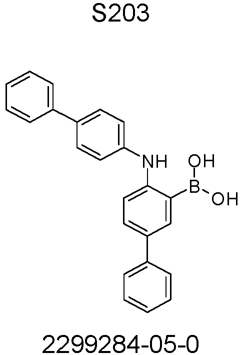 | 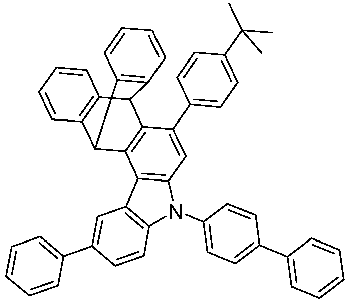 | 39 % |
| C4 | 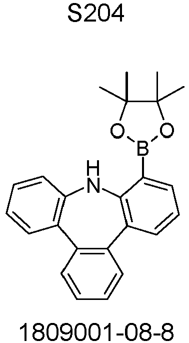 | 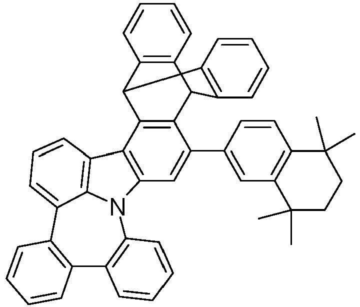 | 41 % |
| C5 | 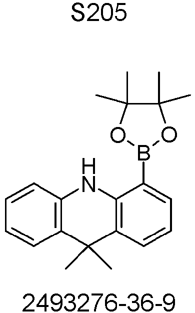 | 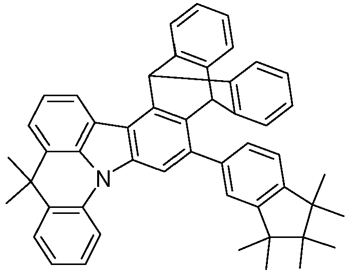 | 37 % |
| C6 | 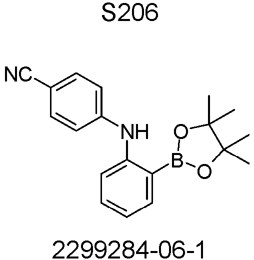 | 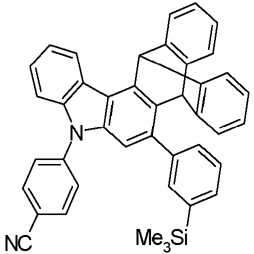 | 23 % |
| C7 | 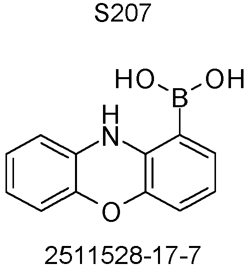 | 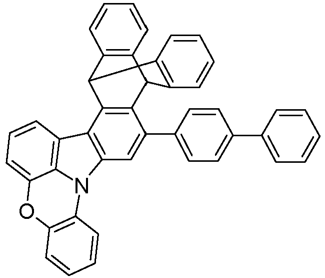 | 40 % |
| C8 | 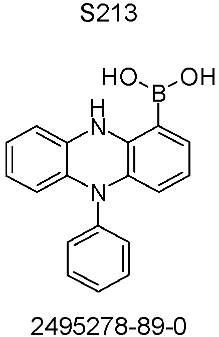 | 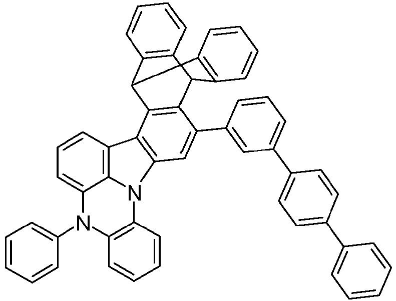 | 27 % |
| C9 | 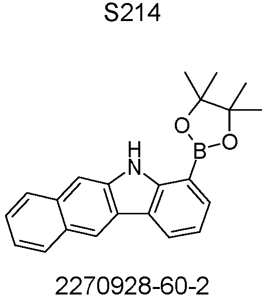 | 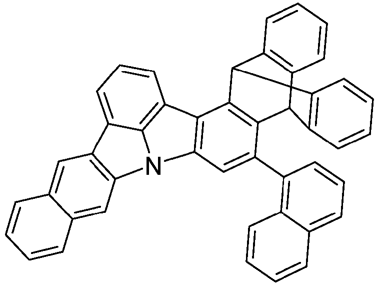 | 23 % |
| C10 | 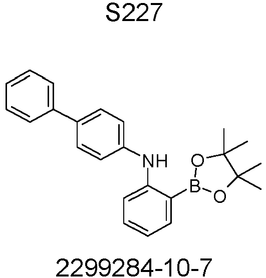 | 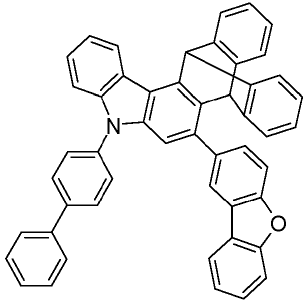 | 42 % |
| C11 | 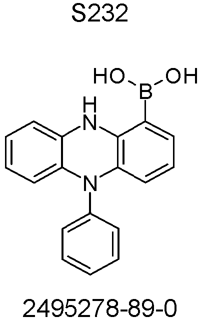 | 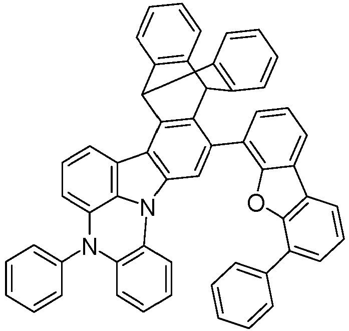 | 38 % |
| C12 | 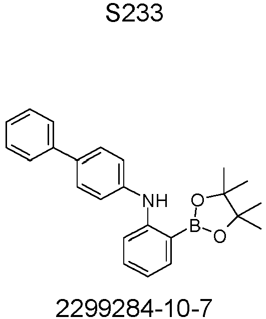 | 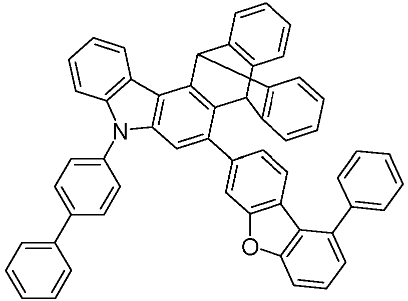 | 35 % |
| C13 | 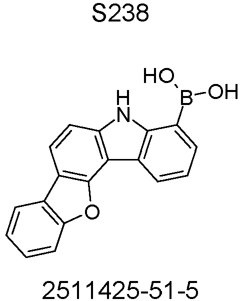 | 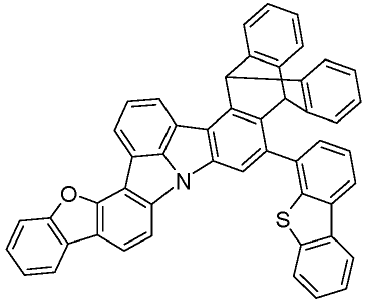 | 30 % |
| C14 | 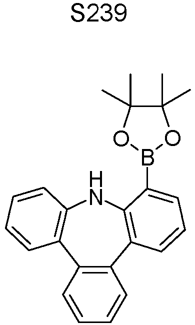 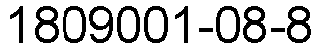 | 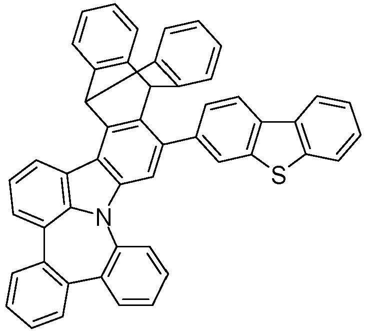 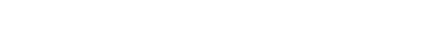 | 33 % |
| C15 | 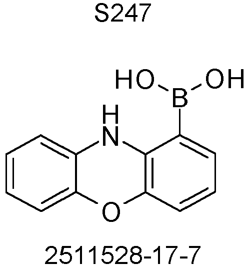 | 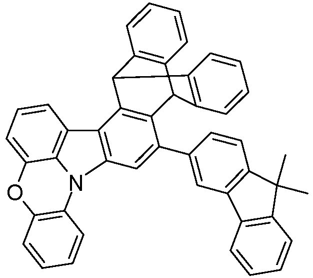 | 38 % |
| C16 | 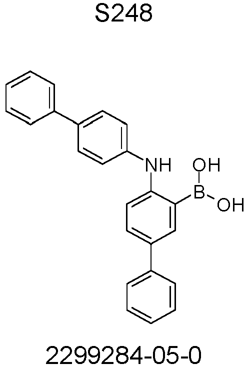 | 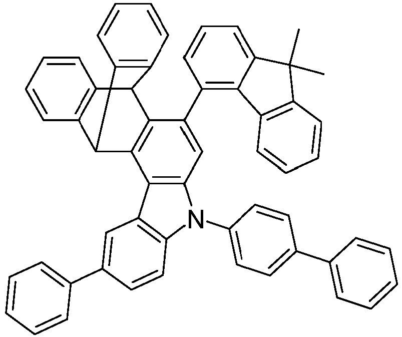 | 43 % |
| C17 | 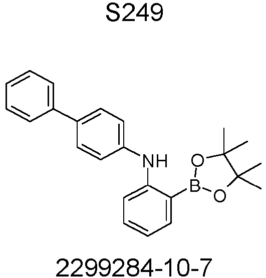 | 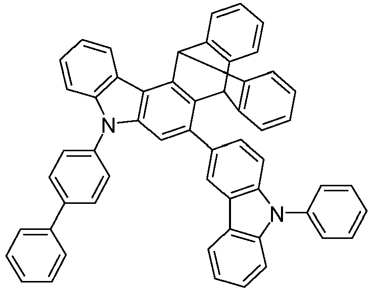 | 40 % |
| C18 | 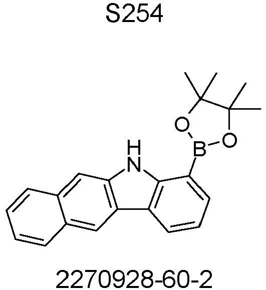 | 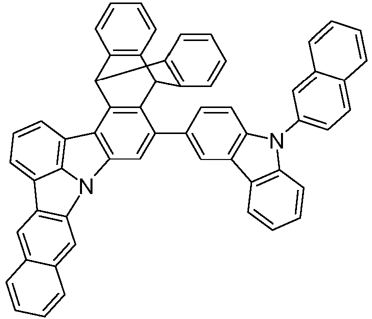 | 28 % |
| C19 | 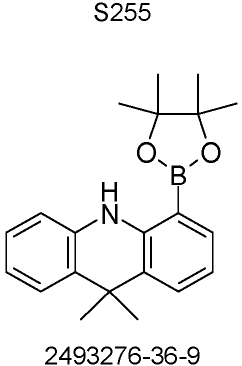 | 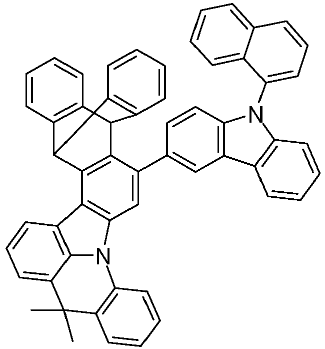 | 34 % |
| C20 | 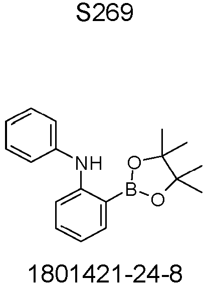 | 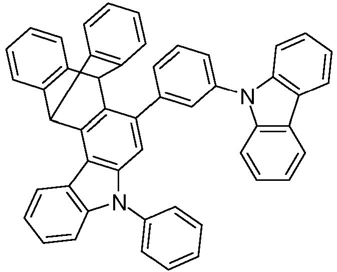 | 37 % |
| C21 | 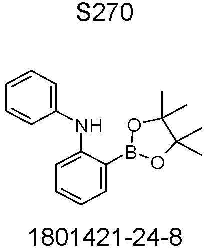 | 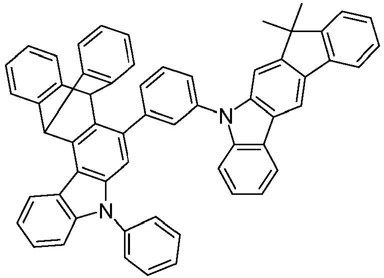 | 40 % |
| C22 | 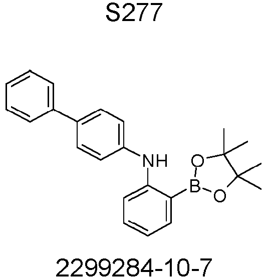 | 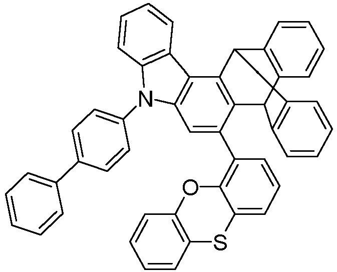 | 32 % |
| C23 | 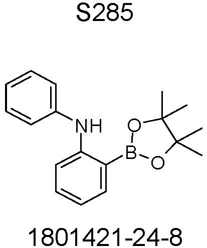 | 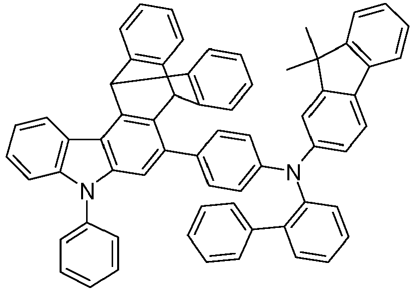 | 34 % |
| C24 | 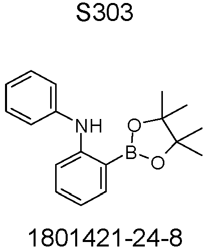 | 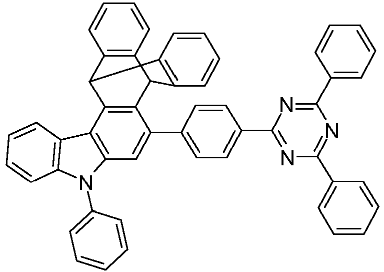 | 39 % |
| C25 | 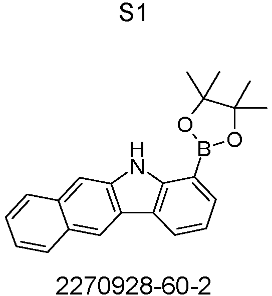 | 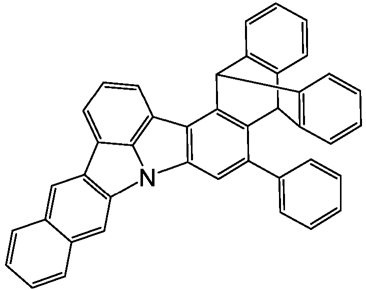 | 30 % |
| C26 | 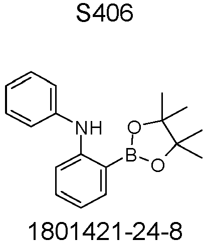 | 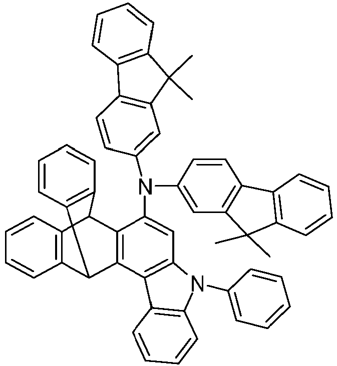 | 32 % |
| C27 | 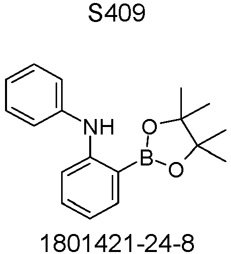 | 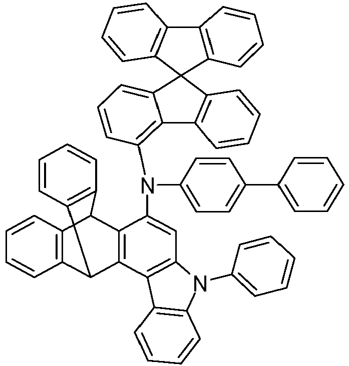 | 37 % |
| C28 | 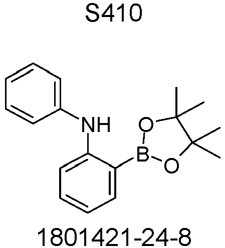 | 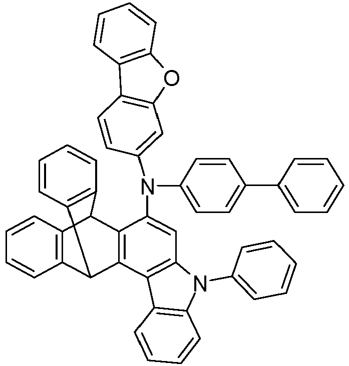 | 41 % |

### Beispiel C100: Carbazole vom Typ2

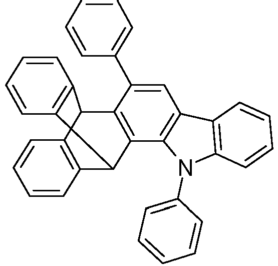

### A) Buchwald-Kupplung

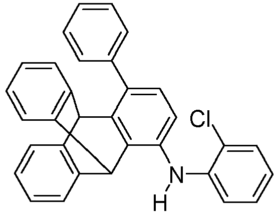

Ein gut gerührtes Gemisch aus 40.9 g (100 mmol) S200, 11.6 g (110 mmol) 2-Chloranilin [95-51-2], 24.0 g (250 mmol) Natrium-tert-butanolat, 263 mg (1.3 mmol) Tri-tert-butylphosphin, 224 mg (1 mmol) Palladium(II)acetat und 500 ml Toluol wird 12 h bei 80 °C gerührt. Nach Abkühlen auf 60 °C fügt man 300 ml Wasser zu, rührt kurz nach, trennt die org. Phase ab, wäscht einmal mit 300 ml Wasser, einmal mit 200 ml ges. Kochsalzlösung und trocknet über Natriumsulfat. Man filtriert vom Trockenmittel über ein mit Toluol vorgeschlämmtes Kieselgelbett ab, engt das Filtrat zur Trockene ein, rührt den Rückstand mit Methanol heiß aus und kristallisiert einmal aus Acetonitril / DCM um. Ausbeute: 38.0 g (83 mmol) 83 %; Reinheit: ca. 97 % ig n. ¹H-NMR.

### B) Cyclisierung

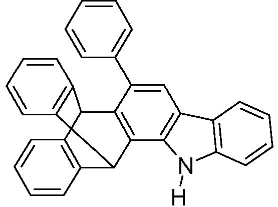

Durchführung analog D100 B), wobei anstelle von D100 A) 45.6 g (100 mmol) C100 A) eingesetzt wird und t-Bu₃PHBF₄ / Pd(OAc)₂ im Verhältnis 1.5:1.0 eingesetzt werden. Anstelle von t-Bu₃PHBF₄ kann auch 1,3-bis[2,6-bis(1-methylethyl)phenyl]-4,5-dihydro-1H-imidazolium-chlorid verwendet werden Ausbeute: 34.2 g (81 mmol) 81 %; Reinheit: ca. 97 % ig n. ¹H-NMR.

### C) Arylierung der NH-Funktion

Durchführung analog K. Suzuki et al, Adv. Synth. & Catal., 2008, 350(5), 652. Ein gut gerührtes Gemisch aus 42.0 g (100 mmol) C100 B), 11.5 ml (110 mmol) Brombenzol [108-86-1], 19.2 g (200 mmol) Natrium-tert-butanolat, 529 mg (1.5 mmol) Bis-1,1-dimethylethyl)(1-methyl-2,2-diphenylcyclopropyl)phosphin [742103-27-1], 224 mg (1 mmol) Palladium(II)acetat und 400 ml o-Xylol wird 16 h unter Rückfluss erhitzt. Nach Abkühlen auf 60 °C fügt man 300 ml Wasser zu, rührt kurz nach, trennt die org. Phase ab, wäscht einmal mit 300 ml Wasser, einmal mit 200 ml ges. Kochsalzlösung und trocknet über Natriumsulfat. Man filtriert vom Trockenmittel über ein mit Toluol vorgeschlämmtes Kieselgelbett ab, engt das Filtrat zur Trockene ein und rührt den Rückstand mit Methanol heiß aus. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum. Ausbeute: 39.6 g (80 mmol) 80 %; Reinheit: ca. 99.9 % ig n. HPLC.

Analog können folgende Verbindungen dargestellt werden:

| Bsp. | Edukt | Produkt | Ausbeute |
|---|---|---|---|
| C101 | 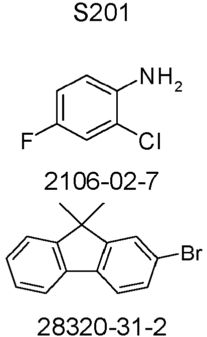 | 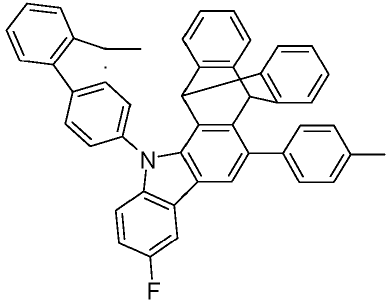 | 65 % |
| C102 | 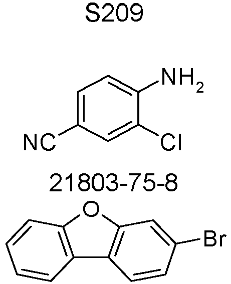 | 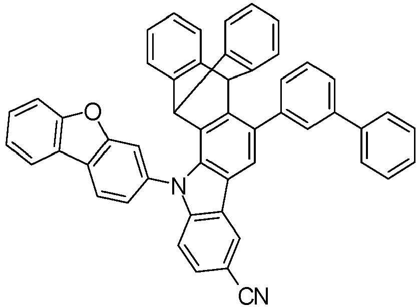 | 51 % |
| | 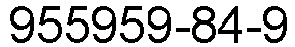 | | |
| C103 | 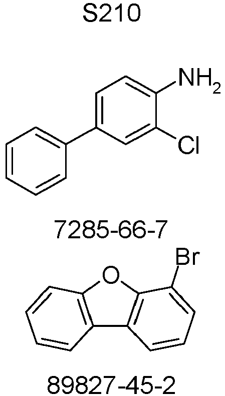 | 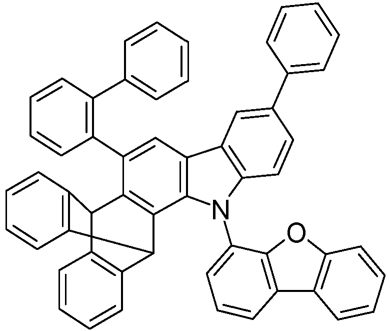 | 55 % |
| C104 | 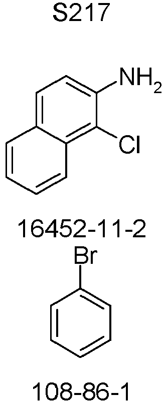 | 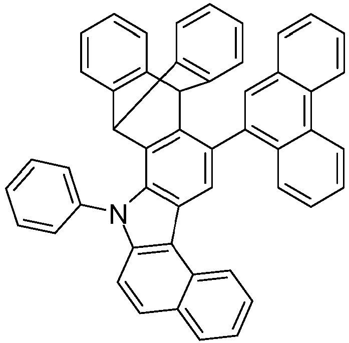 | 60 % |
| C105 | 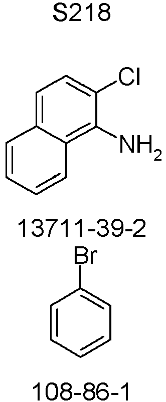 | 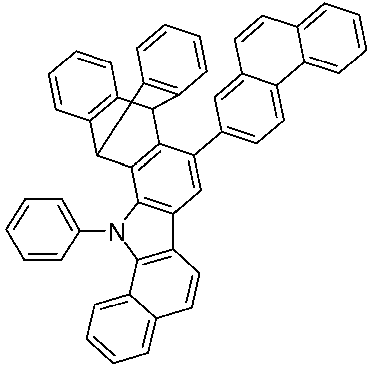 | 41 % |
| C106 | 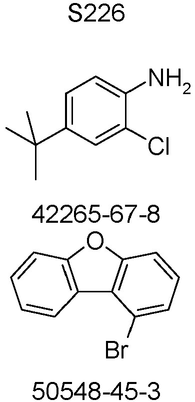 | 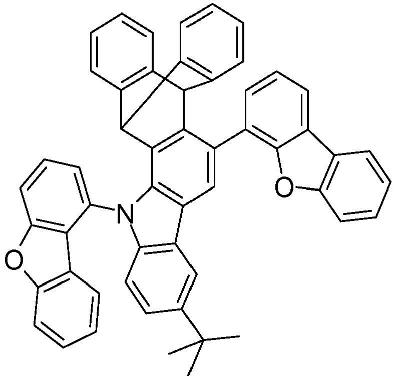 | 46 % |
| C107 | 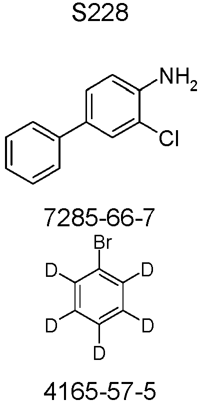 | 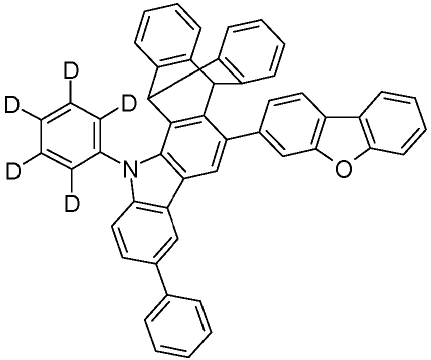 | 56 % |
| C108 | 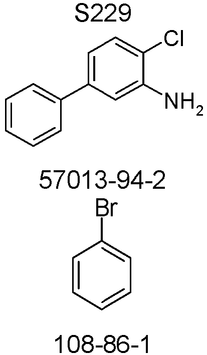 | 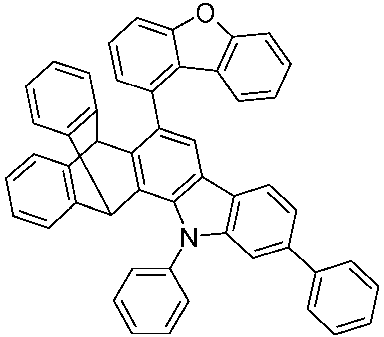 | 58 % |
| C109 | 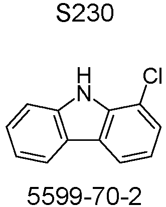 | 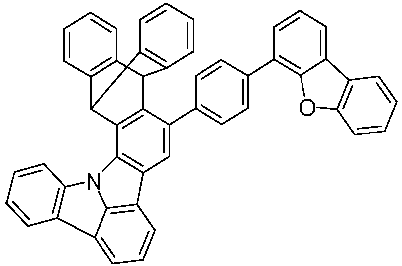 | 42 % |
| C110 | 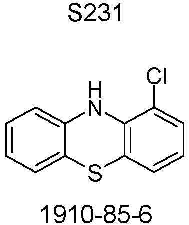 | 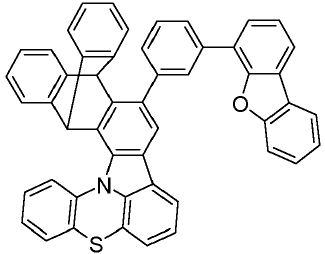 | 33 % |
| C111 | 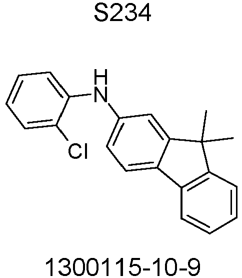 | 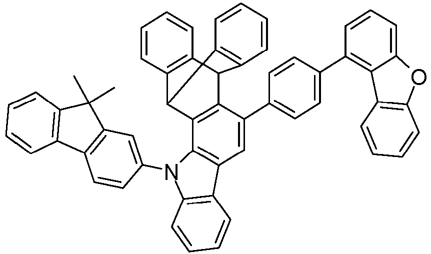 | 27 % |
| C112 | 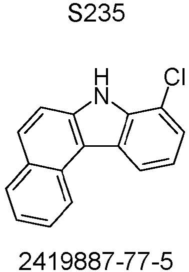 | 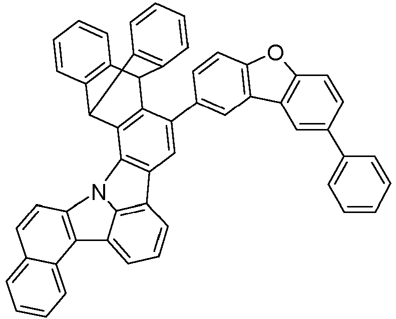 | 40 % |
| C113 | 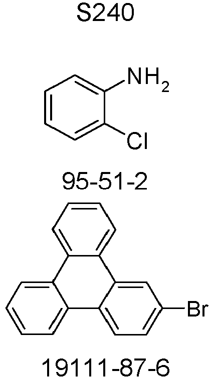 | 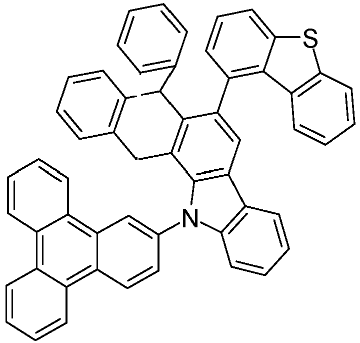 | 53 % |
| C114 | 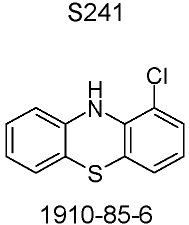 | 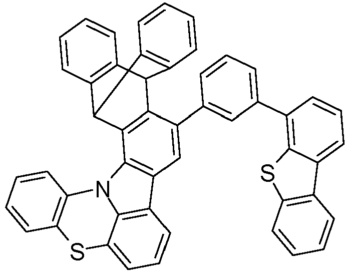 | 45 % |
| C115 | 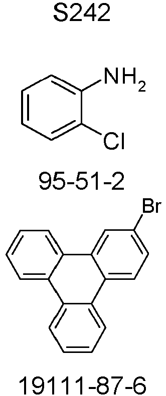 | 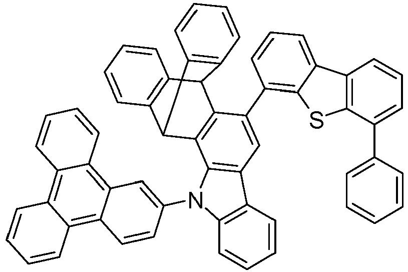 | 47 % |
| C116 | 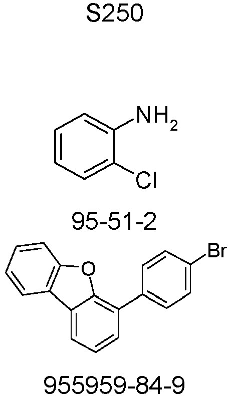 | 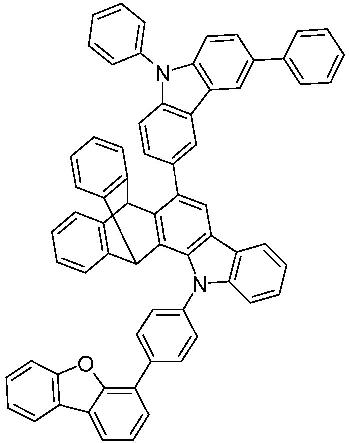 | 54 % |
| C117 | 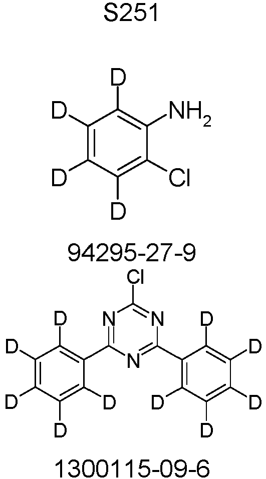 | 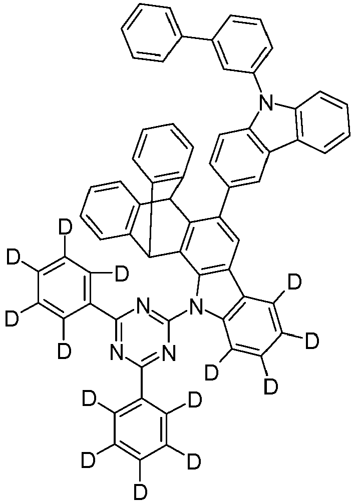 | 59 % |
| C118 | 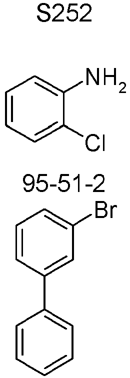 | 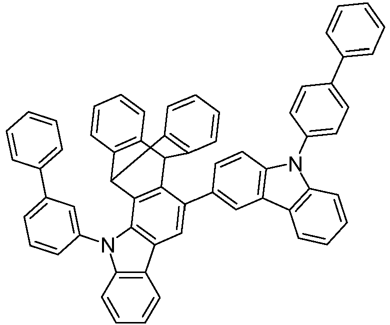 | 55 % |
| | 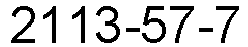 | | |
| C119 | 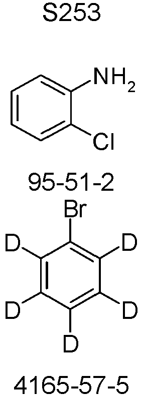 | 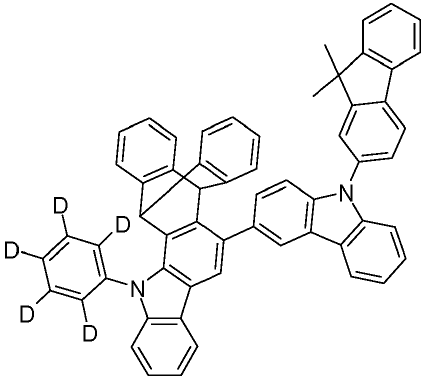 | 57 % |
| C120 | 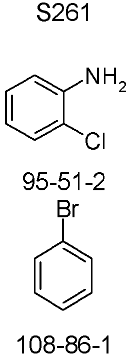 | 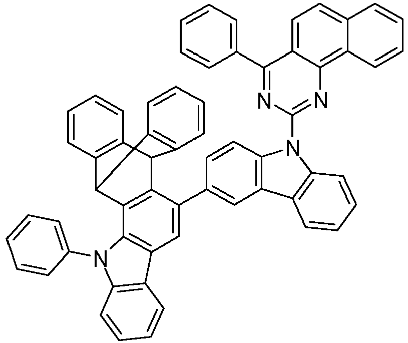 | 60 % |
| C121 | 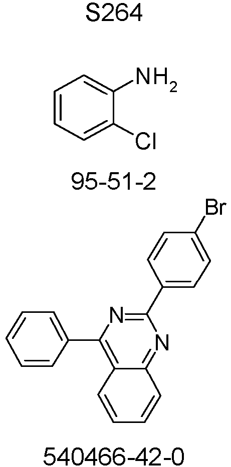 | 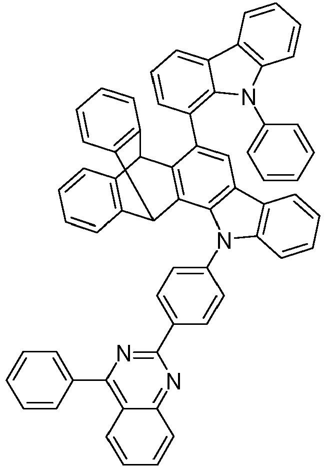 | 50 % |
| C122 | 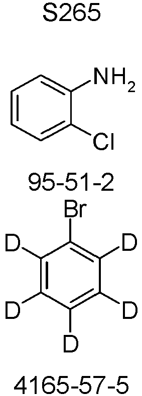 | 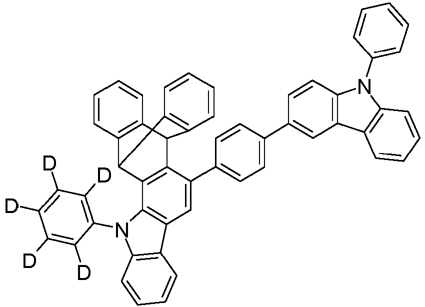 | 53 % |
| C123 | 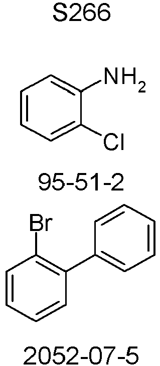 | 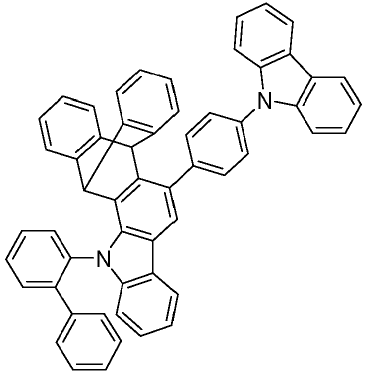 | 51 % |
| C124 | 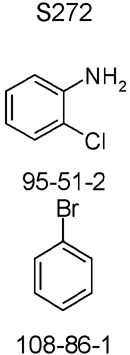 | 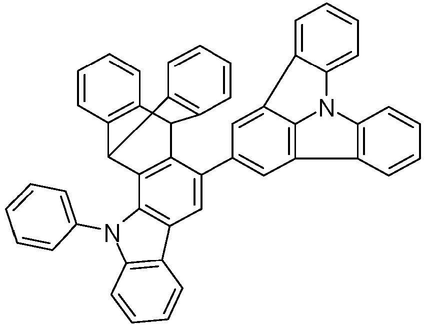 | 54 % |
| C125 | 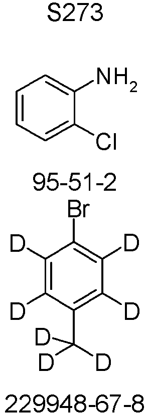 | 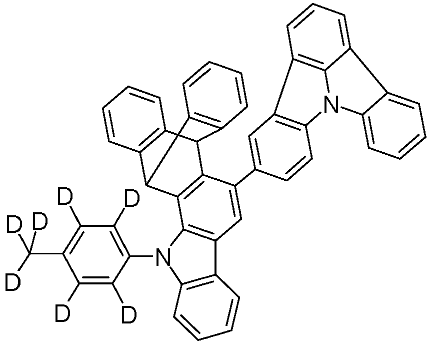 | 59% |
| C126 | 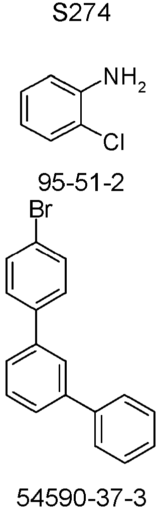 | 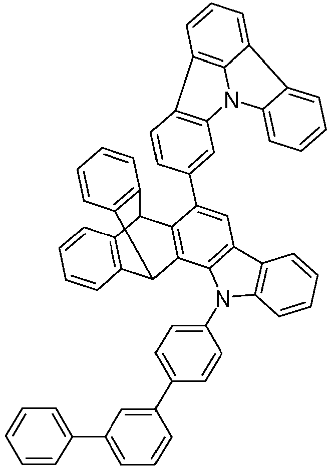 | 53 % |
| C127 | 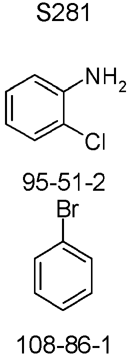 | 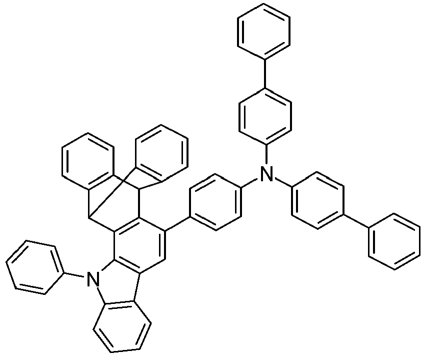 | 62 % |
| C128 | 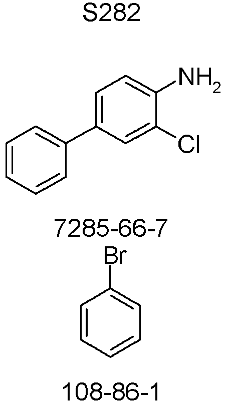 | 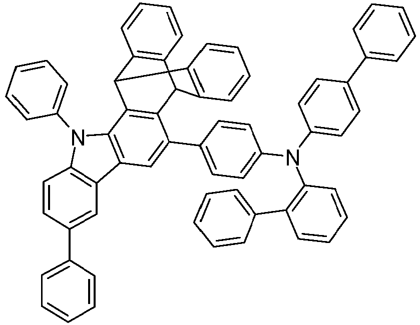 | 58 % |
| C129 | 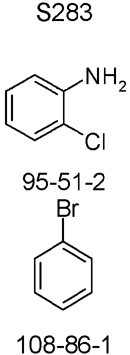 | 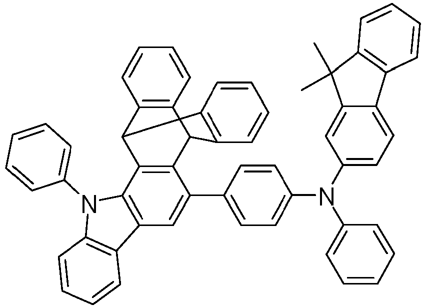 | 60 % |
| C130 | 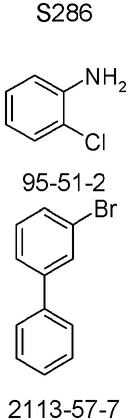 | 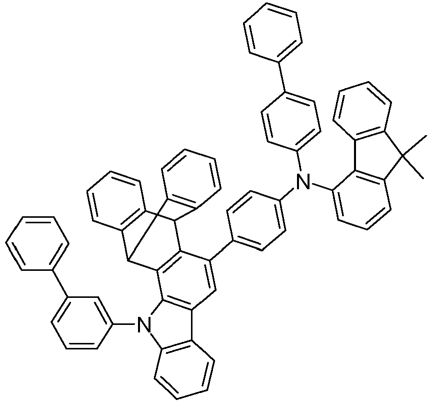 | 55 % |
| C131 | 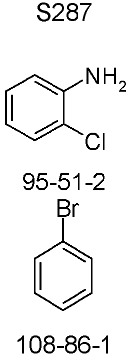 | 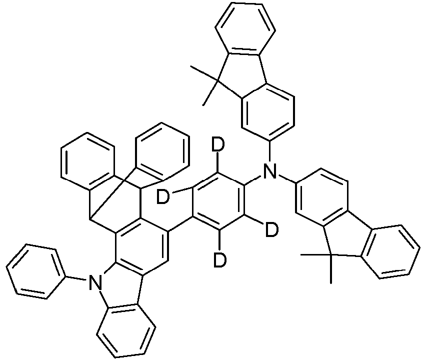 | 57 % |
| C132 | 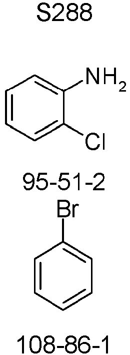 | 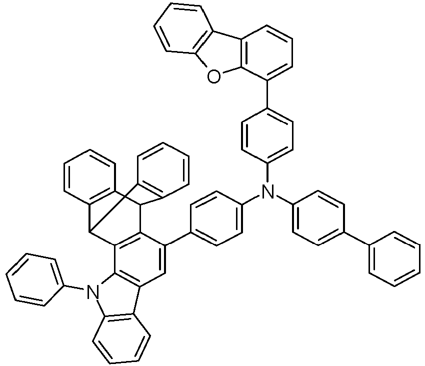 | 59 % |
| C133 | 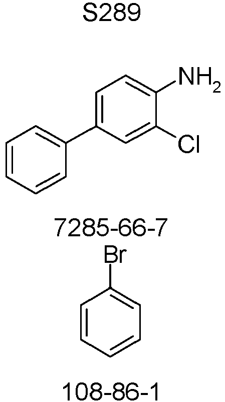 | 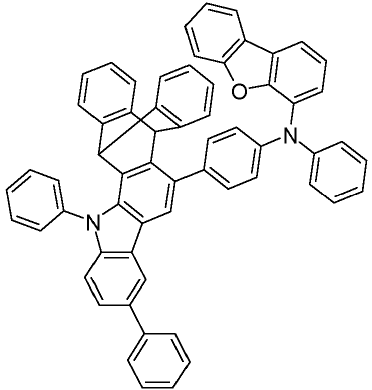 | 54 % |
| C134 | 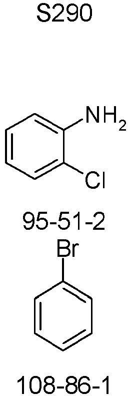 | 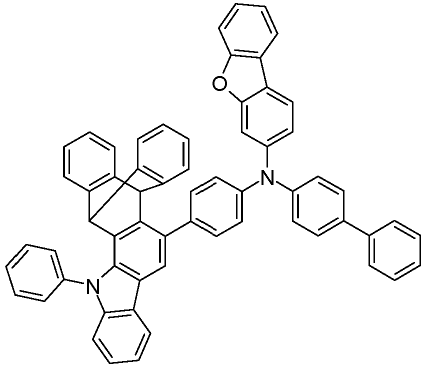 | 60 % |
| C135 | 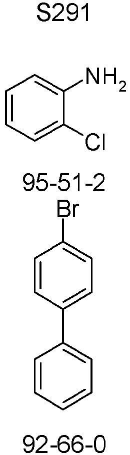 | 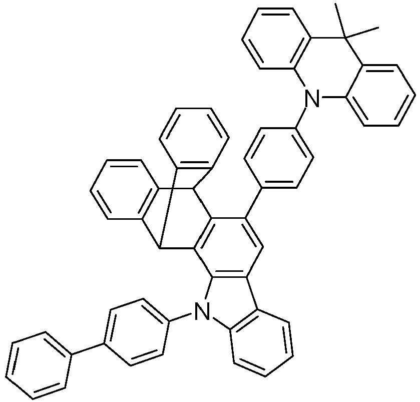 | 57 % |
| C136 | 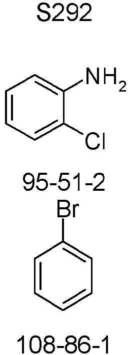 | 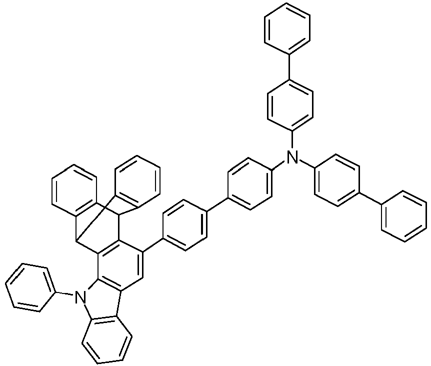 | 55 % |
| C137 | 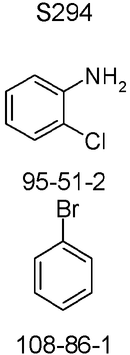 | 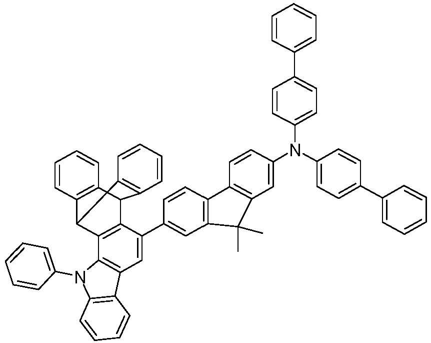 | 53 % |
| C138 | 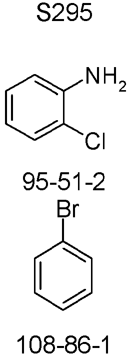 | 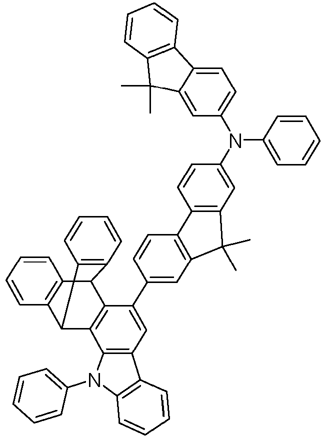 | 57 % |
| C139 | 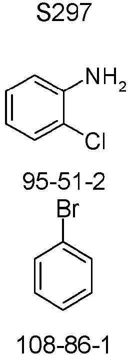 | 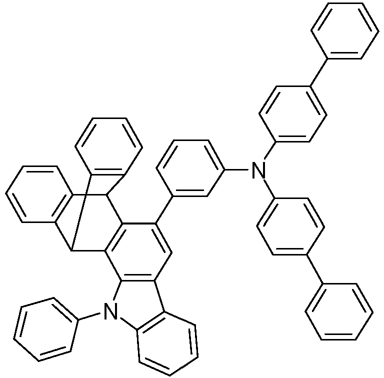 | 61 % |
| C140 | 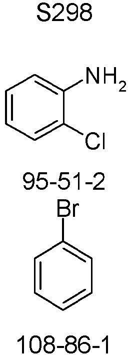 | 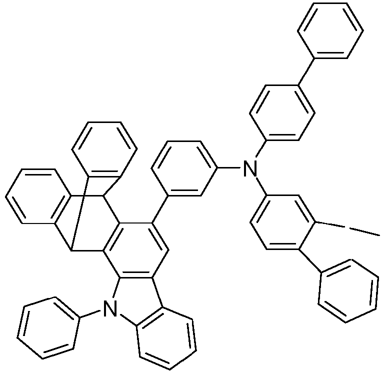 | 59% |
| C141 | 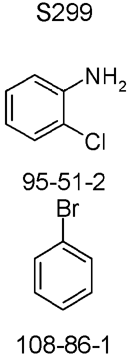 | 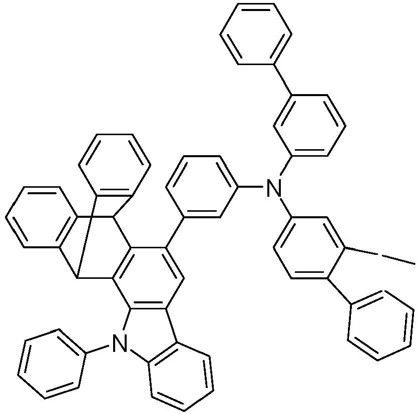 | 57 % |
| C142 | 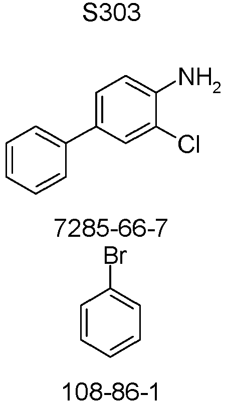 | 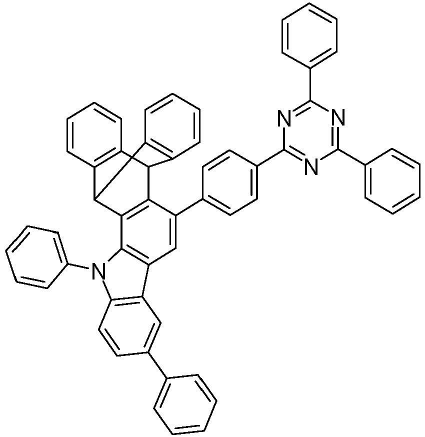 | 60 % |
| C143 | 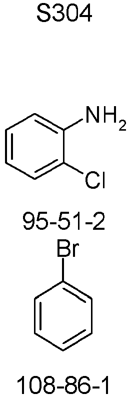 | 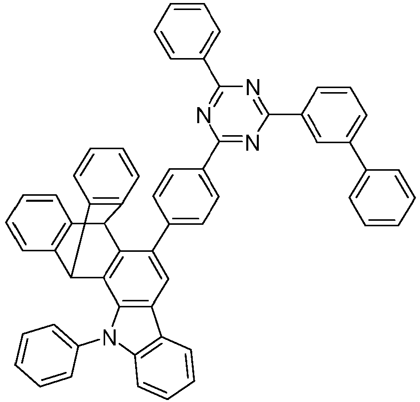 | 58 % |
| C144 | 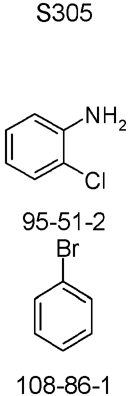 | 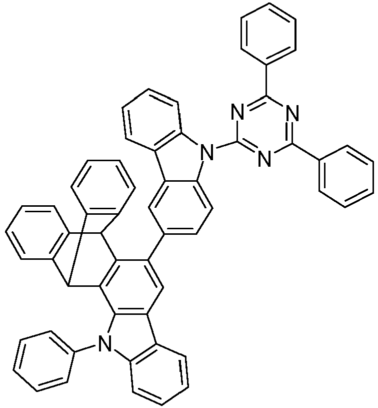 | 49 % |
| C145 | 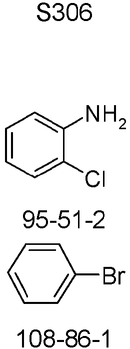 | 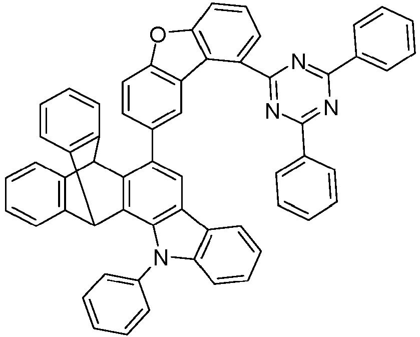 | 52 % |
| C146 | 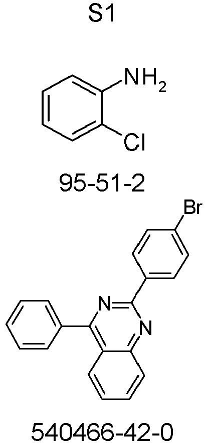 | 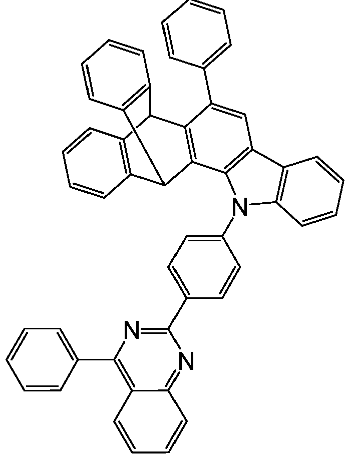 | 58 % |
| C147 | 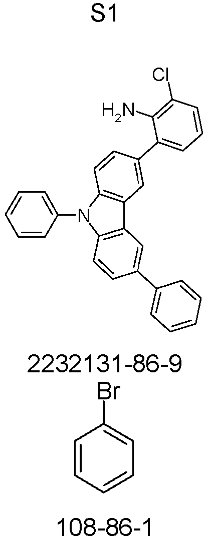 | 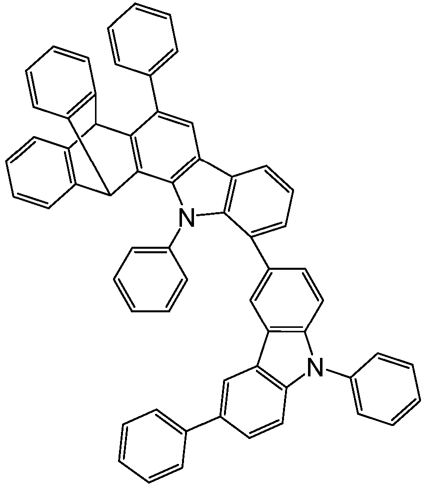 | 46 % |
| C148 | 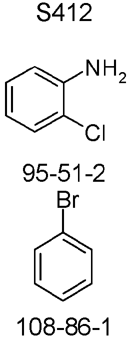 | 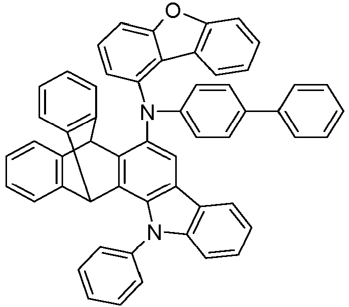 | 84 % |
| C149 | 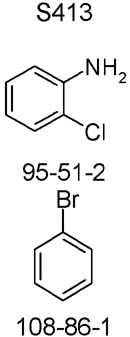 | 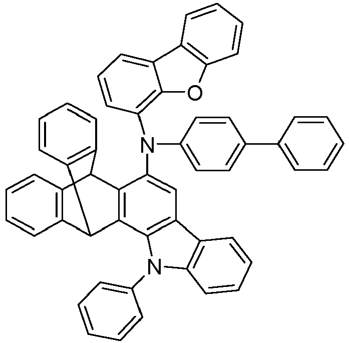 | 86 % |

### Beispiel F1: Fluorene vom Typ 1

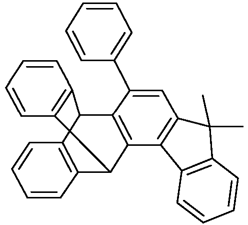

### A) Suzuki-Kupplung

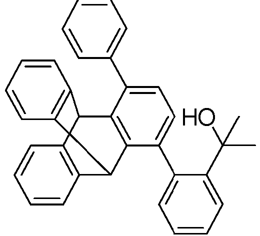

Ein gut gerührtes Gemisch aus 40.9 g (100 mmol) S200, 19.8 g (110 mmol) [2-(1-Hydroxy-1-methylethyl)phenyl]boronsäure [1443380-11-7], 42.5 g (200 mmol) Trikaliumphosphat, 860 mg (2 mmol) S-Phos, 225 mg (1 mmol) Palladium(II)-acetat, 400 ml Toluol, 100 ml Dioxan und 300 ml Wasser wird 16 h unter Rückfluss erhitzt. Nach Erkalten trennt man die org. Phase ab, wäscht zweimal mit je 200 ml Wasser einmal mit 200 ml ges. Kochsalzlösung und trocknet über Magnesiumsulfat. Man filtriert vom Trockenmittel über ein mit Dioxan vorgeschlämmtes Celite-Bett ab, engt das Filtrat zur Trockene ein, rührt den Rückstand mit 200 ml Methanol heiß aus, filtriert ab und trocknet im Vakuum. Ausbeute: 36.2 g (78 mmol), 78 %; Reinheit: ca. 95 % ig. n. ¹H-NMR.

### B) De-hydatisierende Cyclisierung

Ein gut gerührtes Gemisch aus 46.5 g (100 mmol) F1 Stufe A), 350 ml Eisessig und 0.3 ml konz. Salzsäure wird 1 h auf 100 °C erhitzt. Man lässt auf 30 °C erkalten, saugt vom ausgefallenen Rohprodukt ab, wäscht dieses einmal mit 100 ml Eisessig, dreimal mit je 50 ml Methanol und trocknet im Vakuum. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum. Ausbeute: 31.8 g (71 mmol) 71 %; Reinheit: ca. 99.9 % ig n. HPLC.

Analog können folgende Verbindungen dargestellt werden:

| Bsp. | Edukt | Produkt | Ausbeute |
|---|---|---|---|
| F2 | 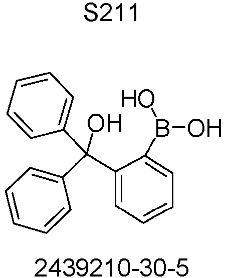 | 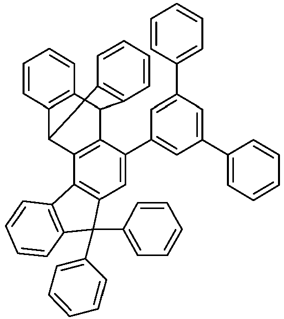 | 56 % |
| F3 | 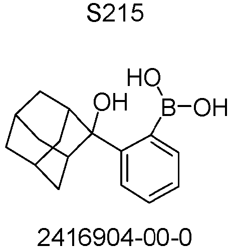 | 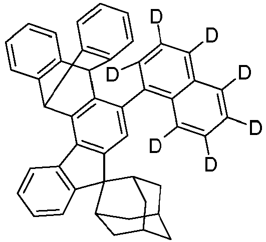 | 43 % |
| F4 | 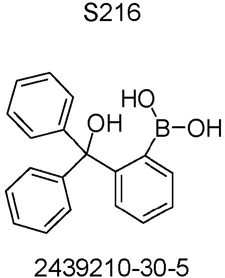 | 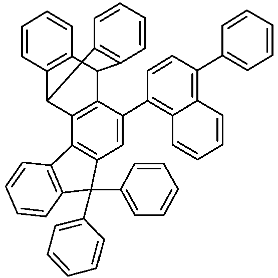 | 48 % |
| F5 | 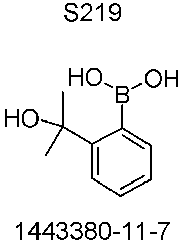 | 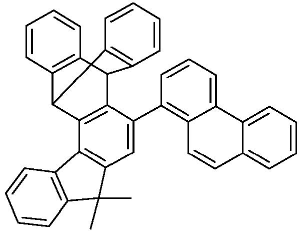 | 60 % |
| F6 | 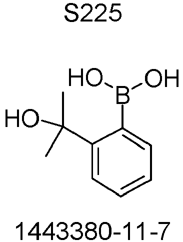 | 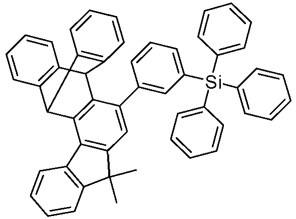 | 21 % |
| F7 | 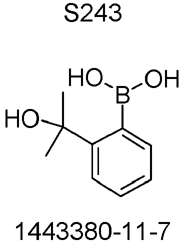 | 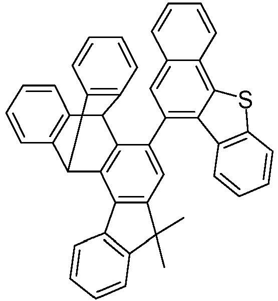 | 61 % |
| F8 | 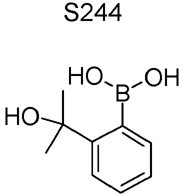 | 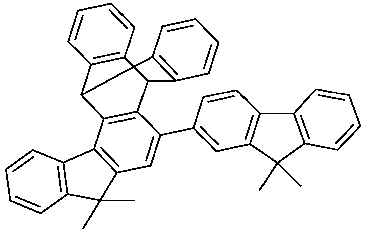 | 67 % |
| | 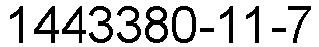 | | |
| F9 | 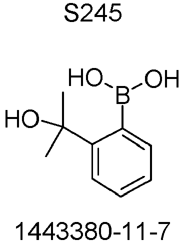 | 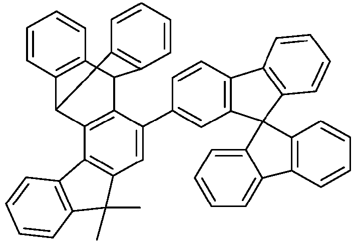 | 63 % |
| F10 | 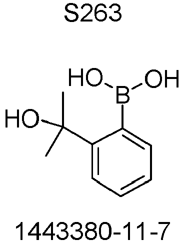 | 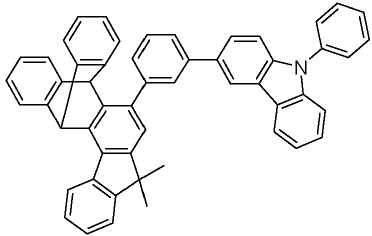 | 58 % |
| F11 | 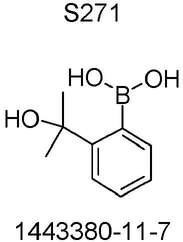 | 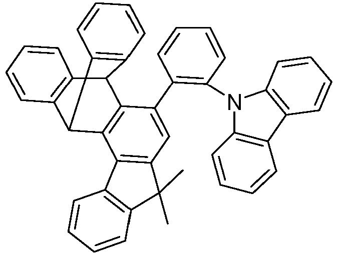 | 55 % |
| F12 | 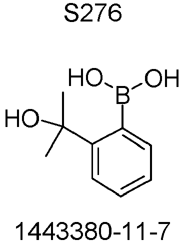 | 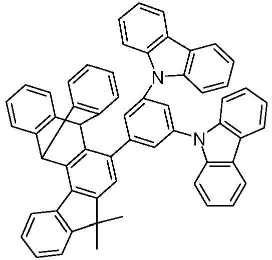 | 49 % |
| F13 | 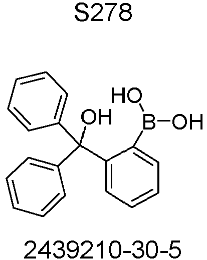 | 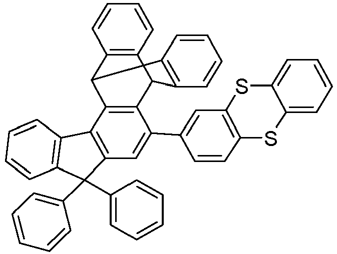 | 45 % |
| F14 | 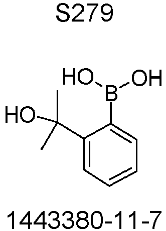 | 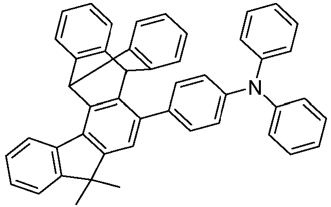 | 63 % |
| F15 | 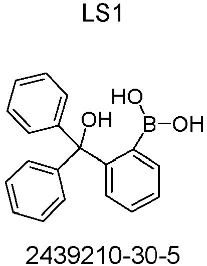 | 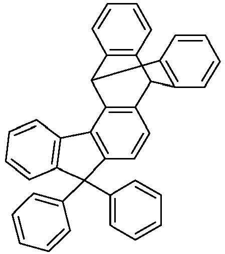 | 66 % |
| F16 | 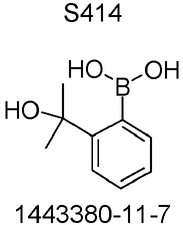 | 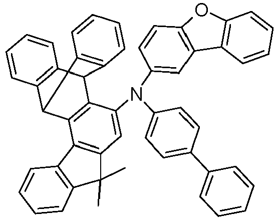 | 55 % |
| F17 | 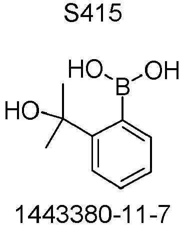 | 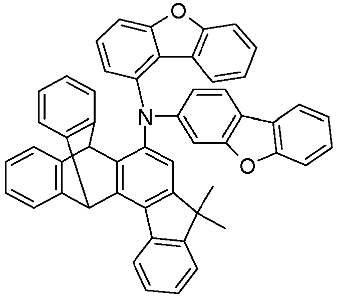 | 57 % |
| F18 | 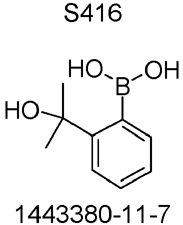 | 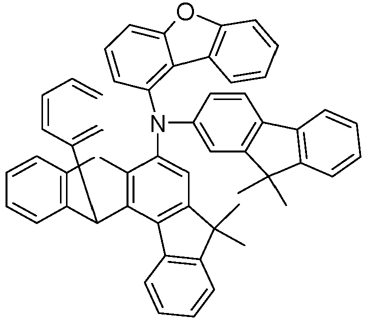 | 54 % |
| F19 | 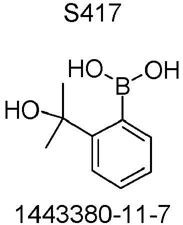 | 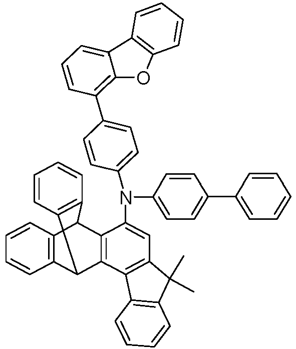 | 60 % |
| F20 | 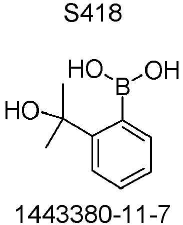 | 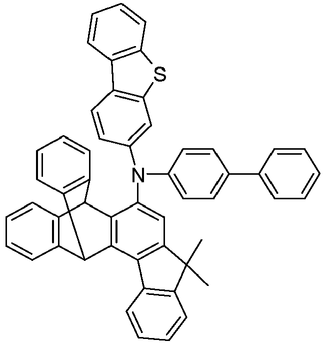 | 59 % |

### Beispiel F100: Fluorene vom Typ2

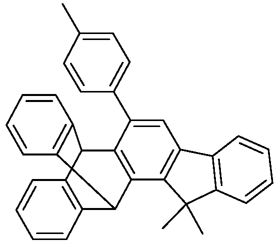

### A) De-Triflatisierung

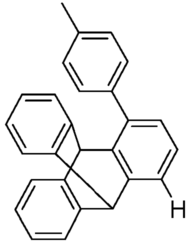

Durchführung analog A. G. Martinez et al, J. Chem. Soc., Perkin Trans. I, 1986, 1595. Eine Lösung aus 49.3 g (100 mmol) S2 in einem Gemisch aus 500 ml THF, 200 ml Methanol und 16.6 ml (120 mmol) Triethylamin wird mit 2.0 g Palladium-Kohle (5 Gew.-%) versetzt und dann in einem Autoklaven bei 40 °C unter 2 bar Wasserstoff für 30 h gerührt. Man filtriert die Reaktionsmischung über ein mit THF vorgeschlämmtes Celite-Bett ab, engt das Filtrat zur Trockene ein, nimmt den Rückstand in 500 ml DCM auf, wäscht dieses zweimal mit je 200 ml Wasser, einmal mit 200 ml ges. Kochsalzlösung und trocknet über Natriumsulfat. Man filtriert vom Trockenmittel über ein mit DCM vorgeschlämmtes Kieselgel-Bett ab, engt das Filtrat ein und substituiert das abrotierte DCM kontinuierlich durch Methanol, saugt das auskristallisierte Produkt ab, wäscht dieses mit wenig Methanol und trocknet im Vakuum. Ausbeute: 29.8 g (89 mmol) 89 %; Reinheit: ca. 98 % ig. n. ¹H-NMR.

### B) Friedel-Crafts-Alkylierung

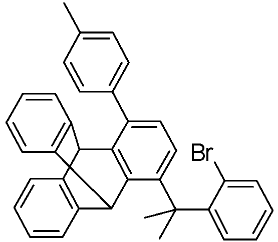

Eine gut gerührte Lösung von 34.5 g (100 mmol) F100 Stufe A) und 1.3 g (10 mmol) Aluminium(III)chlorid, wasserfrei in 500 ml DCM (trocken, Stabilisator-frei) wird tropfenweise bei 5 °C mit einer Lösung von 23.4 g (100 mmol) 1-Brom-2-(1-chlor-1-methylethyl)benzol [7073-71-4] in 300 ml DCM versetzt. Man rührt 2 h bei 5 °C nach, hydrolysiert vorsichtig durch Zugabe von 200 ml Eiswasser, trennt die org. Phase ab, wäscht diese zweimal mit je 100 ml Wasser, einmal mit 100 ml ges. Natriumhydrogencarbonat-Lösung und trocknet über Natriumsulfat. Man filtriert vom Trockenmittel ab, versetzt mit 200 ml Methanol und destilliert dann das DCM langsam ab, wobei das Produkt kristallisiert. Man saugt das Produkt ab, wäscht zweimal mit je 50 ml Methanol, trocknet im Vakuum und kristallisiert abschließend aus Acetonitril / DCM um. Ausbeute: 40.8 g (75 mmol) 75 %; Reinheit: ca. 95 % ig. n. ¹H-NMR.

### C) Cyclisierung

Durchführung analog D100 B), wobei anstelle von D100 A) 54.2 g (100 mmol) F100 Stufe B) eingesetzt wird. Anstelle von Cy₃PHBF₄ kann auch t-Bu₃PHBF₄ oder 1,3-bis[2,6-bis(1-methylethyl)phenyl]-4,5-dihydro-1H-imidazolium-chlorid verwendet werden. Ausbeute: 33.0 g (71 mmol) 71 %; Reinheit: ca. 98 % ig n. ¹H-NMR.

### D) Suzuki-Kupplung der Halogenfunktion

Intermediate F100 Stufe C), die eine Halogenfunktion tragen - wie z.B. F101 Stufe C), F104 Stufe C) bzw. F106 Stufe C) - können analog zu F1 Stufe A) mit einer Boronsäure/ester in einer Suzuki-Kupplung umgesetzt werden. Die weitere Reinigung erfolgt jeweils durch wiederholte Heißextraktionskristallisation (übliche org. Lösungsmittel bzw. deren Kombinationen, bevorzugt Acetonitril-DCM, 1:3 bis 3:1 vv) oder durch Chromatographie und fraktioniere Sublimation bzw. Tempern im Hochvakuum.

Analog können folgende Verbindungen dargestellt werden:

| Bsp. | Edukt | Produkt | |
|---|---|---|---|
| F101 | 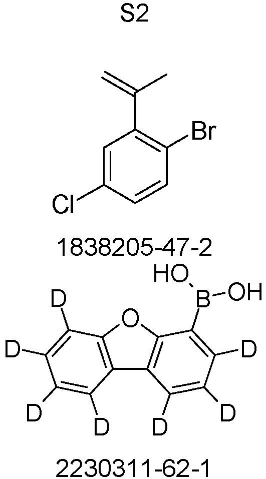 | 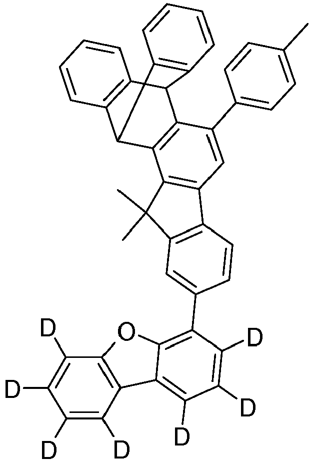 | 28 % |
| F102 | 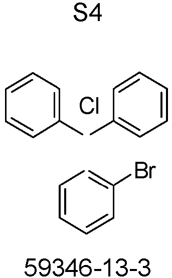 | 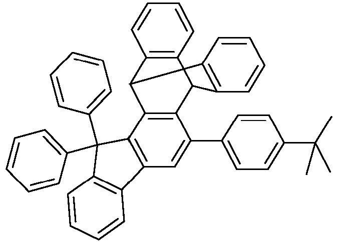 | 41 % |
| F103 | 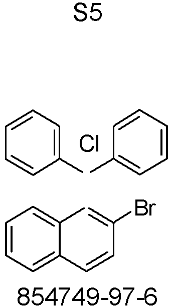 | 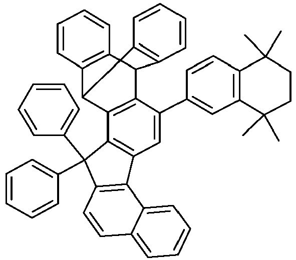 | 36 % |
| F104 | 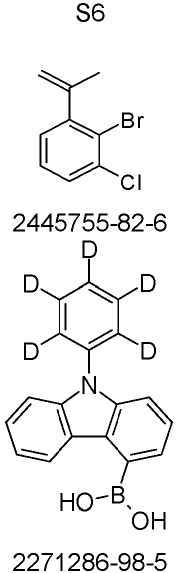 | 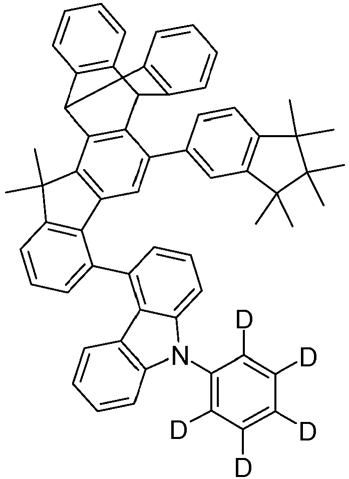 | 30 % |
| F105 | 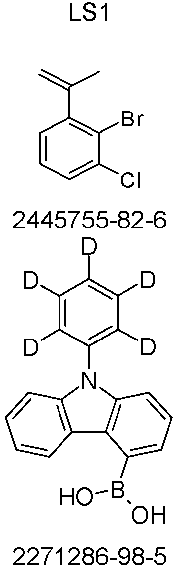 | 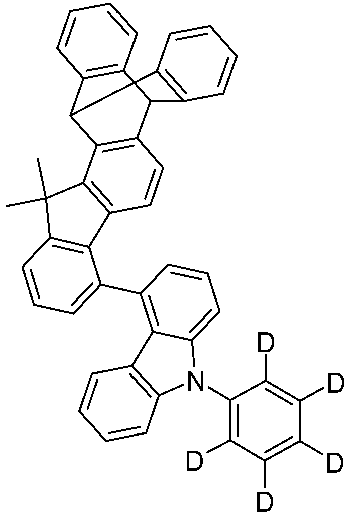 | 22 % |

### Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP). Diese beschichteten Glasplättchen bilden die Substrate, auf welche die OLEDs aufgebracht werden.

### 1a) Blaue Fluoreszenz-OLED- Bauteile - BF:

Die erfindungsgemäßen Verbindungen können in der Lochtransportschicht (HTL), der Elektronenbockerschicht (EBL), Lochblockierschicht (HBL) und der Elektronentransportschicht (ETL) verwendet werden. Alle Materialien werden in einer Vakuumkammer thermisch aufgedampft. Dabei besteht die Emissionsschicht (EML) immer aus mindestens einem Matrixmaterial (Hostmaterial, Wirtsmaterial) SMB (s. Tabelle 1) und einem emittierenden Dotierstoff (Dotand, Emitter) D, der dem Matrixmaterial bzw. den Matrixmaterialien durch Co-Verdampfung in einem bestimmten Volumenanteil beigemischt wird. Eine Angabe wie SMB:D (97:3%) bedeutet hierbei, dass das Material SMB in einem Volumenanteil von 97% und der Dotand D in einem Anteil von 3% in der Schicht vorliegt. Analog kann auch die Elektronentransportschicht aus einer Mischung zweier Materialien bestehen, s. Tabelle 1. Die zur Herstellung der OLEDs verwendeten Materialien sind in Tabelle 5 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Angabe der EQE in (%) und der Spannung in (V) erfolgt bei einer Leuchtdichte von 1000 cd/m². Die Lebensdauer wird bei einer Startleuchtdichte von 10000 cd/m² bestimmt. Die Angabe LT80 in (h) ist die gemessene Zeit, in der die Helligkeit auf 80 % der Anfangshelligkeit abgefallen ist.

### Die OLEDs haben folgenden Schichtaufbau:

### Substrat

Lochinjektionsschicht (HIL) aus HTM1 dotiert mit 5 % NDP-9 (kommerziell erhältlich von der Fa. Novaled), 20 nm
Lochtransportschicht (HTL), s. Tabelle 1
Elektronenblockierschicht (EBL), s. Tabelle 1
Emissionsschicht (EML), s. Tabelle 1
Lochblockerschicht (HBL), s. Tabelle 1
Elektronentransportschicht (ETL), s. Tabelle 1
Elektroneninjektionsschicht (EIL) aus ETM2, 1 nm
Kathode aus Aluminium, 100 nm

**Tabelle 1: Aufbau Blaue Fluoreszenz-OLED-Bauteile**

| **Bsp.** | **HTL** | **EBL** | **EML Dicke** | **HBL Dicke** | **ETL Dicke** |
|---|---|---|---|---|---|
| **BF1** | D113 180 nm | EBM1 10 nm | SMB1:DB1 (95%:5%) 20 nm | --- | ETM1:ETM2 (50%:50%) 30 nm |
| **BF2** | D122 180 nm | EBM1 10 nm | SMB1:DB1 (95%:5%) 20 nm | --- | ETM1:ETM2 (50%:50%) 30 nm |
| **BF3** | C129 180 nm | C28 10 nm | SMB1:DB1 (95%:5%) 20 nm | --- | ETM1:ETM2 (50%:50%) 30 nm |
| **BF4** | HTM1 180 nm | D19 10 nm | SMB1:DB1 (95%:5%) 20 nm | --- | ETM1:ETM2 (50%:50%) 30 nm |
| **BF5** | HTM1 180 nm | D20 10 nm | SMB1:DB1 (95%:5%) 20 nm | --- | ETM1:ETM2 (50%:50%) 30 nm |
| **BF6** | HTM1 180 nm | D115 10 nm | SMB1:DB1 (95%:5%) 20 nm | --- | ETM1:ETM2 (50%:50%) 30 nm |
| **BF7** | HTM1 180 nm | C127 10 nm | SMB1:DB1 (95%:5%) 20 nm | --- | ETM1:ETM2 (50%:50%) 30 nm |
| **BF8** | HTM1 180 nm | EBM1 10 nm | SMB1:DB1 (95%:5%) 20 nm | D14 5 nm | ETM1:ETM2 (50%:50%) 30 nm |
| **BF9** | HTM1 180 nm | EBM1 10 nm | SMB1:DB1 (95%:5%) 20 nm | --- | D14:ETM2 (50%:50%) 30 nm |

**Tabelle 2: Ergebnisse Blaue Fluoreszenz-OLED- Bauteile**

| **Bsp.** | **EQE (%) 1000 cd/m²** | **Spannung (V) 1000 cd/m²** | **LT80 (h) 10000 cd/m²** |
|---|---|---|---|
| **BF1** | 9.6 | 4.0 | 120 |
| **BF2** | 10.2 | 3.8 | 160 |
| **BF3** | 10.0 | 4.2 | 170 |
| **BF4** | 9.8 | 4.0 | 185 |
| **BF5** | 9.9 | 3.9 | 150 |
| **BF6** | 10.0 | 3.8 | 167 |
| **BF7** | 10.3 | 3.8 | 150 |
| **BF8** | 9.3 | 3.9 | 170 |
| **BF9** | 9.8 | 3.8 | 165 |

### 1b) Phosphoreszenz-OLED-Bauteile:

Die erfindungsgemäßen Verbindungen können in der Lochtransportschicht (HTL), der Elektronenbockerschicht (EBL), der Emissionsschicht (EML) als Matrixmaterial (Hostmaterial, Wirtsmaterial), der Lochblockierschicht (HBL), Elektronentransportschicht (ETL), und verwendet werden. Hierfür werden alle Materialien in einer Vakuumkammer thermisch aufgedampft. Dabei besteht die Emissionsschicht immer aus mindestens einem bzw. mehreren Matrixmaterialien M und einem phosphoreszierenden Dotierstoff Ir, der dem Matrixmaterial bzw. den Matrixmaterialien durch Co-Verdampfung in einem bestimmten Volumenanteil beigemischt wird. Eine Angabe wie M1:M2:Ir (55%:35%:10%) bedeutet hierbei, dass das Material M1 in einem Volumenanteil von 55%, M2 in einem Volumenanteil von 35% und Ir in einem Volumenanteil von 10% in der Schicht vorliegt. Analog kann auch die Elektronentransportschicht aus einer Mischung zweier Materialien bestehen. Der genaue Aufbau der OLEDs ist Tabelle 3 zu entnehmen. Die zur Herstellung der OLEDs verwendeten Materialien sind in Tabelle 5 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Angabe der EQE in (%) und der Spannung in (V) erfolgt bei einer Leuchtdichte von 1000 cd/m². Die Lebensdauer wird bei einer Startleuchtdichte von 1000 cd/m² für blau- und rot-, 10000 cd/m² für grün- und gelb-emittierende Bauteile bestimmt. Die Angabe LT80 in (h) ist die gemessene Zeit, in der die Helligkeit auf 80 % der Anfangshelligkeit abfällt.

### Die OLEDs haben folgenden Schichtaufbau:

### Substrat

Lochinjektionsschicht (HIL) aus HTM1 dotiert mit 5 % NDP-9 (kommerziell erhältlich von der Fa. Novaled), 20 nm
Lochtransportschicht (HTL), s. Tabelle 3
Elektronenblockierschicht (EBL), s. Tabelle 3
Emissionsschicht (EML), s. Tabelle 3
Lochblockerschicht (HBL), s. Tabelle 3
Elektronentransportschicht (ETL), s. Tabelle 3
Elektroneninjektionsschicht (EIL) aus ETM2, 1 nm
Kathode aus Aluminium, 100 nm

**Tabelle 3: Aufbau Phosphoreszenz-OLED-Bauteile**

| **Bsp.** | **HTL Dicke** | **EBL Dicke** | **EML Dicke** | **HBL Dicke** | **ETL Dicke** |
|---|---|---|---|---|---|
| **Blau** | | | | | |
| BP1 | HTM1 180 nm | EBM2 20 nm | C1:M4:IrB1 (40%:50%:10%) 25 nm | HBM1 5 nm | ETM1:ETM2 (50%:50%) 30 nm |
| BP2 | HTM1 180 nm | EBM2 20 nm | C20:M4:IrB1 (30%:60%:10%) 25 nm | HBM1 5 nm | ETM1:ETM2 (50%:50%) 30 nm |
| BP3 | HTM1 180 nm | EBM2 20 nm | C100:M4:IrB1 (40%:50%:10%) 25 nm | HBM1 5 nm | ETM1:ETM2 (50%:50%) 30 nm |

| **Grün** | | | | | |
|---|---|---|---|---|---|
| GP1 | D113 50 nm | EBM1 20 nm | M1:M2:IrG1 (30%:60%:10%) 40 nm | HBM1 5 nm | ETM1:ETM2 (50%:50%) 30 nm |
| GP2 | HTM1 50 nm | D21 20 nm | M1:M2:IrG1 (30%:60%:10%) 40 nm | HBM1 5 nm | ETM1:ETM2 (50%:50%) 30 nm |
| GP3 | HTM1 50 nm | D121 20 nm | M1:M2:IrG1 (30%:60%:10%) 40 nm | HBM1 5 nm | ETM1:ETM2 (50%:50%) 30 nm |
| GP4 | HTM1 50 nm | D122 20 nm | M1:M2:IrG1 (30%:60%:10%) 40 nm | HBM1 5 nm | ETM1:ETM2 (50%:50%) 30 nm |
| GP5 | HTM1 50 nm | EBM1 20 nm | D118:M2:IrG1 (25%:65%:10%) 40 nm | HBM1 5 nm | ETM1:ETM2 (50%:50%) 30 nm |
| GP6 | HTM1 50 nm | EBM1 20 nm | C142:M2:IrG1 (30%:60%:10%) 40 nm | HBM1 5 nm | ETM1:ETM2 (50%:50%) 30 nm |
| GP7 | HTM1 50 nm | EBM1 20 nm | C143:M2:IrG1 (30%:60%:10%) 40 nm | HBM1 5 nm | ETM1:ETM2 (50%:50%) 30 nm |
| GP8 | HTM1 50 nm | EBM1 20 nm | M1:D108:IrG1 (30%:60%:10%) 40 nm | HBM1 5 nm | ETM1:ETM2 (50%:50%) 30 nm |
| GP9 | HTM1 50 nm | EBM1 20 nm | M1:D109:IrG1 (25%:65%:10%) 40 nm | HBM1 5 nm | ETM1:ETM2 (50%:50%) 30 nm |
| GP10 | HTM1 50 nm | EBM1 20 nm | M1:C17:IrG1 (30%:60%:10%) 40 nm | HBM1 5 nm | ETM1:ETM2 (50%:50%) 30 nm |
| GP11 | HTM1 50 nm | EBM1 20 nm | M1:C118:IrG1 (30%:60%:10%) 40 nm | HBM1 5 nm | ETM1:ETM2 (50%:50%) 30 nm |
| GP12 | HTM1 50 nm | EBM1 20 nm | C117:M2:IrG1 (60%:30%:10%) 40 nm | HBM1 5 nm | ETM1:ETM2 (50%:50%) 30 nm |
| GP13 | HTM1 50 nm | EBM1 20 nm | M1:C122:IrG1 (30%:60%:10%) 40 nm | D118 5 nm | ETM1:ETM2 (50%:50%) 30 nm |

| **Gelb** | | | | | |
|---|---|---|---|---|---|
| GP50 | C129 40 nm | EBM1 20 nm | M1:M2:IrG2 (22%:66%:12%) 40 nm | HBM1 5 nm | ETM1:ETM2 (50%:50%) 30 nm |
| GP51 | HTM1 40 nm | C128 20 nm | M1:M2:IrG2 (22%:66%:12%) 40 nm | HBM1 5 nm | ETM1:ETM2 (50%:50%) 30 nm |
| GP52 | HTM1 40 nm | C132 20 nm | M1:M2:IrG2 (22%:66%:12%) 40 nm | HBM1 5 nm | ETM1:ETM2 (50%:50%) 30 nm |
| GP53 | HTM1 40 nm | C139 20 nm | M1:M2:IrG2 (22%:66%:12%) 40 nm | HBM1 5 nm | ETM1:ETM2 (50%:50%) 30 nm |
| GP54 | HTM1 40 nm | C141 20 nm | M1:M2:IrG2 (22%:66%:12%) 40 nm | HBM1 5 nm | ETM1:ETM2 (50%:50%) 30 nm |
| GP55 | HTM1 40 nm | EBM1 20 nm | C24:M2:IrG2 (22%:66%:12%) 40 nm | HBM1 5 nm | ETM1:ETM2 (50%:50%) 30 nm |
| GP56 | HTM1 40 nm | EBM1 20 nm | C144:M2IrG2 (22%:66%:12%) 40 nm | HBM1 5 nm | ETM1:ETM2 (50%:50%) 30 nm |
| GP57 | HTM1 40 nm | EBM1 20 nm | C145:M2:IrG2 (22%:66%:12%) 40 nm | HBM1 5 nm | ETM1:ETM2 (50%:50%) 30 nm |
| GP58 | HTM1 40 nm | EBM1 20 nm | M1:D4:IrG2 (50%:34%:16%) 40 nm | HBM1 5 nm | ETM1:ETM2 (50%:50%) 30 nm |

| **Rot** | | | | | |
|---|---|---|---|---|---|
| RP1 | HTM1 90 nm | D123 10 nm | M5:IrR1 (92%:8%) 35 nm | HBM1 10 nm | ETM1:ETM2 (50%:50%) 30 nm |
| RP2 | HTM1 90 nm | F16 10 nm | M5:IrR1 (92%:8%) 35 nm | HBM1 10 nm | ETM1:ETM2 (50%:50%) 30 nm |
| RP3 | HTM1 90 nm | F19 10 nm | M5:IrR1 (92%:8%) 35 nm | HBM1 10 nm | ETM1:ETM2 (50%:50%) 30 nm |
| RP4 | HTM1 90 nm | F20 10 nm | M5:IrR1 (92%:8%) 35 nm | HBM1 10 nm | ETM1:ETM2 (50%:50%) 30 nm |
| RP5 | HTM1 90 nm | EBM1 10 nm | C120:IrR1 (92%:8%) 35 nm | HBM1 10 nm | ETM1:ETM2 (50%:50%) 30 nm |
| RP6 | HTM1 90 nm | EBM1 10 nm | C121:IrR1 (92%:8%) 35 nm | HBM1 10 nm | ETM1:ETM2 (50%:50%) 30 nm |
| RP7 | HTM1 90 nm | C140 10 nm | C146: IrR1 (92%:8%) 35 nm | HBM1 10 nm | ETM1:ETM2 (50%:50%) 30 nm |

**Tabelle 4: Ergebnisse Phosphoreszenz-OLED-Bauteile**

| **Blau** | | | |
|---|---|---|---|
| **Bsp.** | **EQE (%)** | **Spannung (V)** | **LT80 (h)** |
| | **1000 cd/m²** | **1000 cd/m²** | **1000 cd/m²** |
| BP1 | 22.4 | 4.1 | 170 |
| BP2 | 21.2 | 4.0 | 190 |
| BP3 | 22.6 | 4.2 | 200 |

| **Grün** | | | |
|---|---|---|---|
| **Bsp.** | **EQE (%)** | **Spannung (V)** | **LT80 (h)** |
| | **1000 cd/m²** | **1000 cd/m²** | **10000 cd/m²** |
| GP1 | 23.1 | 3.1 | 3100 |
| GP2 | 22.8 | 3.0 | 3300 |
| GP3 | 22.9 | 2.9 | 3200 |
| GP4 | 23.0 | 3.9 | 3400 |
| GP6 | 22.5 | 2.8 | 3500 |
| GP7 | 22.7 | 2.8 | 3600 |
| GP8 | 23.3 | 3.0 | 3100 |
| GP9 | 23.5 | 3.2 | 3300 |
| GP10 | 23.2 | 3.0 | 3500 |
| GP11 | 23.4 | 2.9 | 3600 |
| GP12 | 22.9 | 2.9 | 3700 |
| GP13 | 23.2 | 2.8 | 3400 |

| **Gelb** | | | |
|---|---|---|---|
| GP50 | 31.0 | 3.0 | 18000 |
| GP51 | 30.5 | 2.9 | 17000 |
| GP52 | 30.9 | 2.9 | 19000 |
| GP53 | 30.9 | 3.1 | 21000 |
| GP54 | 31.2 | 3.1 | 20000 |
| GP55 | 31.7 | 2.9 | 22000 |
| GP56 | 31.5 | 2.9 | 21000 |
| GP57 | 30.7 | 3.0 | 19000 |
| GP58 | 28.2 | 3.3 | 24000 |

| **Rot** | | | |
|---|---|---|---|
| **Bsp.** | **EQE (%)** | **Spannung (V)** | **LT80 (h)** |
| | **1000 cd/m²** | **1000 cd/m²** | **1000 cd/m²** |
| RP1 | 17.0 | 3.1 | 16000 |
| RP2 | 17.2 | 3.0 | 15000 |
| RP3 | 17.1 | 3.0 | 17000 |
| RP4 | 16.7 | 3.2 | 13000 |
| RP5 | 17.2 | 3.1 | 17000 |
| RP6 | 16.9 | 3.0 | 16000 |
| RP7 | 17.5 | 3.1 | 17000 |

**Tabelle 5: Strukturformeln der verwendeten Materialien**

| | |
|---|---|
| 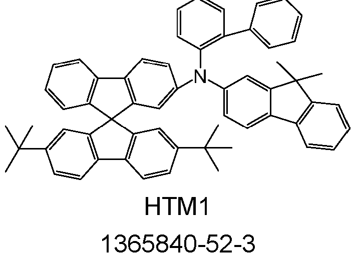 | 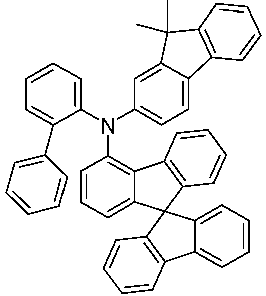 |
| | 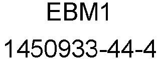 |
| 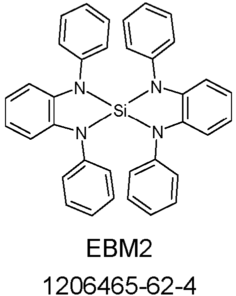 | 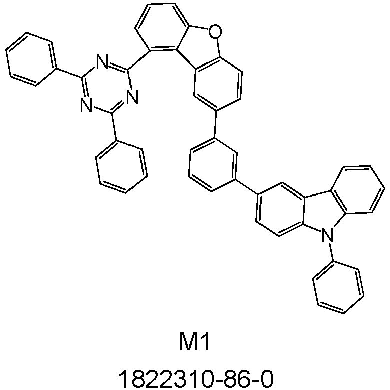 |
| 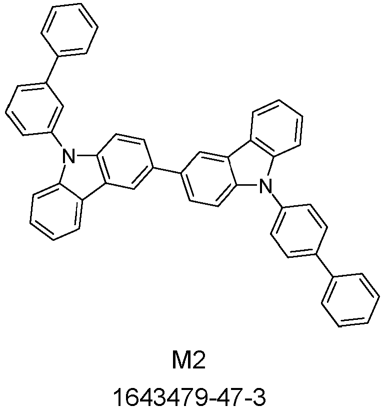 | 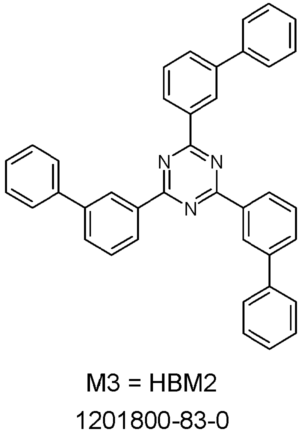 |
| 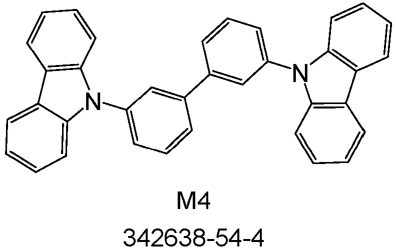 | 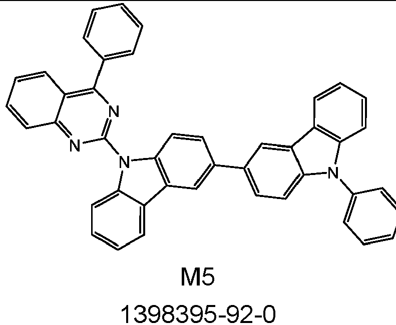 |
| 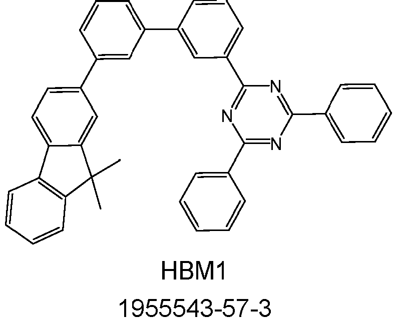 | 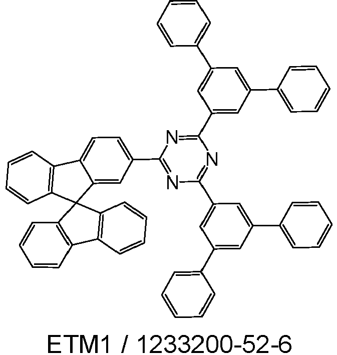 |
| 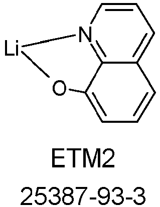 | 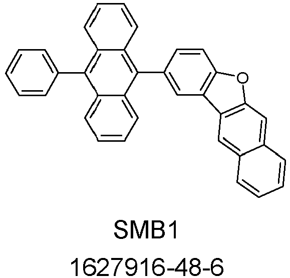 |
| Fluoreszent Blau | Phosphoreszent Blau |
| 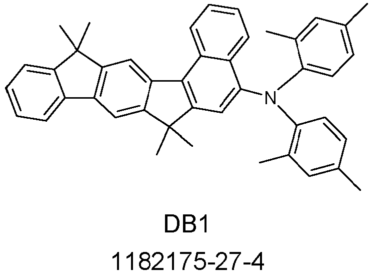 | 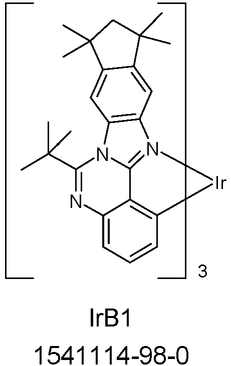 |
| Phosphoreszent Grün | Phosphoreszent Gelb |
| 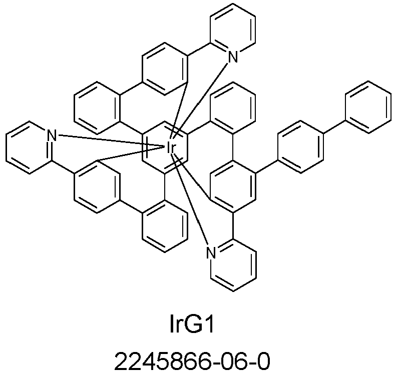 | 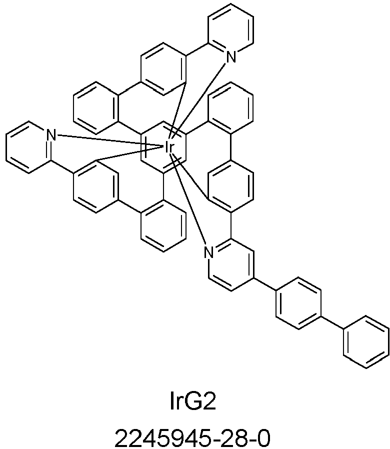 |
| Phosphoreszent Tiefrot | |
| 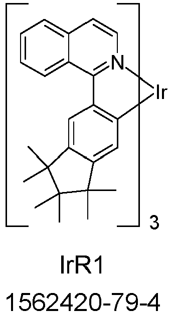 | |

## Patentansprüche

1. Verbindung gemäß Formel (1) (1), 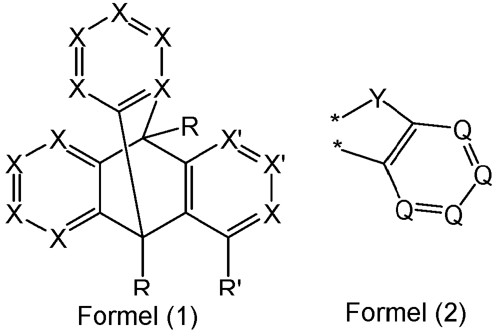 sowie Enantiomere davon, wobei für die verwendeten Symbole gilt:
X ist gleich oder verschieden bei jedem Auftreten CR oder N mit der Maßgabe, dass maximal zwei Gruppen X pro Zyklus für N stehen;
X' stehen für C, welche über die mit * bezeichneten Bindungen in Formel (2) ein an den Zyklus ankondensiertes aromatisches oder heteroaromatisches Ringsystem bilden;
Y ist bei jedem Auftreten gleich oder verschieden ein BR, C(R)₂, Si(R)₂, Ge(R)₂, Sn(R)₂, O, S, Se, SO, SO₂, PR, P(=O)R, Bi(O)R², BiR²; wobei bei C(R)₂ R über ein Kohlenstoffatom angebunden ist;
Q ist gleich oder verschieden bei jedem Auftreten CR oder N mit der Maßgabe, dass maximal zwei Gruppen Q pro Zyklus für N stehen;
R ist bei jedem Auftreten gleich oder verschieden H, D, F, Cl, Br, I, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, eine geradkettige Alkylgruppe mit 1 bis 20 C-Atomen oder eine Alkenyl- oder Alkinylgruppe mit 2 bis 20 C-Atomen oder eine verzweigte oder zyklische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch -R¹C=CR¹-, -C≡C-, Si(R¹)₂, NR¹, CONR¹, C=O, C=S, -C(=O)O-, P(=O)(R¹), -O-, -S-, SO oder SO₂ ersetzt sein können, oder ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann, wobei zwei oder mehr bevorzugt an den gleichen Zyklus gebundene Reste R miteinander ein aliphatisches, heteroaliphatisches, aromatisches oder heteroaromatisches Ringsystem bilden können, das mit einem oder mehreren Resten R¹ substituiert sein kann, und wobei zwei an dasselbe Kohlenstoff- Silizium-, Germanium- oder Zinnatom gebundene Reste R ein monozyklisches oder polyzyklisches, aliphatisches, aromatisches oder heteroaromatisches Ringsystem miteinander bilden können, das mit einem oder mehreren Resten R¹ substituiert sein kann;
R' ist bei jedem Auftreten gleich oder verschieden H, D, F, Cl, Br, I, N(Ar')₂, N(R¹)₂, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R', S(=O)₂R¹, SR¹, ein aromatisches oder heteroaromatisches Ringsystem mit 5 bis 60 aromatischen Ringatomen, bevorzugt mit 5 bis 40 aromatischen Ringatomen, das jeweils durch einen oder mehrere Reste R¹ substituiert sein kann;
Ar' ist bei jedem Auftreten gleich oder verschieden ein aromatisches oder heteroaromatisches Ringsystem mit 5 bis 40 aromatischen Ringatomen, das durch einen oder mehrere Reste R' substituiert sein kann;
R¹ ist bei jedem Auftreten gleich oder verschieden H, D, F, I, B(OR²)₂, CHO, C(=O)R², CR²=C(R²)₂, CN, C(=O)OR², Si(R²)₃, NO₂, P(=O)(R²)₂, OSO_{2R}², SR², OR², S(=O)R², S(=O)₂R², eine geradkettige Alkylgruppe mit 1 bis 20 C-Atomen oder eine Alkenyl- oder Alkinylgruppe mit 2 bis 20 C-Atomen oder eine verzweigte oder zyklische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere CH₂-Gruppen in den oben genannten Gruppen durch -R²C=CR²-, -C≡C-, Si(R²)₂, C=O, C=S, -C(=O)O-, NR², CONR², P(=O)(R²), -O-, -S-, SO oder SO₂ ersetzt sein können und wobei ein oder mehrere H-Atome in den oben genannten Gruppen durch D, F, Cl, Br, I, CN oder NO₂ ersetzt sein können, oder ein aromatisches oder heteroaromatisches Ringsystem mit 5 bis 30 aromatischen Ringatomen, das jeweils durch einen oder mehrere Reste R² substituiert sein kann, wobei zwei oder mehr Reste R¹ miteinander ein aliphatisches, heteroaliphatisches, aromatisches oder heteroaromatisches Ringsystem bilden können;
R² ist bei jedem Auftreten gleich oder verschieden H, D, F, CN oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden.

2. Verbindung nach Anspruch 1, ausgewählt aus den Verbindungen der Formeln (3) oder (4), 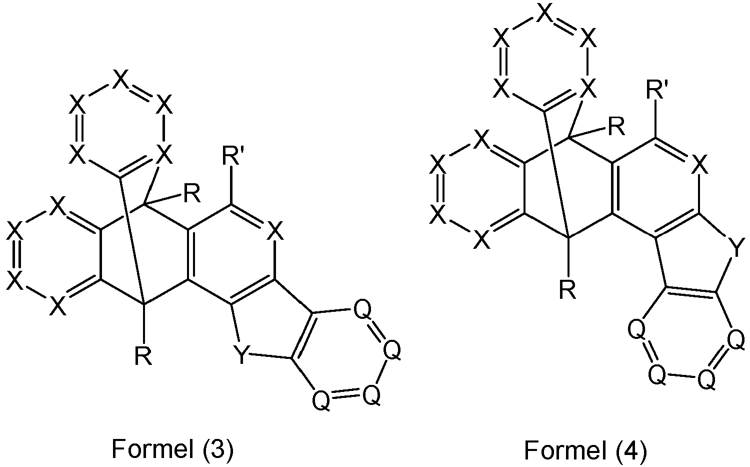 sowie Enantiomere davon, wobei die verwendeten Symbole die in Anspruch 1 genannten Bedeutungen aufweisen.

3. Verbindung nach einem oder mehreren der Ansprüche 1 oder 2, ausgewählt aus den Verbindungen der Formeln (3-1) bis (3-3) und (4-1) bis (4-3), 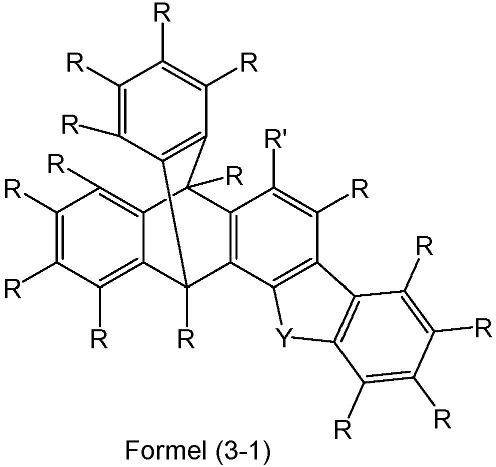 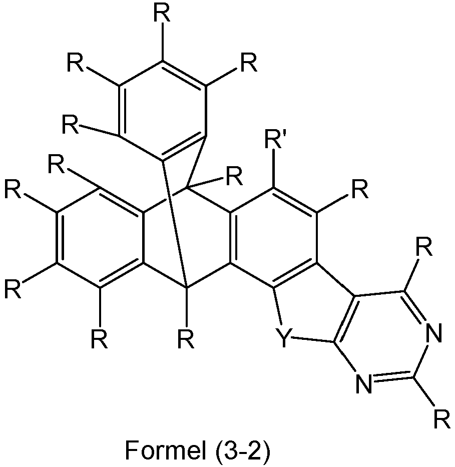 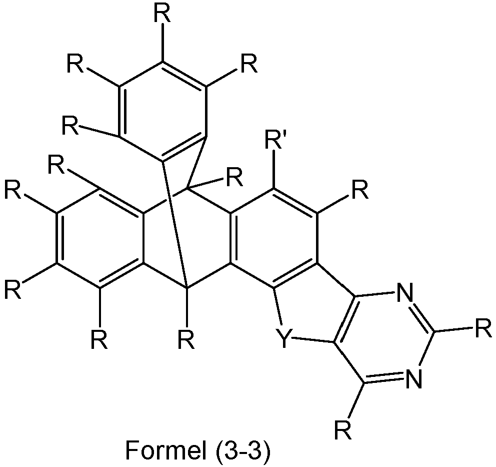 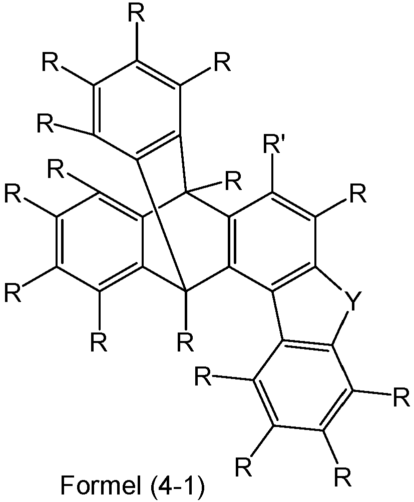 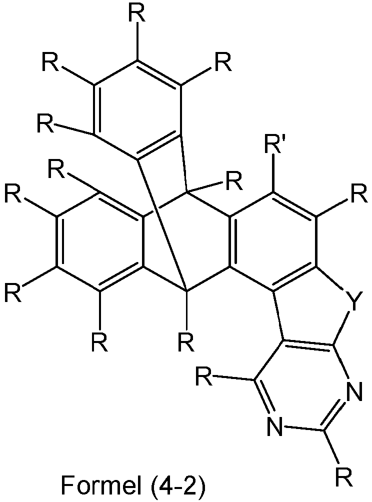 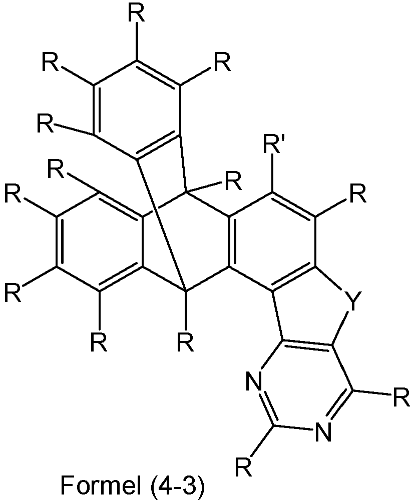 sowie Enantiomere davon, wobei die verwendeten Symbole die in Anspruch 1 genannten Bedeutungen aufweisen.

4. Verfahren zur Herstellung einer Verbindung nach einem oder mehreren der Ansprüche 1 bis 3, **gekennzeichnet durch** die folgenden Schritte:
(A) Synthese des Grundgerüsts nach Formel (1);
(B) Ankondensieren der Struktur nach Formel (2) unter Bildung der mit * bezeichneten Bindungen durch Kupplungs- und Ringschlussreaktion.

5. Oligomer, Polymer oder Dendrimer umfassend eine oder mehrere Verbindungen gemäß Formel (1) nach einem oder mehreren der Ansprüche 1 bis 3, wobei die Bindung(en) zu dem Oligomer, Polymer oder Dendrimer an beliebigen Positionen in Formel (1) erfolgen kann (können).

6. Formulierung, enthaltend mindestens eine Verbindung nach einem oder mehreren der Ansprüche 1 bis 3 und mindestens eine weitere Verbindung und/oder mindestens ein Lösemittel.

7. Verwendung einer Verbindung nach einem oder mehreren der Ansprüche 1 bis 3 und oder einer Formulierung nach Anspruch 6 in einer elektronischen Vorrichtung.

8. Elektronische Vorrichtung enthaltend mindestens eine Verbindung nach einem oder mehreren der Ansprüche 1 bis 3 und/oder mindestens ein Oligomer, Polymer oder Dendrimer nach Anspruch 5.

9. Elektronische Vorrichtung nach Anspruch 8, wobei es sich um eine organische Elektrolumineszenzvorrichtung handelt, **dadurch gekennzeichnet, dass** die Vorrichtung Anode, Kathode und mindestens eine emittierende Schicht umfasst, wobei mindestens eine organische Schicht, welche eine emittierende Schicht, Lochtransportschicht, Elektronentransportschicht, Lochblockierschicht, Elektronenblockierschicht oder eine andere funktionelle Schicht sein kann, mindestens eine Verbindung nach Formel (1) umfasst.

## Claims

1. Compound according to formula (1), 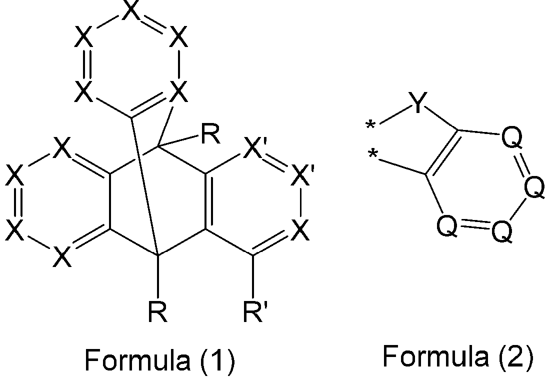 and enantiomers thereof, wherein the following applies to the symbols used:
X is identical or different at each occurrence CR or N, with the proviso that at most two groups X per cycle represent N;
X' represent C, which, via the bonds marked with * in formula (2), form an aromatic or heteroaromatic ring system annelated to the cycle;
Y is, at each occurrence, identically or differently BR, C(R)₂, Si(R)₂, Ge(R)₂, Sn(R)₂, O, S, Se, SO, SO₂, PR, P(=O)R, Bi(O)R², BiR²; wherein in the case of C(R)₂ R is bonded via a carbon atom;
Q is identical or different at each occurrence CR or N, with the proviso that at most two groups Q per cycle represent N;
R is, at each occurrence, identical or different H, D, F, Cl, Br, I, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, a linear alkyl group with 1 to 20 carbon atoms or an alkenyl or alkynyl group with 2 to 20 carbon atoms or a branched or cyclic alkyl group with 3 to 20 carbon atoms, wherein the alkyl, alkenyl or alkynyl group may in each case be substituted with one or more radicals R¹, wherein one or more non-adjacent CH₂ groups can be replaced by -R¹C=CR¹-, -C=C-, Si(R¹)₂, NR¹, CONR¹, C=O, C=S, -C(=O)O-, P(=O)(R¹), -O-, -S-, SO or SO₂, or an aromatic or heteroaromatic ring system with 5 to 60 aromatic ring atoms, preferred with 5 to 40 aromatic ring atoms, which may in each case be substituted by one or more radicals R¹, wherein two or more radicals R, preferably bonded to the same cycle, can together form an aliphatic, heteroaliphatic, aromatic or heteroaromatic ring system, which may be substituted by one or more radicals R¹, and wherein two radicals R bonded to the same carbon, silicon, germanium or tin atom can together form a monocyclic or polycyclic, aliphatic, aromatic or heteroaromatic ring system, which may be substituted by one or more radicals R¹;
R' is, at each occurrence, identical or different H, D, F, CI, Br, I, N(Ar')₂, N(R¹)₂, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, an aromatic or heteroaromatic ring system with 5 to 60 aromatic ring atoms, preferred with 5 to 40 aromatic ring atoms, which may in each case be substituted by one or more radicals R¹;
Ar' is, at each occurrence, identical or different an aromatic or heteroaromatic ring system with 5 to 40 aromatic ring atoms, which may be substituted by one or more radicals R¹;
R¹ is, at each occurrence, identical or different H, D, F, I, B(OR²)₂, CHO, C(=O)R², CR²=C(R²)₂, CN, C(=O)OR², Si(R²)₃, NO₂, P(=O)(R²)₂, OSO_{2R}², SR², OR², S(=O)R², S(=O)₂R², a linear alkyl group with 1 to 20 carbon atoms or an alkenyl or alkynyl group with 2 to 20 carbon atoms or a branched or cyclic alkyl group with 3 to 20 carbon atoms, wherein the alkyl, alkenyl or alkynyl group may in each case be substituted with one or more radicals R² and wherein one or more CH₂ groups in the above-mentioned groups can be replaced by -R²C=CR²-, -C≡C-, Si(R²)₂, C=O, C=S, - C(=O)O-, NR², CONR², P(=O)(R²), -O-, -S-, SO or SO₂ and wherein one or more H atoms in the above-mentioned groups can be replaced by D, F, CI, Br, I, CN or NO₂, or an aromatic or heteroaromatic ring system with 5 to 30 aromatic ring atoms, which may in each case be substituted by one or more radicals R², wherein two or more radicals R¹ can together form an aliphatic, heteroaliphatic, aromatic or heteroaromatic ring system;
R² is, at each occurrence, identical or different H, D, F, CN or an aliphatic, aromatic or heteroaromatic organic radical with 1 to 20 carbon atoms, in which one or more H atoms may also be replaced by D or F; in this context, two or more substituents R² may be linked to one another and form a ring.

2. Compound according to claim 1, selected from the compounds of formulae (3) or (4), 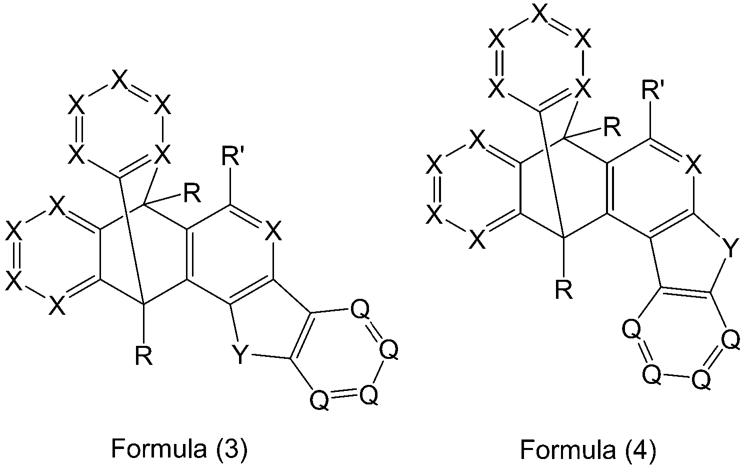 and enantiomers thereof, wherein the symbols used have the meanings stated in claim 1.

3. Compound according to one or more of claims 1 or 2, selected from the compounds of formulae (3-1) to (3-3) and (4-1) to (4-3), 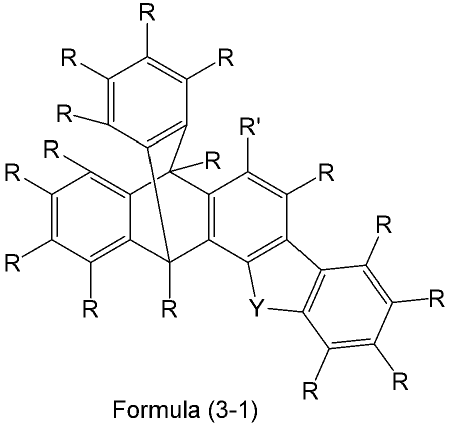 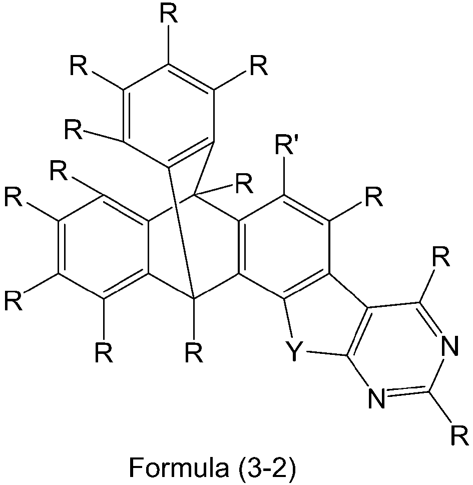 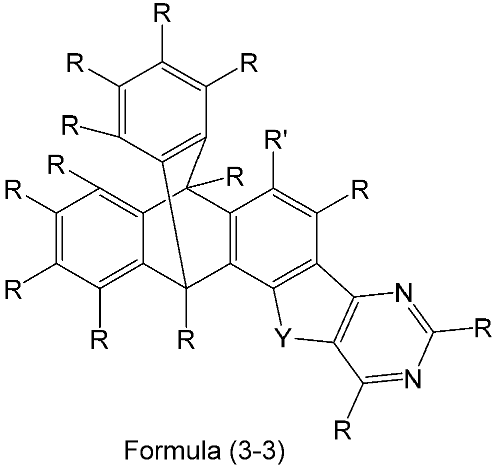 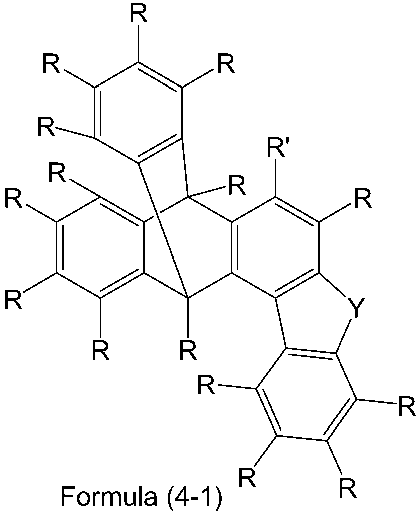 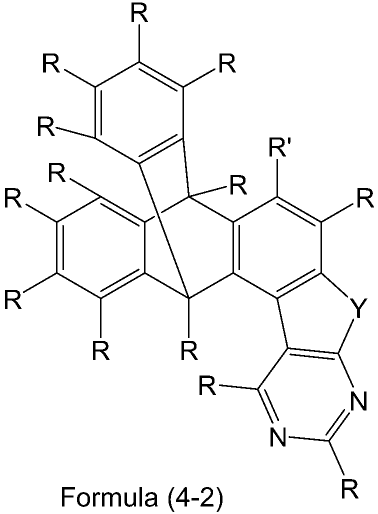 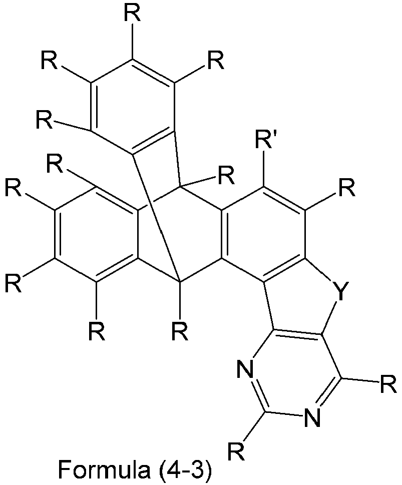 and enantiomers thereof, wherein the symbols used have the meanings stated in claim 1.

4. Process for preparing a compound according to one or more of claims 1 to 3, **characterized in that** it comprises the following steps:
(A) synthesizing the basic scaffold according to formula (1);
(B) annelating the structure according to formula (2), forming the bonds marked with * by coupling and ring-closing reaction.

5. Oligomer, polymer or dendrimer comprising one or more compounds according to formula (1) according to one or more of claims 1 to 3, wherein the bond(s) to the oligomer, polymer or dendrimer can occur at any positions in formula (1).

6. Formulation, containing at least one compound according to one or more of claims 1 to 3 and at least one further compound and/or at least one solvent.

7. Use of a compound according to one or more of claims 1 to 3 and/or a formulation according to claim 6 in an electronic device.

8. Electronic device containing at least one compound according to one or more of claims 1 to 3 and/or at least one oligomer, polymer or dendrimer according to claim 5.

9. Electronic device according to claim 8, wherein it is an organic electroluminescent device, **characterized in that** the device comprises an anode, a cathode and at least one emitting layer, wherein at least one organic layer, which can be an emitting layer, hole transport layer, electron transport layer, hole blocking layer, electron blocking layer or another functional layer, comprises at least one compound according to formula (1).

## Revendications

1. Composé selon la formule (1), 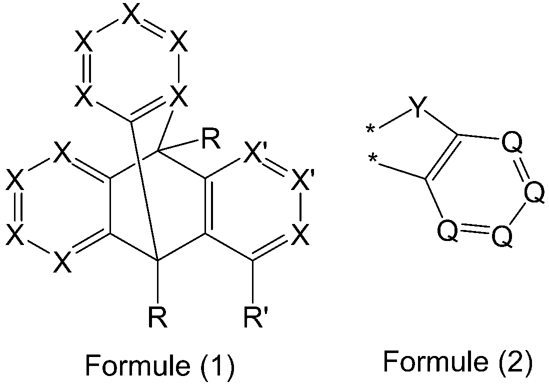 ainsi que les énantiomères de ceux-ci, dans les symboles utilisés, il est entendu que:
X est identique ou différent à chaque occurrence, CR ou N, avec la condition qu'au maximum deux groupes X par cycle représentent N;
X' représentent C, lesquels, via les liaisons marquées par * dans la formule (2), forment un système cyclique aromatique ou hétéroaromatique condensé au cycle;
Y est, à chaque occurrence, identique ou différent, un BR, C(R)₂, Si(R)₂, Ge(R)₂, Sn(R)₂, O, S, Se, SO, SO₂, PR, P(=O)R, Bi(O)R², BiR² ; dans C(R)₂, R est lié via un atome de carbone;
Q est identique ou différent à chaque occurrence, CR ou N, avec la condition qu'au maximum deux groupes Q par cycle représentent N ;
R est, à chaque occurrence, identique ou différent : H, D, F, CI, Br, I, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, un groupe alkyle linéaire comportant 1 à 20 atomes de C, ou un groupe alcényl ou alcynyl comportant 2 à 20 atomes de C, ou un groupe alkyle ramifié ou cyclique comportant 3 à 20 atomes de C, le groupe alkyle, alcényl ou alcynyl pouvant, dans chaque cas, être substitué par un ou plusieurs radicaux R¹, dans un ou plusieurs groupes CH₂ non adjacents pouvant être remplacés par -R¹C=CR¹-, -C=C-, Si(R¹)₂, NR¹, CONR¹, C=O, C=S, -C(=O)O-, P(=O)(R¹), -O-, -S-, SO ou SO₂, ou un système cyclique aromatique ou hétéroaromatique comportant 5 à 60 atomes de cycle aromatiques, de préférence 5 à 40 atomes de cycle aromatiques, pouvant, dans chaque cas, être substitué par un ou plusieurs radicaux R¹, dans lequel deux ou plusieurs radicaux R, de préférence liés au même cycle, peuvent former ensemble un système cyclique aliphatique, hétéroaliphatique, aromatique ou hétéroaromatique, pouvant être substitué par un ou plusieurs radicaux R¹, et dans lequel deux radicaux R liés au même atome de carbone, de silicium, de germanium ou d'étain peuvent former ensemble un système cyclique monocyclique ou polycyclique, aliphatique, aromatique ou hétéroaromatique, pouvant être substitué par un ou plusieurs radicaux R¹ ;
R' est, à chaque occurrence, identique ou différent : H, D, F, CI, Br, I, N(Ar')₂, N(R¹)₂, OAr', SAr', B(OR¹)₂, CHO, C(=O)R¹, CR¹=C(R¹)₂, CN, C(=O)OR¹, C(=O)NR¹, Si(R¹)₃, NO₂, P(=O)(R¹)₂, OSO₂R¹, OR¹, S(=O)R¹, S(=O)₂R¹, SR¹, un système cyclique aromatique ou hétéroaromatique comportant 5 à 60 atomes de cycle aromatiques, de préférence 5 à 40 atomes de cycle aromatiques, pouvant, dans chaque cas, être substitué par un ou plusieurs radicaux R¹;
Ar' est, à chaque occurrence, identique ou différent : un système cyclique aromatique ou hétéroaromatique comportant 5 à 40 atomes de cycle aromatiques, pouvant être substitué par un ou plusieurs radicaux R¹;
R¹ est, à chaque occurrence, identique ou différent : H, D, F, I, B(OR²)₂, CHO, C(=O)R², CR²=C(R²)₂, CN, C(=O)OR², Si(R²)₃, NO₂, P(=O)(R²)₂, OSO_{2R}², SR², OR², S(=O)R², S(=O)₂R², un groupe alkyle linéaire comportant 1 à 20 atomes de C, ou un groupe alcényl ou alcynyl comportant 2 à 20 atomes de C, ou un groupe alkyle ramifié ou cyclique comportant 3 à 20 atomes de C, le groupe alkyle, alcényl ou alcynyl pouvant, dans chaque cas, être substitué par un ou plusieurs radicaux R², et dans lequel un ou plusieurs groupes CH₂ des groupes précités peuvent être remplacés par -R²C=CR²-, -C≡C-, Si(R²)₂, C=O, C=S, -C(=O)O-, NR², CONR², P(=O)(R²), -O-, -S-, SO ou SO₂, et dans lequel un ou plusieurs atomes H des groupes précités peuvent être remplacés par D, F, CI, Br, I, CN ou NO₂, ou un système cyclique aromatique ou hétéroaromatique comportant 5 à 30 atomes de cycle aromatiques, pouvant, dans chaque cas, être substitué par un ou plusieurs radicaux R², dans lequel deux ou plusieurs radicaux R¹ peuvent former ensemble un système cyclique aliphatique, hétéroaliphatique, aromatique ou hétéroaromatique;
R² est, à chaque occurrence, identique ou différent : H, D, F, CN ou un radical organique aliphatique, aromatique ou hétéroaromatique comportant 1 à 20 atomes de C, dans lequel un ou plusieurs atomes H peuvent également être remplacés par D ou F; deux ou plusieurs substituants R² peuvent être liés entre eux et former un cycle.

2. Composé selon la revendication 1, sélectionné parmi les composés des formules (3) ou (4), 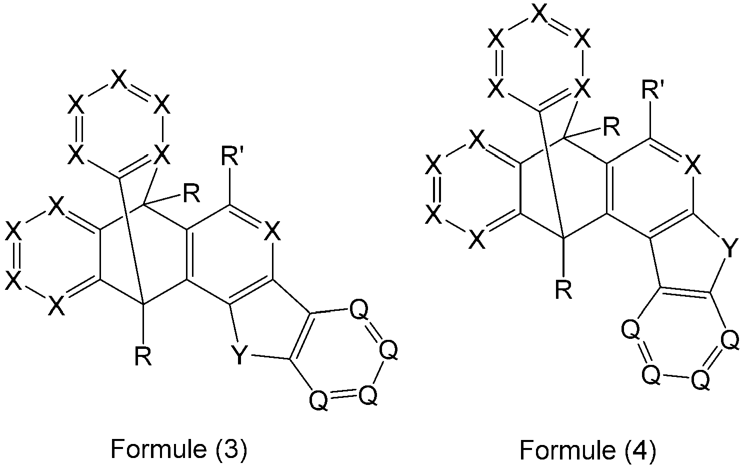 ainsi que les énantiomères de ceux-ci, dans lequel les symboles utilisés présentent les significations mentionnées dans la revendication 1.

3. Composé selon une ou plusieurs des revendications 1 ou 2, sélectionné parmi les composés des formules (3-1) à (3-3) et (4-1) à (4-3), 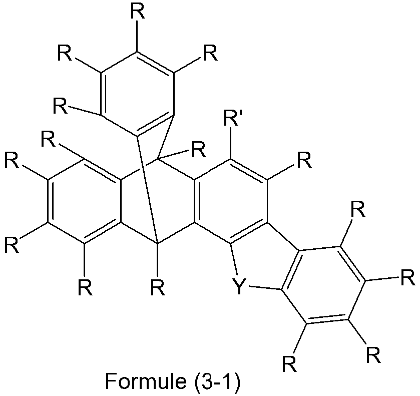 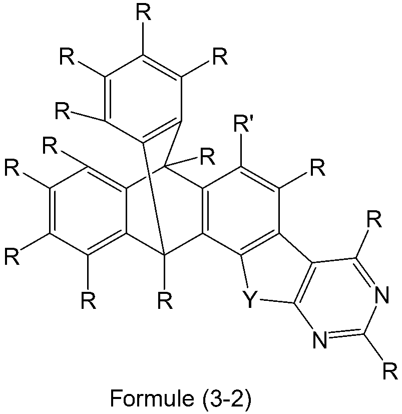 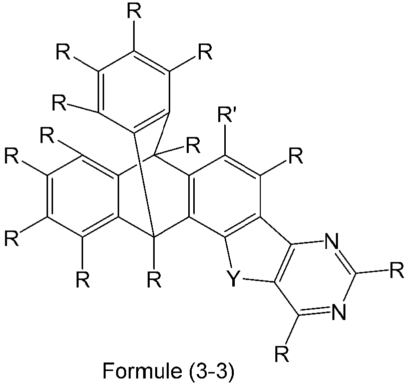 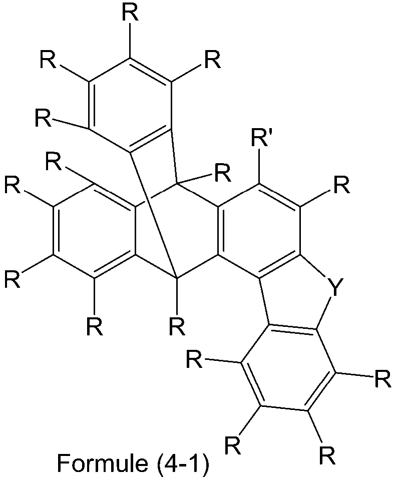 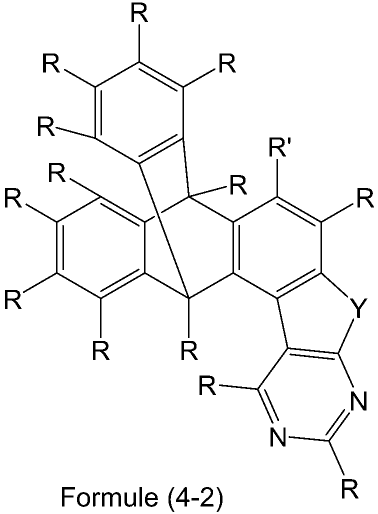 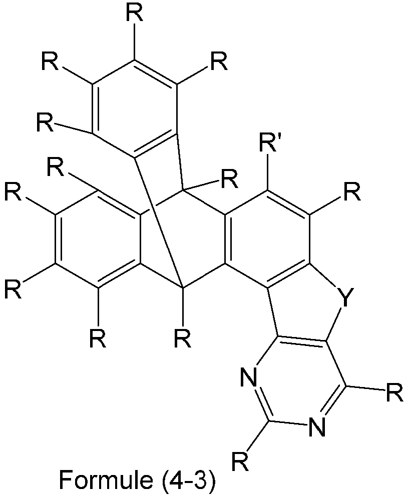 ainsi que les énantiomères de ceux-ci, dans lequel les symboles utilisés présentent les significations mentionnées dans la revendication 1.

4. Procédé de fabrication d'un composé selon une ou plusieurs des revendications 1 à 3, **caractérisé par** les étapes suivantes:
(A) synthétisant le squelette de base selon la formule (1);
(B) condensant la structure selon la formule (2) avec formation des liaisons marquées par * par réaction de couplage et de cyclisation.

5. Oligomère, polymère ou dendrimère comprenant un ou plusieurs composés selon la formule (1) selon une ou plusieurs des revendications 1 à 3, dans lequel la (les) liaison(s) à l'oligomère, au polymère ou au dendrimère peut (peuvent) avoir lieu à n'importe quelles positions dans la formule (1).

6. Formulation, contenant au moins un composé selon une ou plusieurs des revendications 1 à 3 et au moins un autre composé et/ou au moins un solvant.

7. Utilisation d'un composé selon une ou plusieurs des revendications 1 à 3 et/ou d'une formulation selon la revendication 6 dans un dispositif électronique.

8. Dispositif électronique contenant au moins un composé selon une ou plusieurs des revendications 1 à 3 et/ou au moins un oligomère, polymère ou dendrimère selon la revendication 5.

9. Dispositif électronique selon la revendication 8, dans lequel il s'agit d'un dispositif électroluminescent organique, **caractérisé en ce que** le dispositif comprend une anode, une cathode et au moins une couche émissive, dans lequel au moins une couche organique, laquelle peut être une couche émissive, une couche de transport de trous, une couche de transport d'électrons, une couche de blocage de trous, une couche de blocage d'électrons ou une autre couche fonctionnelle, comprend au moins un composé selon la formule (1).
